(19) **Europäisches Patentamt / European Patent Office / Office européen des brevets**

(11) **EP 4 708 740 A1**

(12) **EUROPEAN PATENT APPLICATION**
published in accordance with Art. 153(4) EPC

(43) Date of publication:
**11.03.2026 Bulletin 2026/11**

(21) Application number: **23935798.1**

(22) Date of filing: **04.05.2023**

(51) International Patent Classification (IPC):
**H04L 1/00** (2006.01)

(52) Cooperative Patent Classification (CPC):
**H04L 1/00**

(86) International application number:
**PCT/KR2023/006154**

(87) International publication number:
**WO 2024/228412 (07.11.2024 Gazette 2024/45)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **LG Electronics Inc.**
**Yeongdeungpo-gu**
**Seoul 07336 (KR)**

(72) Inventors:
• **KIM, Bonghoe**
**Seoul 06772 (KR)**
• **LEE, Jongku**
**Seoul 06772 (KR)**

(74) Representative: **Mooser, Sebastian Thomas**
**Wuesthoff & Wuesthoff**
**Patentanwälte und Rechtsanwalt PartG mbB**
**Schweigerstraße 2**
**81541 München (DE)**

(54) **METHOD, COMMUNICATION DEVICE, PROCESSING DEVICE, AND STORAGE MEDIUM FOR TRANSMITTING INFORMATION BLOCK, AND METHOD, COMMUNICATION DEVICE, PROCESSING DEVICE, AND STORAGE MEDIUM FOR RECEIVING INFORMATION BLOCK**

(57) This communication device may: determine the length N of a polar code for encoding an information block; perform polar encoding of the information block on the basis of the polar code to generate coded bits; and transmit the coded bits to any other communication device. Scheduling information regarding transmission of the information block may be provided to the communication device or the other communication device. The scheduling information may include mother code size-related information associated with N.

## FIG. 19

$$\boxed{\text{Generating input u for polar encoding based on information block of length K, polar sequence } Q^{N-1}_0 \text{ of length N, and polar code of length N}} \quad S1901$$

$$\downarrow$$

$$\boxed{\text{Determining coded bits based on polar encoding of input u}} \quad S1903$$

$$\downarrow$$

$$\boxed{\text{Transmitting scheduling information including information regarding mother code and coded bits}} \quad S1905$$

EP 4 708 740 A1

# EP 4 708 740 A1

## Description

### TECHNICAL FIELD

The present disclosure relates to a wireless communication system.

### BACKGROUND

A variety of technologies, such as machine-to-machine (M2M) communication, machine type communication (MTC), and a variety of devices demanding high data throughput, such as smartphones and tablet personal computers (PCs), have emerged and spread. Accordingly, the volume of data throughput demanded to be processed in a cellular network has rapidly increased. In order to satisfy such rapidly increasing data throughput, carrier aggregation technology or cognitive radio technology for efficiently employing more frequency bands and multiple input multiple output (MIMO) technology or multi-base station (BS) cooperation technology for raising data capacity transmitted on limited frequency resources have been developed.

As more and more communication devices have required greater communication capacity, there has been a need for enhanced mobile broadband (eMBB) communication relative to legacy radio access technology (RAT). In addition, massive machine type communication (mMTC) for providing various services at anytime and anywhere by connecting a plurality of devices and objects to each other is one main issue to be considered in next-generation communication.

Communication system design considering services/user equipment (UEs) sensitive to reliability and latency is also under discussion. The introduction of next-generation RAT is being discussed in consideration of eMBB communication, mMTC, ultra-reliable and low-latency communication (URLLC), and the like.

### DISCLOSURE

#### Technical Problem

As new radio communication technology has been introduced, the number of UEs to which a BS should provide services in a prescribed resource region is increasing and the volume of data and control information that the BS transmits/receives to/from the UEs to which the BS provides services is also increasing. Since the amount of resources available to the BS for communication with the UE(s) is limited, a new method for the BS to efficiently receive/transmit uplink/downlink data and/or uplink/downlink control information from/to the UE(s) using the limited radio resources is needed. In other words, due to increase in the density of nodes and/or the density of UEs, a method for efficiently using high-density nodes or high-density UEs for communication is needed.

A method to efficiently support various services with different requirements in a wireless communication system is also needed.

Overcoming delay or latency is an important challenge to applications, performance of which is sensitive to delay/latency.

A method for further improving the performance of a polar code proposed as an alternative to existing channel codes is required.

The objects to be achieved with the present disclosure are not limited to what has been particularly described hereinabove and other objects not described herein will be more clearly understood by persons skilled in the art from the following detailed description.

#### Technical Solution

In an aspect of the present disclosure, provided herein is a method of transmitting an information block by a communication device in a wireless communication system. The method includes: determining a length N of a polar code for encoding the information block; transmitting scheduling information for transmission of the information block; generating an input bit sequence **u** of length N based on a polar sequence of length N, $\mathbf{Q}^{N-1}_0 = \{Q_0, Q_1, ..., Q_{N-1}\}$, and a length K of the information block; generating coded bits based on polar encoding of the input bit sequence **u** of length N; and transmitting the coded bits based on the scheduling information. The polar sequence of length N, $\mathbf{Q}^{N-1}0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for i = 0, 1, ..., N - 1, and $W(Q^N_i)$ denotes a reliability of a bit index $Q^N_i$. The scheduling information includes resource allocation information, information regarding an information length, and information regarding a mother code size, and N is related to the information regarding the mother code size.

In another aspect of the present disclosure, provided herein is a communication device configured to transmit an information block in a wireless communication system. The communication device includes: at least one transceiver; at least one processor; and at least one computer memory operably connectable to the at least one processor and storing instructions that, when executed, cause the at least one processor to perform operations. The operations include: determining a length N of a polar code for encoding the information block; transmitting scheduling information for transmission of the information block; generating an input bit sequence $\mathbf{u}$ of length N based on a polar sequence of length N, $\mathbf{Q}^{N-1}_0 = \{Q_0, Q_1, ..., Q_{N-1}\}$, and a length K of the information block; generating coded bits based on polar encoding of the input bit sequence $\mathbf{u}$ of length N; and transmitting the coded bits based on the scheduling information. The polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for $i = 0, 1, ..., N - 1$, and $W(Q^N_i)$ denotes a reliability of a bit index $Q^N_i$. The scheduling information includes resource allocation information, information regarding an information length, and information regarding a mother code size, and N is related to the information regarding the mother code size.

In another aspect of the present disclosure, provided herein is a processing device in a wireless communication system. The processing device includes: at least one processor; and at least one computer memory operably connectable to the at least one processor and storing instructions that, when executed, cause the at least one processor to perform operations. The operations include: determining a length N of a polar code for encoding an information block; transmitting scheduling information for transmission of the information block; generating an input bit sequence $\mathbf{u}$ of length N based on a polar sequence of length N, $\mathbf{Q}^{N-1}_0 = \{Q_0, Q_1, ..., Q_{N-1}\}$, and a length K of the information block; generating coded bits based on polar encoding of the input bit sequence u of length N; and transmitting the coded bits based on the scheduling information. The polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... \leq W(Q^N_{N-1})$, where $0 \leq Q^N_i \leq N - 1$ denotes a bit index for $i = 0, 1, ..., N - 1$, and $W(Q^N_i)$ denotes a reliability of a bit index $Q^N_i$. The scheduling information includes resource allocation information, information regarding an information length, and information regarding a mother code size, and N is related to the information regarding the mother code size.

In another aspect of the present disclosure, provided herein is a computer-readable storage medium configured to store at least one program code comprising instructions that, when executed, cause at least one processor to perform operations. The operations include: determining a length N of a polar code for encoding an information block; transmitting scheduling information for transmission of the information block; generating an input bit sequence $\mathbf{u}$ of length N based on a polar sequence of length N, $\mathbf{Q}^{N-1}_0 = \{Q_0, Q_1, ..., Q_{N-1}\}$, and a length K of the information block; generating coded bits based on polar encoding of the input bit sequence $\mathbf{u}$ of length N; and transmitting the coded bits based on the scheduling information. The polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... \leq W(Q^N_{N-1})$, where $0 \leq Q^N_i \leq N - 1$ denotes a bit index for $i = 0, 1, ..., N - 1$, and $W(Q^N_i)$ denotes a reliability of a bit index $Q^N_i$. The scheduling information includes resource allocation information, information regarding an information length, and information regarding a mother code size, and N is related to the information regarding the mother code size.

In another aspect of the present disclosure, provided herein is a method of receiving an information block by a communication device in a wireless communication system. The method includes: determining a length N of a polar code for encoding an information block; transmitting scheduling information for transmission of the information block; generating an input bit sequence u to a polar code of length N, based on a polar sequence of length N, $Q^{N-1}_0 = \{Q_0, Q_1, ..., Q_{N-1}\}$, and a length K of the information block; generating coded bits based on polar encoding of the input bit sequence $\mathbf{u}$ to the polar code of length N; and transmitting the coded bits based on the scheduling information. The polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for $i = 0, 1, ..., N - 1$, and $W(Q^N_1)$ denotes a reliability of a bit index $Q^N_i$. The scheduling information includes resource allocation information, information regarding an information length, and information regarding a mother code size, and N is related to the information regarding the mother code size.

In another aspect of the present disclosure, provided herein is a communication device configured to receive an information block in a wireless communication system. The communication device includes: at least one transceiver; at least one processor; and at least one computer memory operably connectable to the at least one processor and storing instructions that, when executed, cause the at least one processor to perform operations. The operations include: determining a length N of a polar code for encoding an information block; transmitting scheduling information for transmission of the information block; generating an input bit sequence $\mathbf{u}$ to a polar code of length N, based on a polar sequence of length N, $\mathbf{Q}^{N-1}_0 = \{Q_0, Q_1, ..., Q_{N-1}\}$, and a length K of the information block; generating coded bits based on polar encoding of the input bit sequence $\mathbf{u}$ to the polar code of length N; and transmitting the coded bits based on the scheduling information. The polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for $i = 0, 1, ..., N - 1$, and $W(Q^N_1)$ denotes a reliability of a bit index $Q^N_i$. The scheduling information includes resource allocation information, information regarding an information length, and information regarding a mother code size, and N is related to the information regarding the mother code size.

In another aspect of the present disclosure, provided herein is a processing device in a wireless communication system. The processing device includes: at least one processor; and at least one computer memory operably connectable to the at least one processor and storing instructions that, when executed, cause the at least one processor to perform operations. The operations include: determining a length N of a polar code for encoding an information block; transmitting scheduling information for transmission of the information block; generating an input bit sequence u to a polar code of length N, based on a polar sequence of length N, $\mathbf{Q}^{N-1}_0 = \{Q_0, Q_1, ..., Q_{N-1}\}$, and a length K of the information block; generating coded bits based on polar encoding of the input bit sequence $\mathbf{u}$ to the polar code of length N; and transmitting the coded bits based on the scheduling information. The polar sequence of length N, $\mathbf{Q}^{N-1}0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for $i = 0, 1, ..., N - 1$, and $W(Q^N_i)$ denotes a reliability of a bit index $Q^N_i$. The scheduling information includes resource allocation information, information regarding an information length, and information regarding a mother code size, and N is related to the information regarding the mother code size.

In another aspect of the present disclosure, provided herein is a computer-readable storage medium configured to store at least one program code comprising instructions that, when executed, cause at least one processor to perform operations. The operations include: determining a length N of a polar code for encoding an information block; transmitting scheduling information for transmission of the information block; generating an input bit sequence $\mathbf{u}$ to a polar code of length N, based on a polar sequence of length N, $\mathbf{Q}^{N-1}_0 = \{Q_0, Q_1, ..., Q_{N-1}\}$, and a length K of the information block; generating coded bits based on polar encoding of the input bit sequence $\mathbf{u}$ to the polar code of length N; and transmitting the coded bits based on the scheduling information. The polar sequence of length N, $\mathbf{Q}^{N-1}0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for $i = 0, 1, ..., N - 1$, and $W(Q^N_i)$ denotes a reliability of a bit index $Q^N_i$. The scheduling information includes resource allocation information, information regarding an information length, and information regarding a mother code size, and N is related to the information regarding the mother code size.

In each aspect of the present disclosure, generating the input bit sequence $\mathbf{u}$ of length N may include, based on the transmission of the information block being initial transmission, placing bits $c_0$ to $c_{K-1}$ of the information block in K most reliable bit indexes among N bit indexes of the polar code to generating the input bit sequence $\mathbf{u} = [u_0, u_1, u_2, ..., u_{N-1}]$ of length N.

In each aspect of the present disclosure, generating the input bit sequence $\mathbf{u}$ of length N may include, based on the transmission of the information block being retransmission, placing bits $c_0$ to $c_{K-1}$ of the information block in K most reliable bit indexes among N bit indexes of the polar code of length N and placing at least one of the bits $c_0$ to $c_{K-1}$ of the information block at a bit index other than the K most reliable bit indexes to generate the input bit sequence $\mathbf{u} = [u_0, u_1, u_2, ..., u_{N-1}]$ of length N.

In each aspect of the present disclosure, generating the input bit sequence $\mathbf{u}$ of length N may include, based on the transmission of the information block is retransmission and on $N = 2^n*N1$, generating the input bit sequence $\mathbf{u} = [u_0, u_1, u_2, ..., u_{N-1}]$ of length N such that an upper portion $[u_{N-N1}, u_{N-N1+1}, u_{N-N1+2}, ..., u_{N-1}]$ of the input bit sequence of length N is identical to an input bit sequence $[u_0, u_1, u_2, ..., u_{N1-1}]$ to a polar code of length N1, and such that, a bit index belonging to the K most reliable bit indexes in a lower portion $[u_0, u_1, u_2, ..., u_{N-N1-1}]$ of the input bit sequence of length N includes an information bit placed at a bit index among bit indexes of the upper portion that does not belong to the K most reliable bit indexes. Here, N1 is the length of the polar code for the initial transmission of the information block, and $n \geq 0$.

In each aspect of the present disclosure, the mapping relationship of the information bits of the information block to the bit indexes of the polar code of length N may include the following: based on the transmission of the information block being initial transmission, an input bit sequence $\mathbf{u} = [u_0, u_1, u_2, ..., u_{N-1}]$ of length N to the polar code of length N includes bits $c_0$ to $c_{K-1}$ of the information block in K most reliable bit indexes among N bit indexes of the polar code.

In each aspect of the present disclosure, the mapping relationship of the information bits of the information block to the bit indexes of the polar code of length N may include the following: based on the transmission of the information block being retransmission, an input bit sequence $\mathbf{u} = [u_0, u_1, u_2, ..., u_{N-1}]$ to the polar code of length N includes bits $c_0$ to $c_{K-1}$ of the information block at positions of K most reliable bit indexes among N bit indexes of the polar code of length N and includes at least one of the bits $c_0$ to $c_{K-1}$ of the information block at a position of a bit index other than the K most reliable bit indexes.

In each aspect of the present disclosure, the mapping relationship of the information bits of the information block to the bit indexes of the polar code of length N may include the following: based on the transmission of the information block being retransmission and that $N = 2^n*N1$, an upper portion $[u_{N-N1}, u_{N-N1+1}, u_{N-N1+2}, ..., u_{N-1}]$ of the input bit sequence $\mathbf{u} = [u_0, u_1, u_2, ..., u_{N-1}]$ of length N includes the bits $c_0$ to $c_{K-1}$ of the information block at positions identical to positions of an input bit sequence $[u_0, u_1, u_2, ..., u_{N1-1}]$ to a polar code of length N1, and a bit index belonging to the K most reliable bit indexes in a lower portion $[u_0, u_1, u_2, ..., u_{N-N1-1}]$ of the input bit sequence of length N includes an information bit identical to an information bit placed at a bit index among bit indexes of the upper portion that does not belong to the K most reliable bit indexes. N1 is a length of a polar code for initial transmission of the information block, and $n \geq 0$.

In each aspect of the present disclosure, the information regarding the mother code size may include information regarding a multiplication factor. N may be related to a length $N_{int}$ which is based on the resource allocation information and the information regarding the information length, and to the information regarding the multiplication factor regarding how many times N is of $N_{int}$.

In each aspect of the present disclosure, the scheduling information may further include copy-related information regarding whether N is greater than a length of a polar code for initial transmission of the information block.

In each aspect of the present disclosure, the copy-related information may have a first value when the transmission of the information block is the initial transmission, and the copy-related information may have a second value when the transmission of the information block is retransmission.

The foregoing solutions are merely a part of the examples of the present disclosure and various examples into which the technical features of the present disclosure are incorporated may be derived and understood by persons skilled in the art from the following detailed description.

**Advantageous Effects**

According to some implementation(s) of the present disclosure, a wireless communication signal may be efficiently transmitted/received. Accordingly, the total throughput of a wireless communication system may be raised.

According to some implementation(s) of the present disclosure, various services with different requirements may be efficiently supported in a wireless communication system.

According to some implementation(s) of the present disclosure, delay/latency occurring during wireless communication between communication devices may be reduced.

According to some implementation(s) of the present disclosure, the performance of channel coding based on polar codes may be improved.

According to some implementations of the present disclosure, increment redundancy (IR) hybrid automatic repeat request (HARQ) may be applied to data to which channel coding based on a polar code is applied.

The effects according to the present disclosure are not limited to what has been particularly described hereinabove and other effects not described herein will be more clearly understood by persons skilled in the art related to the present disclosure from the following detailed description.

**BRIEF DESCRIPTION OF THE DRAWINGS**

The accompanying drawings, which are included to provide a further understanding of the present disclosure, illustrate examples of implementations of the present disclosure and together with the detailed description serve to explain implementations of the present disclosure:

FIG. 1 illustrates an example of a communication system 1 to which implementations of the present disclosure are applied;

FIG. 2 is a block diagram illustrating examples of communication devices capable of performing a method according to the present disclosure;

FIG. 3 illustrates another example of a wireless device capable of performing implementation(s) of the present disclosure;

FIG. 4 illustrates an example of a frame structure used in a 3rd generation partnership project (3GPP)-based wireless communication system;

FIG. 5 illustrates a process for processing a transport block (TB) on a transmitting side;

FIG. 6 is an exemplary block diagram for a polar encoder;

FIG. 7 illustrates the concept of channel splitting and channel combining for channel polarization;

FIG. 8 illustrates N-th level channel combining for polar codes;

FIG. 9 illustrates evolution of decoding paths in a list-L decoding process;

FIG. 10 is a diagram to explain the concept of selecting position(s) to which information bit(s) are to be allocated in polar codes;

FIG. 11 illustrates puncturing and information bit allocation for polar codes;

FIG. 12 illustrates a method of generating parity check bit(s) used in polar codes;

FIG. 13 illustrates examples of allocating information bits to a polar encoder according to some implementations of the present disclosure;

FIG. 14 illustrates bit indexes sorted in ascending order of reliabilities;

FIGS. 15 to 18 illustrate examples of placing data bits at bit indexes of a polar code according to some implementations of the present disclosure;

FIG. 19 illustrates a channel encoding process according to some implementations of the present disclosure; and

FIG. 20 illustrates a channel decoding process according to some implementations of the present disclosure.

## DETAILED DESCRIPTION

Hereinafter, implementations according to the present disclosure will be described in detail with reference to the accompanying drawings. The detailed description, which will be given below with reference to the accompanying drawings, is intended to explain exemplary implementations of the present disclosure, rather than to show the only implementations that may be implemented according to the present disclosure. The following detailed description includes specific details in order to provide a thorough understanding of the present disclosure. However, it will be apparent to those skilled in the art that the present disclosure may be practiced without such specific details.

In some instances, known structures and devices may be omitted or may be shown in block diagram form, focusing on important features of the structures and devices, so as not to obscure the concept of the present disclosure. The same reference numbers will be used throughout the present disclosure to refer to the same or like parts.

A technique, a device, and a system described below may be applied to a variety of wireless multiple access systems. The multiple access systems may include, for example, a code division multiple access (CDMA) system, a frequency division multiple access (FDMA) system, a time division multiple access (TDMA) system, an orthogonal frequency division multiple access (OFDMA) system, a single-carrier frequency division multiple access (SC-FDMA) system, a multi-carrier frequency division multiple access (MC-FDMA) system, etc. CDMA may be implemented by radio technology such as universal terrestrial radio access (UTRA) or CDMA2000. TDMA may be implemented by radio technology such as global system for mobile communications (GSM), general packet radio service (GPRS), enhanced data rates for GSM evolution (EDGE) (i.e., GERAN), etc. OFDMA may be implemented by radio technology such as institute of electrical and electronics engineers (IEEE) 802.11 (Wi-Fi), IEEE 802.16 (WiMAX), IEEE 802.20, evolved-UTRA (E-UTRA), etc. UTRA is part of universal mobile telecommunications system (UMTS) and 3rd generation partnership project (3GPP) long-term evolution (LTE) is part of E-UMTS using E-UTRA. 3GPP LTE adopts OFDMA on downlink (DL) and adopts SC-FDMA on uplink (UL). LTE-advanced (LTE-A) is an evolved version of 3GPP LTE.

For convenience of description, description will be given under the assumption that the present disclosure is applied to LTE and/or new RAT (NR). However, the technical features of the present disclosure are not limited thereto. For example, although the following detailed description is given based on mobile communication systems corresponding to 3GPP LTE/NR systems, the mobile communication systems are applicable to other arbitrary mobile communication systems except for matters that are specific to the 3GPP LTE/NR system.

For terms and techniques that are not described in detail among terms and techniques used in the present disclosure, reference may be made to 3GPP based standard specifications, for example, 3GPP TS 36.211, 3GPP TS 36.212, 3GPP TS 36.213, 3GPP TS 36.321, 3GPP TS 36.300, 3GPP TS 36.331, 3GPP TS 37.213, 3GPP TS 38.211, 3GPP TS 38.212, 3GPP TS 38.213, 3GPP TS 38.214, 3GPP TS 38.300, 3GPP TS 38.331, etc.

In examples of the present disclosure described later, if a device "assumes" something, this may mean that a channel transmission entity transmits a channel in compliance with the corresponding "assumption." This also may mean that a channel reception entity receives or decodes the channel in the form of conforming to the "assumption" on the premise that the channel has been transmitted in compliance with the "assumption."

In the present disclosure, a user equipment (UE) may be fixed or mobile. Each of various devices that transmit and/or receive user data and/or control information by communicating with a base station (BS) may be the UE. The term UE may be referred to as terminal equipment, mobile station (MS), mobile terminal (MT), user terminal (UT), subscriber station (SS), wireless device, personal digital assistant (PDA), wireless modem, handheld device, etc. In the present disclosure, a BS refers to a fixed station that communicates with a UE and/or another BS and exchanges data and control information with a UE and another BS. The term BS may be referred to as advanced base station (ABS), Node-B (NB), evolved Node-B (eNB), base transceiver system (BTS), access point (AP), processing server (PS), etc. Particularly, a BS of a universal terrestrial radio access (UTRAN) is referred to as an NB, a BS of an evolved-UTRAN (E-UTRAN) is referred to as an eNB, and a BS of new radio access technology network is referred to as a gNB. Hereinbelow, for convenience of description, the NB, eNB, or gNB will be referred to as a BS regardless of the type or version of communication technology.

In the present disclosure, a node refers to a fixed point capable of transmitting/receiving a radio signal to/from a UE by communication with the UE. Various types of BSs may be used as nodes regardless of the names thereof. For example, a BS, NB, eNB, pico-cell eNB (PeNB), home eNB (HeNB), relay, repeater, etc. may be a node. Furthermore, a node may not be a BS. For example, a radio remote head (RRH) or a radio remote unit (RRU) may be a node. Generally, the RRH and RRU have power levels lower than that of the BS. Since the RRH or RRU (hereinafter, RRH/RRU) is connected to the BS through a dedicated line such as an optical cable in general, cooperative communication according to the RRH/RRU and the BS may be smoothly performed relative to cooperative communication according to BSs connected through a wireless link. At least one antenna is installed per node. An antenna may refer to a physical antenna port or refer to a virtual antenna or an antenna group. The node may also be called a point.

In the present disclosure, a cell refers to a specific geographical area in which one or more nodes provide communication services. Accordingly, in the present disclosure, communication with a specific cell may mean communication with a BS or a node providing communication services to the specific cell. A DL/UL signal of the specific cell refers to a DL/UL signal from/to the BS or the node providing communication services to the specific cell. A cell providing UL/DL communication services to a UE is especially called a serving cell. Furthermore, channel status/quality of the specific cell refers to channel status/quality of a channel or a communication link generated between the BS or the node providing communication services to the specific cell and the UE. In 3GPP-based communication systems, the UE may measure a DL channel state from a specific node using cell-specific reference signal(s) (CRS(s)) transmitted on a CRS resource and/or channel state information reference signal(s) (CSI-RS(s)) transmitted on a CSI-RS resource, allocated to the specific node by antenna port(s) of the specific node.

A 3GPP-based communication system uses the concept of a cell in order to manage radio resources, and a cell related with the radio resources is distinguished from a cell of a geographic area.

The "cell" of the geographic area may be understood as coverage within which a node may provide services using a carrier, and the "cell" of the radio resources is associated with bandwidth (BW), which is a frequency range configured by the carrier. Since DL coverage, which is a range within which the node is capable of transmitting a valid signal, and UL coverage, which is a range within which the node is capable of receiving the valid signal from the UE, depend upon a carrier carrying the signal, coverage of the node may also be associated with coverage of the "cell" of radio resources used by the node. Accordingly, the term "cell" may be used to indicate service coverage by the node sometimes, radio resources at other times, or a range that a signal using the radio resources may reach with valid strength at other times.

In 3GPP communication standards, the concept of the cell is used in order to manage radio resources. The "cell" associated with the radio resources is defined by a combination of DL resources and UL resources, that is, a combination of a DL component carrier (CC) and a UL CC. The cell may be configured by the DL resources only or by the combination of the DL resources and the UL resources. If carrier aggregation is supported, linkage between a carrier frequency of the DL resources (or DL CC) and a carrier frequency of the UL resources (or UL CC) may be indicated by system information. For example, the combination of the DL resources and the UL resources may be indicated by system information block type 2 (SIB2) linkage. In this case, the carrier frequency may be equal to or different from a center frequency of each cell or CC. When carrier aggregation (CA) is configured, the UE has only one radio resource control (RRC) connection with a network. During RRC connection establishment/re-establishment/handover, one serving cell provides non-access stratum (NAS) mobility information. During RRC connection re-establishment/handover, one serving cell provides security input. This cell is referred to as a primary cell (Pcell). The Pcell refers to a cell operating on a primary frequency on which the UE performs an initial connection establishment procedure or initiates a connection re-establishment procedure. According to UE capability, secondary cells (Scells) may be configured to form a set of serving cells together with the Pcell. The Scell may be configured after completion of RRC connection establishment and used to provide additional radio resources in addition to resources of a specific cell (SpCell). A carrier corresponding to the Pcell on DL is referred to as a downlink primary CC (DL PCC), and a carrier corresponding to the Pcell on UL is referred to as an uplink primary CC (UL PCC). A carrier corresponding to the Scell on DL is referred to as a downlink secondary CC (DL SCC), and a carrier corresponding to the Scell on UL is referred to as an uplink secondary CC (UL SCC).

In a dual connectivity (DC) operation, the term special cell (SpCell) refers to a Pcell of a master cell group (MCG) or a primary secondary cell (PSCell) of a secondary cell group (SCG). The SpCell supports PUCCH transmission and contention-based random access and is always activated. The MCG is a group of service cells associated with a master node (e.g., BS) and includes the SpCell (Pcell) and optionally one or more Scells. For a UE configured with DC, the SCG is a subset of serving cells associated with a secondary node and includes the PSCell and 0 or more Scells. The PSCell is a primary Scell of the SCG. For a UE in RRC_CONNECTED state, which is not configured with CA or DC, only one serving cell including only the Pcell is present. For a UE in RRC _CONNECTED state, which is configured with CA or DC, the term serving cells refers to a set of cells including SpCell(s) and all Scell(s). In DC, two medium access control (MAC) entities, i.e., one MAC entity for the MCG and one MAC entity for the SCG, are configured for the UE.

For a UE that is configured with CA and is not configured with DC, a Pcell PUCCH group including the Pcell and 0 or more Scells and an Scell PUCCH group including only Scell(s) may be configured. For the Scell, an Scell on which a PUCCH associated with the corresponding cell is transmitted (hereinafter, a PUCCH cell) may be configured. An Scell for which a PUCCH Scell is indicated belongs to the Scell PUCCH group and PUCCH transmission of related uplink control information (UCI) is performed on the PUCCH Scell. If a PUCCH Scell is not indicated for an Scell or a cell which is indicated for PUCCH transmission for the Scell is a Pcell, the Scell belongs to the Pcell PUCCH group and PUCCH transmission of related UCI is performed on the Pcell.

In a wireless communication system, the UE receives information on DL from the BS and the UE transmits information on UL to the BS. The information that the BS and UE transmit and/or receive includes data and a variety of control information and there are various physical channels according to types/usage of the information that the UE and the BS transmit and/or receive.

The 3GPP-based communication standards define DL physical channels corresponding to resource elements carrying information originating from a higher layer and DL physical signals corresponding to resource elements which are used by the physical layer but do not carry the information originating from the higher layer. For example, a physical downlink shared channel (PDSCH), a physical broadcast channel (PBCH), a physical multicast channel (PMCH), a physical control format indicator channel (PCFICH), a physical downlink control channel (PDCCH), etc. are defined as the DL physical channels, and a reference signal (RS) and a synchronization signal (SS) are defined as the DL physical signals. The RS, which is also referred to as a pilot, represents a signal with a predefined special waveform known to both the BS and the UE. For example, a demodulation reference signal (DMRS), a channel state information RS (CSI-RS), etc. are defined as DL RSs. The 3GPP-based communication standards define UL physical channels corresponding to resource elements carrying information originating from the higher layer and UL physical signals corresponding to resource elements which are used by the physical layer but do not carry the information originating from the higher layer. For example, a physical uplink shared channel (PUSCH), a physical uplink control channel (PUCCH), and a physical random access channel (PRACH) are defined as the UL physical channels, and a DMRS for a UL control/data signal, a sounding reference signal (SRS) used for UL channel measurement, etc. are defined.

In the present disclosure, a PDCCH refers to a set of time-frequency resources (e.g., resource elements (REs)) carrying downlink control information (DCI), and a PDSCH refers to a set of time-frequency resources carrying DL data. A PUCCH, a PUSCH, and a PRACH refer to a set of time-frequency resources carrying UCI, a set of time-frequency resources carrying UL data, and a set of time-frequency resources carrying random access signals, respectively. In the following description, "the UE transmits/receives a PUCCH/PUSCH/PRACH" is used as the same meaning that the UE transmits/receives the UCI/UL data/random access signals on or through the PUCCH/PUSCH/PRACH, respectively. In addition, "the BS transmits/receives a PBCH/PDCCH/PDSCH" is used as the same meaning that the BS transmits the broadcast information/DCI/DL data on or through a PBCH/PDCCH/PDSCH, respectively.

In the present disclosure, a radio resource (e.g., a time-frequency resource) scheduled or configured to the UE by the BS for transmission or reception of the PUCCH/PUSCH/PDSCH may be referred to as a PUCCH/PUSCH/PDSCH resource.

Since a communication device receives a synchronization signal block (SSB), DMRS, CSI-RS, PBCH, PDCCH, PDSCH, PUSCH, and/or PUCCH in the form of radio signals on a cell, the communication device may not select and receive radio signals including only a specific physical channel or a specific physical signal through a radio frequency (RF) receiver, or may not select and receive radio signals without a specific physical channel or a specific physical signal through the RF receiver. In actual operations, the communication device receives radio signals on the cell via the RF receiver, converts the radio signals, which are RF band signals, into baseband signals, and then decodes physical signals and/or physical channels in the baseband signals using one or more processors. Thus, in some implementations of the present disclosure, not receiving physical signals and/or physical channels may mean that a communication device does not attempt to restore the physical signals and/or physical channels from radio signals, for example, does not attempt to decode the physical signals and/or physical channels, rather than that the communication device does not actually receive the radio signals including the corresponding physical signals and/or physical channels.

As more and more communication devices have required greater communication capacity, there has been a need for eMBB communication relative to legacy radio access technology (RAT). In addition, massive MTC for providing various services at anytime and anywhere by connecting a plurality of devices and objects to each other is one main issue to be considered in next-generation communication. Further, communication system design considering services/UEs sensitive to reliability and latency is also under discussion. The introduction of next-generation RAT is being discussed in consideration of eMBB communication, massive MTC, ultra-reliable and low-latency communication (URLLC), and the like. Currently, in 3GPP, a study on the next-generation mobile communication systems after EPC is being conducted. In the present disclosure, for convenience, the corresponding technology is referred to as a new RAT (NR) or fifth-generation (5G) RAT, and a system using NR or supporting NR is referred to as an NR system.

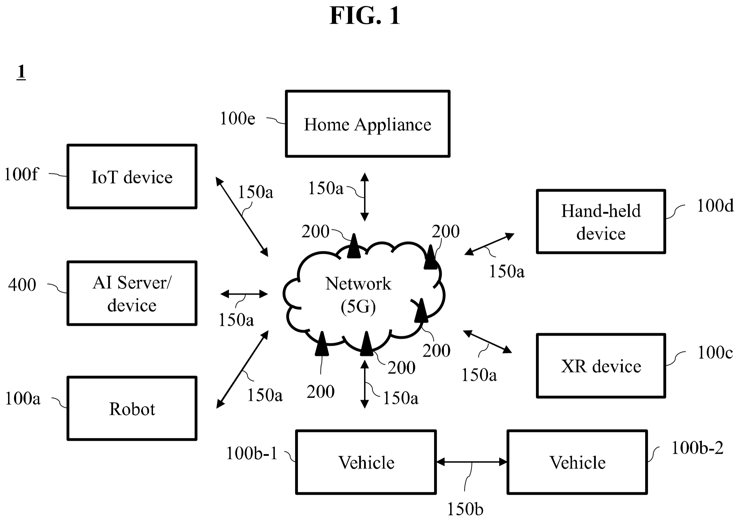

FIG. 1 illustrates an example of a communication system 1 to which implementations of the present disclosure are applied. Referring to FIG. 1, the communication system 1 applied to the present disclosure includes wireless devices, BSs, and a network. Here, the wireless devices represent devices performing communication using RAT (e.g., 5G NR or LTE (e.g., E-UTRA)) and may be referred to as communication/radio/SG devices. The wireless devices may include, without being limited to, a robot 100a, vehicles 100b-1 and 100b-2, an extended reality (XR) device 100c, a hand-held device 100d, a home appliance 100e, an Internet of Things (IoT) device 100f, and an artificial intelligence (AI) device/server 400. For example, the vehicles may include a vehicle having a wireless communication function, an autonomous driving vehicle, and a vehicle capable of performing vehicle-to-vehicle communication. Here, the vehicles may include an unmanned aerial vehicle (UAV) (e.g., a drone). The XR device may include an augmented reality (AR)/virtual reality (VR)/mixed reality (MR) device and may be implemented in the form of a head-mounted device (HMD), a head-up display (HUD) mounted in a vehicle, a television, a smartphone, a computer, a wearable device, a home appliance device, a digital signage, a vehicle, a robot, etc. The hand-held device may include a smartphone, a smartpad, a wearable device (e.g., a smartwatch or smartglasses), and a computer (e.g., a notebook). The home appliance may include a TV, a refrigerator, and a washing machine. The IoT device may include a sensor and a smartmeter. For example, the BSs and the network may also be implemented as wireless devices and a specific wireless device may operate as a BS/network node with respect to another wireless device.

The wireless devices 100a to 100f may be connected to a network 300 via BSs 200. AI technology may be applied to the wireless devices 100a to 100f and the wireless devices 100a to 100f may be connected to the AI server 400 via the network 300. The network 300 may be configured using a 3G network, a 4G (e.g., LTE) network, or a 5G (e.g., NR) network. Although the wireless devices 100a to 100f may communicate with each other through the BSs 200/network 300, the wireless devices 100a to 100f may perform direct communication (e.g., sidelink communication) with each other without passing through the BSs/network. For example, the vehicles 100b-1 and 100b-2 may perform direct communication (e.g., vehicle-to-vehicle (V2V)/Vehicle-to-everything (V2X) communication). The IoT device (e.g., a sensor) may perform direct communication with other IoT devices (e.g., sensors) or other wireless devices 100a to 100f.

Wireless communication/connections 150a and 150b may be established between the wireless devices 100a to 100f and the BSs 200 and between the wireless devices 100a to 100f). Here, the wireless communication/connections such as UL/DL communication 150a and sidelink communication 150b (or, device-to-device (D2D) communication) may be established by various RATs (e.g., 5G NR). The wireless devices and the BSs/wireless devices may transmit/receive radio signals to/from each other through the wireless communication/connections 150a and 150b. To this end, at least a part of various configuration information configuring processes, various signal processing processes (e.g., channel encoding/decoding, modulation/demodulation, and resource mapping/demapping), and resource allocating processes, for transmitting/receiving radio signals, may be performed based on the various proposals of the present disclosure.

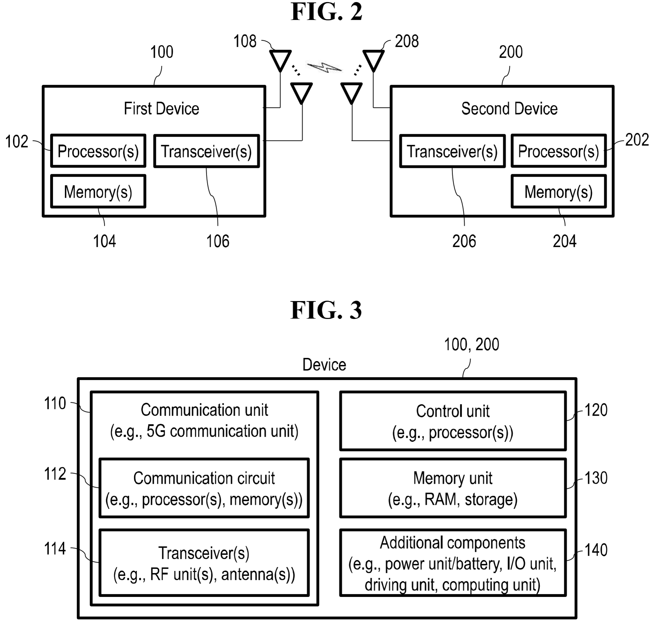

FIG. 2 is a block diagram illustrating examples of communication devices capable of performing a method according to the present disclosure. Referring to FIG. 2, a first wireless device 100 and a second wireless device 200 may transmit and/or receive radio signals through a variety of RATs (e.g., LTE and NR). Here, {the first wireless device 100 and the second wireless device 200} may correspond to {the wireless device 100x and the BS 200} and/or {the wireless device 100x and the wireless device 100x} of FIG. 1.

The first wireless device 100 may include one or more processors 102 and one or more memories 104 and additionally further include one or more transceivers 106 and/or one or more antennas 108. The processor(s) 102 may control the memory(s) 104 and/or the transceiver(s) 106 and may be configured to implement the below-described /proposed functions, procedures, and/or methods. For example, the processor(s) 102 may process information within the memory(s) 104 to generate first information/signals and then transmit radio signals including the first information/signals through the transceiver(s) 106. The processor(s) 102 may receive radio signals including second information/signals through the transceiver(s) 106 and then store information obtained by processing the second information/signals in the memory(s) 104. The memory(s) 104 may be connected to the processor(s) 102 and may store a variety of information related to operations of the processor(s) 102. For example, the memory(s) 104 may perform a part or all of processes controlled by the processor(s) 102 or store software code including instructions for performing the below-described/-proposed procedures and/or methods. Here, the processor(s) 102 and the memory(s) 104 may be a part of a communication modem/circuit/chip designed to implement RAT (e.g., LTE or NR). The transceiver(s) 106 may be connected to the processor(s) 102 and transmit and/or receive radio signals through one or more antennas 108. Each of the transceiver(s) 106 may include a transmitter and/or a receiver. The transceiver(s) 106 is used interchangeably with radio frequency (RF) unit(s). In the present disclosure, the wireless device may represent the communication modem/circuit/chip.

The second wireless device 200 may include one or more processors 202 and one or more memories 204 and additionally further include one or more transceivers 206 and/or one or more antennas 208. The processor(s) 202 may control the memory(s) 204 and/or the transceiver(s) 206 and may be configured to implement the below-described/proposed functions, procedures, and/or methods. For example, the processor(s) 202 may process information within the memory(s) 204 to generate third information/signals and then transmit radio signals including the third information/signals through the transceiver(s) 206. The processor(s) 202 may receive radio signals including fourth information/signals through the transceiver(s) 106 and then store information obtained by processing the fourth information/signals in the memory(s) 204. The memory(s) 204 may be connected to the processor(s) 202 and may store a variety of information related to operations of the processor(s) 202. For example, the memory(s) 204 may perform a part or all of processes controlled by the processor(s) 202 or store software code including instructions for performing the below-described/-proposed procedures and/or methods. Here, the processor(s) 202 and the memory(s) 204 may be a part of a communication modem/circuit/chip designed to implement RAT (e.g., LTE or NR). The transceiver(s) 206 may be connected to the processor(s) 202 and transmit and/or receive radio signals through one or more antennas 208. Each of the transceiver(s) 206 may include a transmitter and/or a receiver. The transceiver(s) 206 is used interchangeably with RF unit(s). In the present disclosure, the wireless device may represent the communication modem/circuit/chip.

The wireless communication technology implemented in the wireless devices 100 and 200 of the present disclosure may include narrowband Internet of things for low-power communication as well as LTE, NR, and 6G. For example, the NB-IoT technology may be an example of low-power wide-area network (LPWAN) technologies and implemented in standards such as LTE Cat NB1 and/or LTE Cat NB2. However, the NB-IoT technology is not limited to the above names. Additionally or alternatively, the wireless communication technology implemented in the wireless devices XXX and YYY of the present disclosure may perform communication based on the LTE-M technology. For example, the LTE-M technology may be an example of LPWAN technologies and called by various names including enhanced machine type communication (eMTC). For example, the LTE-M technology may be implemented in at least one of the following various standards: 1) LTE CAT 0, 2) LTE Cat M1, 3) LTE Cat M2, 4) LTE non-Bandwidth Limited (non-BL), 5) LTE-MTC, 6) LTE Machine Type Communication, and/or 7) LTE M, etc., but the LTE-M technology is not limited to the above names. Additionally or alternatively, the wireless communication technology implemented in the wireless devices XXX and YYY of the present disclosure may include at least one of ZigBee, Bluetooth, and LPWAN in consideration of low-power communication, but the wireless communication technology is not limited to the above names. For example, the ZigBee technology may create a personal area network (PAN) related to small/low-power digital communication based on various standards such as IEEE 802.15.4 and so on, and the ZigBee technology may be called by various names.

Hereinafter, hardware elements of the wireless devices 100 and 200 will be described more specifically. One or more protocol layers may be implemented by, without being limited to, one or more processors 102 and 202. For example, the one or more processors 102 and 202 may implement one or more layers (e.g., functional layers such as a physical (PHY) layer, medium access control (MAC) layer, a radio link control (RLC) layer, a packet data convergence protocol (PDCP) layer, radio resource control (RRC) layer, and a service data adaptation protocol (SDAP) layer). The one or more processors 102 and 202 may generate one or more protocol data units (PDUs) and/or one or more service data units (SDUs) according to the functions, procedures, proposals, and/or methods disclosed in the present disclosure. The one or more processors 102 and 202 may generate messages, control information, data, or information according to the functions, procedures, proposals, and/or methods disclosed in the present disclosure. The one or more processors 102 and 202 may generate signals (e.g., baseband signals) including PDUs, SDUs, messages, control information, data, or information according to the functions, procedures, proposals, and/or methods disclosed in the present disclosure and provide the generated signals to the one or more transceivers 106 and 206. The one or more processors 102 and 202 may receive the signals (e.g., baseband signals) from the one or more transceivers 106 and 206 and acquire the PDUs, SDUs, messages, control information, data, or information according to the functions, procedures, proposals, and/or methods disclosed in the present disclosure.

The one or more processors 102 and 202 may be referred to as controllers, microcontrollers, microprocessors, or microcomputers. The one or more processors 102 and 202 may be implemented by hardware, firmware, software, or a combination thereof. As an example, one or more application specific integrated circuits (ASICs), one or more digital signal processors (DSPs), one or more digital signal processing devices (DSPDs), one or more programmable logic devices (PLDs), or one or more field programmable gate arrays (FPGAs) may be included in the one or more processors 102 and 202. The functions, procedures, proposals, and/or methods disclosed in the present disclosure may be implemented using firmware or software, and the firmware or software may be configured to include the modules, procedures, or functions. Firmware or software configured to perform the functions, procedures, proposals, and/or methods disclosed in the present disclosure may be included in the one or more processors 102 and 202 or stored in the one or more memories 104 and 204 so as to be driven by the one or more processors 102 and 202. The functions, procedures, proposals, and/or methods disclosed in the present disclosure may be implemented using firmware or software in the form of code, commands, and/or a set of commands.

The one or more memories 104 and 204 may be connected to the one or more processors 102 and 202 and store various types of data, signals, messages, information, programs, code, commands, and/or instructions. The one or more memories 104 and 204 may be configured by read-only memories (ROMs), random access memories (RAMs), electrically erasable programmable read-only memories (EPROMs), flash memories, hard drives, registers, cash memories, computer-readable storage media, and/or combinations thereof. The one or more memories 104 and 204 may be located at the interior and/or exterior of the one or more processors 102 and 202. The one or more memories 104 and 204 may be connected to the one or more processors 102 and 202 through various technologies such as wired or wireless connection.

The one or more transceivers 106 and 206 may transmit user data, control information, and/or radio signals/channels, mentioned in the methods and/or operational flowcharts of the present disclosure, to one or more other devices. The one or more transceivers 106 and 206 may receive user data, control information, and/or radio signals/channels, mentioned in the functions, procedures, proposals, methods, and/or operational flowcharts disclosed in the present disclosure, from one or more other devices. For example, the one or more transceivers 106 and 206 may be connected to the one or more processors 102 and 202 and transmit and receive radio signals. For example, the one or more processors 102 and 202 may perform control so that the one or more transceivers 106 and 206 may transmit user data, control information, or radio signals to one or more other devices. The one or more processors 102 and 202 may perform control so that the one or more transceivers 106 and 206 may receive user data, control information, or radio signals from one or more other devices. The one or more transceivers 106 and 206 may be connected to the one or more antennas 108 and 208. The one or more transceivers 106 and 206 may be configured to transmit and receive user data, control information, and/or radio signals/channels, mentioned in the functions, procedures, proposals, methods, and/or operational flowcharts disclosed in the present disclosure, through the one or more antennas 108 and 208. In the present disclosure, the one or more antennas may be a plurality of physical antennas or a plurality of logical antennas (e.g., antenna ports). The one or more transceivers 106 and 206 may convert received radio signals/channels etc. from RF band signals into baseband signals in order to process received user data, control information, radio signals/channels, etc. using the one or more processors 102 and 202. The one or more transceivers 106 and 206 may convert the user data, control information, radio signals/channels, etc. processed using the one or more processors 102 and 202 from the base band signals into the RF band signals. To this end, the one or more transceivers 106 and 206 may include (analog) oscillators and/or filters.

FIG. 3 illustrates another example of a wireless device capable of performing implementation(s) of the present disclosure. Referring to FIG. 3, wireless devices 100 and 200 may correspond to the wireless devices 100 and 200 of FIG. 2 and may be configured by various elements, components, units/portions, and/or modules. For example, each of the wireless devices 100 and 200 may include a communication unit 110, a control unit 120, a memory unit 130, and additional components 140. The communication unit may include a communication circuit 112 and transceiver(s) 114. For example, the communication circuit 112 may include the one or more processors 102 and 202 and/or the one or more memories 104 and 204 of FIG. 2. For example, the transceiver(s) 114 may include the one or more transceivers 106 and 206 and/or the one or more antennas 108 and 208 of FIG. 2. The control unit 120 is electrically connected to the communication unit 110, the memory 130, and the additional components 140 and controls overall operation of the wireless devices. For example, the control unit 120 may control an electric/mechanical operation of the wireless device based on programs/code/commands/information stored in the memory unit 130. The control unit 120 may transmit the information stored in the memory unit 130 to the exterior (e.g., other communication devices) via the communication unit 110 through a wireless/wired interface or store, in the memory unit 130, information received through the wireless/wired interface from the exterior (e.g., other communication devices) via the communication unit 110.

The additional components 140 may be variously configured according to types of wireless devices. For example, the additional components 140 may include at least one of a power unit/battery, input/output (I/O) unit, a driving unit, and a computing unit. The wireless device may be implemented in the form of, without being limited to, the robot (100a of FIG. 1), the vehicles (100b-1 and 100b-2 of FIG. 1), the XR device (100c of FIG. 1), the hand-held device (100d of FIG. 1), the home appliance (100e of FIG. 1), the IoT device (100f of FIG. 1), a digital broadcast UE, a hologram device, a public safety device, an MTC device, a medicine device, a fintech device (or a finance device), a security device, a climate/environment device, the AI server/device (400 of FIG. 1), the BS (200 of FIG. 1), a network node, etc. The wireless device may be used in a mobile or fixed place according to a use-case/service.

In FIG. 3, the entirety of the various elements, components, units/portions, and/or modules in the wireless devices 100 and 200 may be connected to each other through a wired interface or at least a part thereof may be wirelessly connected through the communication unit 110. For example, in each of the wireless devices 100 and 200, the control unit 120 and the communication unit 110 may be connected by wire and the control unit 120 and first units (e.g., 130 and 140) may be wirelessly connected through the communication unit 110. Each element, component, unit/portion, and/or module within the wireless devices 100 and 200 may further include one or more elements. For example, the control unit 120 may be configured by a set of one or more processors. As an example, the control unit 120 may be configured by a set of a communication control processor, an application processor, an electronic control unit (ECU), a graphical processing unit, and a memory control processor. As another example, the memory 130 may be configured by a random access memory (RAM), a dynamic RAM (DRAM), a read-only memory (ROM)), a flash memory, a transitory memory, a non-transitory memory, and/or a combination thereof.

In the present disclosure, the at least one memory (e.g., 104 or 204) may store instructions or programs, and the instructions or programs may cause, when executed, at least one processor operably connected to the at least one memory to perform operations according to some embodiments or implementations of the present disclosure.

In the present disclosure, a computer readable (non-transitory) storage medium may store at least one instruction or program, and the at least one instruction or program may cause, when executed by at least one processor, the at least one processor to perform operations according to some embodiments or implementations of the present disclosure.

In the present disclosure, a processing device or apparatus may include at least one processor, and at least one computer memory operably connected to the at least one processor. The at least one computer memory may store instructions or programs, and the instructions or programs may cause, when executed, the at least one processor operably connected to the at least one memory to perform operations according to some embodiments or implementations of the present disclosure.

In the present disclosure, a computer program may include program code stored on at least one computer-readable (non-transitory) storage medium and, when executed, configured to perform operations according to some implementations of the present disclosure or cause at least one processor to perform the operations according to some implementations of the present disclosure. The computer program may be provided in the form of a computer program product. The computer program product may include at least one computer-readable (non-transitory) storage medium.

A communication device of the present disclosure includes at least one processor; and at least one computer memory operably connected to the at least one processor and configured to store instructions for causing, when executed, the at least one processor to perform operations according to example(s) of the present disclosure described later.

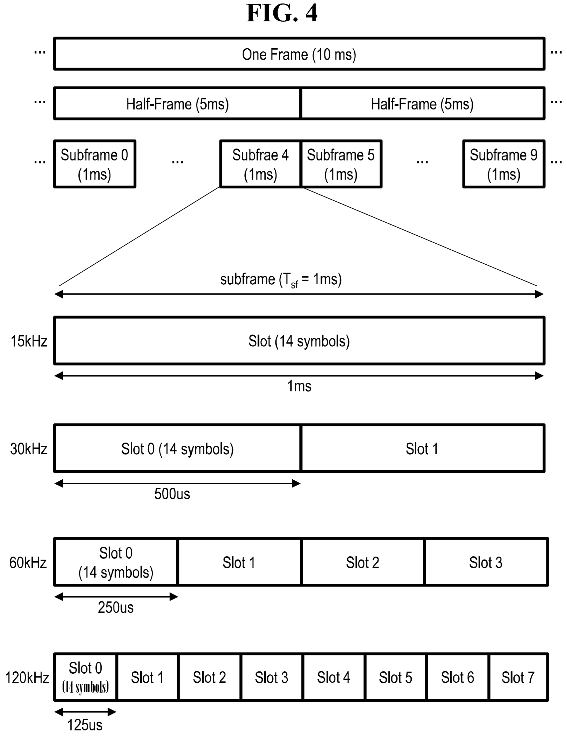

FIG. 4 illustrates an example of a frame structure used in a 3GPP-based wireless communication system.

The frame structure of FIG. 4 is purely exemplary and the number of subframes, the number of slots, and the number of symbols, in a frame, may be variously changed. In an NR system, different OFDM numerologies (e.g., subcarrier spacings (SCSs)) may be configured for multiple cells which are aggregated for one UE. Accordingly, the (absolute time) duration of a time resource including the same number of symbols (e.g., a subframe, a slot, or a transmission time interval (TTI)) may be differently configured for the aggregated cells. Here, the symbol may include an OFDM symbol (or cyclic prefix - OFDM (CP-OFDM) symbol) and an SC-FDMA symbol (or discrete Fourier transform-spread-OFDM (DFT-s-OFDM) symbol). In the present disclosure, the symbol, the OFDM-based symbol, the OFDM symbol, the CP-OFDM symbol, and the DFT-s-OFDM symbol are used interchangeably.

Referring to FIG. 4, in the NR system, UL and DL transmissions are organized into frames. Each frame has a duration of $T_f = (\triangle f_{max} * N_f / 100) * T_c = 10$ ms and is divided into two half-frames of 5 ms each. A basic time unit for NR is $T_c = 1/(\triangle f_{max} * N_f)$ where $\triangle f_{max} = 480 * 10^3$ Hz and $N_f = 4096$. For reference, a basic time unit for LTE is $T_s = 1/(\triangle f_{ref} * N_{f,ref})$ where $\triangle f_{ref} = 15 * 10^3$ Hz and $N_{f,ref} = 2048$. $T_c$ and $T_f$ have the relationship of a constant $\kappa = T_c/T_f = 64$. Each half-frame includes 5 subframes and a duration $T_{sf}$ of a single subframe is 1 ms. Subframes are further divided into slots and the number of slots in a subframe depends on a subcarrier spacing. Each slot includes 14 or 12 OFDM symbols based on a cyclic prefix. In a normal CP, each slot includes 14 OFDM symbols and, in an extended CP, each slot includes 12 OFDM symbols. The numerology depends on an exponentially scalable subcarrier spacing $\triangle f = 2^u * 15$ kHz. The table below shows the number of OFDM symbols ($N^{slot}_{symb}$) per slot, the number of slots ($N^{frame,u}_{slot}$) per frame, and the number of slots ($N^{subframe,u}_{slot}$) per subframe.

Table 1

| u | $N^{slot}_{symb}$ | $N^{frame,u}_{slot}$ | $N^{subframe,u}_{slot}$ |
|---|---|---|---|
| 0 | 14 | 10 | 1 |
| 1 | 14 | 20 | 2 |
| 2 | 14 | 40 | 4 |
| 3 | 14 | 80 | 8 |
| 4 | 14 | 160 | 16 |

The table below shows the number of OFDM symbols per slot, the number of slots per frame, and the number of slots per subframe, according to the subcarrier spacing $\triangle f = 2^u * 15$ kHz.

Table 2

| u | $N^{slot}_{symb}$ | $N^{frame,u}_{slot}$ | $N^{subframe,u}_{slot}$ |
|---|---|---|---|
| 2 | 12 | 40 | 4 |

For a subcarrier spacing configuration u, slots may be indexed within a subframe in ascending order as follows: $n^u_s \in \{0, ..., n^{subframe,u}_{slot} - 1\}$ and indexed within a frame in ascending order as follows: $n^u_{s,f} \in \{0, ..., \mathbf{n}^{frame,u}_{slot} - 1\}$.

The slot includes multiple (e.g., 14 or 12) symbols in the time domain. For each numerology (e.g., subcarrier spacing) and carrier, a resource grid of $N^{size,u}_{grid,x} * N^{RB}_{sc}$ subcarriers and $N^{subframe,u}_{symb}$ OFDM symbols is defined, starting at a common resource block (CRB) $N^{start,u}_{grid}$ indicated by higher layer signaling (e.g., RRC signaling), where $N^{size,u}_{grid,x}$ is the number of resource blocks (RBs) in the resource grid and the subscript x is DL for downlink and UL for uplink. $N^{RB}_{sc}$ is the number of subcarriers per RB. In the 3GPP-based wireless communication system, $N^{RB}_{sc}$ is typically 12. There is one resource grid for a given antenna port p, a subcarrier spacing configuration u, and a transmission link (DL or UL). The carrier bandwidth $N^{size,u}_{grid}$ for the subcarrier spacing configuration u is given to the UE by a higher layer parameter (e.g., RRC parameter). Each element in the resource grid for the antenna port $p$ and the subcarrier spacing configuration $u$ is referred to as a resource element (RE) and one complex symbol may be mapped to each RE. Each RE in the resource grid is uniquely identified by an index k in the frequency domain and an index $l$ representing a symbol location relative to a reference point in the time domain. In the NR system, an RB is defined by 12 consecutive subcarriers in the frequency domain. In the NR system, RBs are classified into CRBs and physical resource blocks (PRBs). The CRBs are numbered from 0 upwards in the frequency domain for the subcarrier spacing configuration $u$. The center of subcarrier 0 of CRB 0 for the subcarrier spacing configuration $u$ is equal to 'Point A' which serves as a common reference point for RB grids. The PRBs for subcarrier spacing configuration u are defined within a bandwidth part (BWP) and numbered from 0 to $N^{size,u}_{BWP,i}-1$, where i is a number of the BWP. The relation between a PRB $n_{PRB}$ in a BWP i and a CRB $n^{u}_{CRB}$ is given by: $n^{u}_{PRB} = n^{u}_{CRB} + N^{size,u}_{BWP,i}$, where $N^{size}_{BWP,i}$ is a CRB in which the BWP starts relative to CRB 0. The BWP includes a plurality of consecutive RBs in the frequency domain. For example, the BWP may be a subset of contiguous CRBs defined for a given numerology $u_i$ in the BWP i on a given carrier. A carrier may include a maximum of N (e.g., 5) BWPs. The UE may be configured to have one or more BWPs on a given component carrier. Data communication is performed through an activated BWP and only a predetermined number of BWPs (e.g., one BWP) among BWPs configured for the UE may be active on the component carrier.

The UE for which carrier aggregation is configured may be configured to use one or more cells. If the UE is configured with a plurality of serving cells, the UE may be configured with one or multiple cell groups. The UE may also be configured with a plurality of cell groups associated with different BSs. Alternatively, the UE may be configured with a plurality of cell groups associated with a single BS. Each cell group of the UE includes one or more serving cells and includes a single PUCCH cell for which PUCCH resources are configured. The PUCCH cell may be a Pcell or an Scell configured as the PUCCH cell among Scells of a corresponding cell group. Each serving cell of the UE belongs to one of cell groups of the UE and does not belong to a plurality of cells.

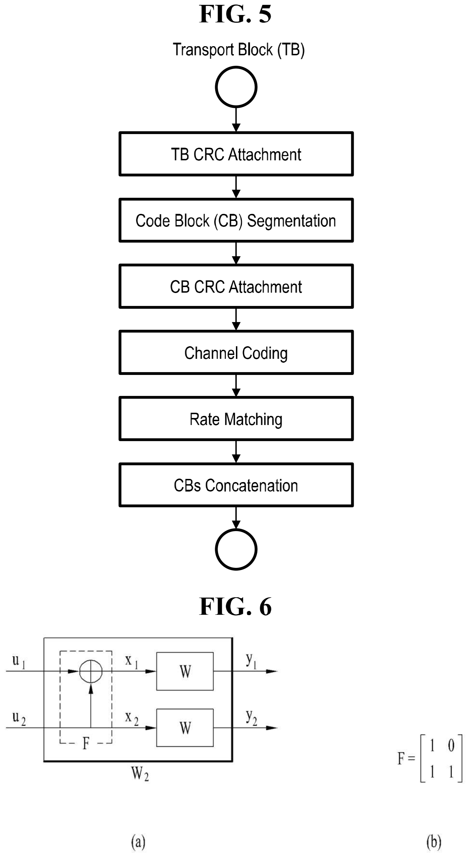

FIG. 5 illustrates a process for processing a transport block (TB) on a transmitting side.

In order for a receiving side to correct errors that radio signals experience in a radio channel, a transmitting side encodes information using a forward error correction code and then transmits the encoded information. The receiving side demodulates a received signal and decodes the error correction code to thereby recover the information transmitted by the transmitting side. In this decoding procedure, errors in the received signal caused by a radio channel are corrected.

Data arrives at a coding block in the form of a maximum of two transport blocks every transmission time interval (TTI) in each DL/UL cell. The following coding steps may be applied to each transport block of the DL/UL cell:

- cyclic redundancy check (CRC) attachment to a transport block;
- code block segmentation and CRC attachment to a code block;
- channel coding;
- rate matching; and
- code block concatenation.

In an actual communication system, a transport block of a predetermined size or larger is divided into a plurality of smaller data blocks and then is encoded, to facilitate actual implementation of coding. The smaller data blocks are called code blocks. While the code blocks are generally of the same size, one of the code blocks may have a different size due to a limited size of an internal interleaver of a channel encoder. Error correction coding is performed on each code block of a predetermined interleaver size and then interleaving is performed to reduce the impact of burst errors that are generated during transmission over a radio channel. The error-corrected and interleaved code block is transmitted by being mapped to an actual radio resource. The amount of radio resources used for actual transmission is designated. Thus, the encoded code blocks are rate-matched to the amount of the radio resources. In general, rate matching is performed through puncturing or repetition. For example, if the amount of radio resources, i.e., the number of transmission bits capable of being transmitted on the radio resources, is M and if a coded bit sequence, i.e., the number of output bits of the encoder, is N, in which M is different from N, then rate matching is performed to match the length of the coded bit sequence to M. If M>N, then all or a part of bits of the coded bit sequence are repeated to match the length of the rate-matched sequence to M. If M<N, then a part of the bits of the coded bit sequence is punctured to match the length of the rate-matched sequence to M and the punctured bits are excluded from transmission.

In wireless communication systems, the transmitting side encodes data to be transmitted based on channel coding with a specific code rate. Then, the transmitting side adjusts the code rate of the data to be transmitted through a rate matching process involving puncturing and repetition.

There are various types of error correction codes, but the size of an information block capable of achieving optimal performance is determined depending on the error correction code. While many coding schemes are available for achieving high-capacity information performance with long information block lengths, the majority of the coding schemes do not consistently show good performance over a wide range of information block lengths and code rates. However, turbo codes, low-density parity check (LPDC) codes, and polar codes show promising BLER performance in a wide range of coding rates and code lengths and hence are considered to be used in the NR system. As demand for various cases such as eMBB, massive IoT, and URLLC has increased, a coding scheme providing greater channel coding efficiency than in turbo codes is needed. In addition, increase in a maximum number of subscribers capable of being accommodated by a channel, i.e., increase in capacity, has been required. Polar codes among various error correction codes are codes providing a new framework capable of solving problems of legacy channel codes and were invented by Arikan at Bilkent University (reference: E. Arikan, "Channel Polarization: A Method for Constructing Capacity-Achieving Codes for Symmetric Binary-Input Memoryless Channels," in IEEE Transactions on Information Theory, vol. 55, no. 7, pp. 3051-3073, July 2009). Polar codes are the first capacity-achieving codes with low encoding and decoding complexities, which were proven mathematically. Polar codes outperform the turbo codes in large information block lengths while no error flow is present. Hereinafter, channel coding using the polar codes is referred to as polar coding.

Polar codes are known as codes capable of achieving the capacity of a given binary discrete memoryless channel. This can be achieved only when a block size is sufficiently large. That is, polar codes are codes capable of achieving the capacity of a channel if the size N of the codes infinitely increases. Polar codes have low encoding and decoding complexity and may be successfully decoded. Polar codes are a sort of linear block error correction codes. Multiple recursive concatenations are basic building blocks for the polar codes and are bases for code construction. Physical conversion of channels in which physical channels are converted into virtual channels occurs and such conversion is based on a plurality of recursive concatenations. If multiple channels are multiplied and accumulated, most of the channels may become better or worse. The idea underlying polar codes is to use good channels. For example, data is sent through good channels at rate 1 and data is sent through bad channels at rate 0. That is, through channel polarization, channels enter a polarized state from a normal state.

FIG. 6 is an example of a block diagram for a polar encoder.

FIG. 6(a) illustrates a base module of a polar code, particularly, first level channel combining for polar coding. In FIG. 6(a), W2 denotes an entire equivalent channel obtained by combining two binary-input discrete memoryless channels (B-DMCs), Ws. Herein, $u_1$ and $u_2$ are binary-input source bits and $y_1$ and $y_2$ are output coded bits. Channel combining is a procedure of concatenating the B-DMCs in parallel.

FIG. 6(b) illustrates a base matrix F for the base module. The binary-input source bits $u_1$ and $u_2$ input to the base matrix F and the output coded bits $x_1$ and $x_2$ of the base matrix F have the following relationship.

$$\text{Equation 1}$$

$$[\, u_1 \; u_2 \,]\begin{bmatrix} 1 & 0 \\ 1 & 1 \end{bmatrix} = [\, x_1 \; x_2 \,]$$

The channel W2 may achieve symmetric capacity I(W) which is a highest rate. In the B-DMC W, symmetric capacity is an important parameter which is used to measure a rate and is a highest rate at which reliable communication can occur over the channel W. The B-DMC may be defined as follows.

$$\text{Equation 2}$$

$$I(W) = \sum_{y \in Y} \sum_{x \in X} \frac{1}{2} W(y|x) \log \frac{w(y|x)}{\frac{1}{2} w(y|0) + \frac{1}{2} w(y|1)}$$

It is possible to synthesize or create a second set of N binary input channels out of N independent copies of a given B-DMC W and the channels have the properties $\{W_N^{(i)}: 1<=i<=N\}$. If N increases, there is a tendency for a part of the channels to have capacity approximating to 1 and for the remaining channels to have capacity approximating to 0. This is called channel polarization. In other words, channel polarization is a process of creating a second set of N channels $\{W_N^{(i)}: 1<=i<=N\}$ using N independent copies of a given B-DMC W. The effect of channel polarization means that, when N increases, all symmetric capacity terms $\{I(W_N^{(i)})\}$ tend towards 0 or 1 for all except a vanishing fraction of indexes i. In other words, the concept behind channel polarization in the polar codes is transforming N copies (i.e., N transmissions) of a channel having a symmetric capacity of I(W) (e.g., additive white Gaussian noise channel) into extreme channels of capacity close to 1 or 0. Among the N channels, an I(W) fraction will be perfect channels and an 1-I(W) fraction will be completely noise channels. Then, information bits are transmitted only through good channels and bits input to the other channels are frozen to 1 or 0. The amount of channel polarization increases along with a block length. Channel polarization consists of two phases: channel combining phase and channel splitting phase.

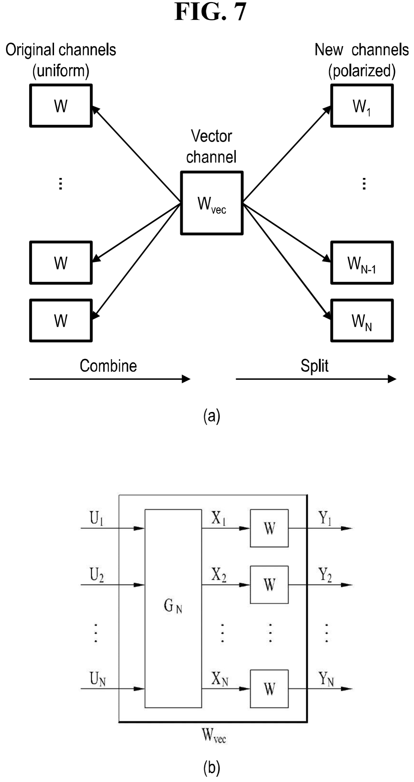

FIG. 7 illustrates the concept of channel combining and channel splitting for channel polarization. As illustrated in FIG. 7, when N copies of an original channel W are properly combined to create a vector channel $W_{vec}$ and then are split into new polarized channels, the new polarized channels are categorized into channels having capacity C(W)=1 and channels having C(W)=0 if N is sufficiently large. In this case, since bits passing through the channels having the channel capacity C(W))=1 are transmitted without error, it is better to transmit information bits therethrough and, since bits passing through the channels having capacity C(W)=0 cannot transport information, it is better to transport frozen bits, which are meaningless bits, therethrough.

Referring to FIG. 7(a), copies of a given B-DMC W are combined in a recursive manner to output a vector channel $W_{vec}$ given by $X_N \rightarrow Y_N$, where N=$2^n$ and n is an integer equal to or greater than 0. Recursion always begins at the 0th level and $W_1$ = W. If n is 1 (n=1), this means the first level of recursion in which two independent copies of $W_1$ are combined. If the above two copies are combined, a channel $W_2: X_2 \rightarrow Y_2$ is obtained. A transitional probability of this new channel $W_2$ may be represented by the following equation.

Equation 3

$$W_2(y_1, y_2 | u_1, u_2) = W(y_1 | u_1 \oplus u_2)W(y_1 | u_2)$$

If the channel $W_2$ is obtained, two copies of the channel $W_2$ are combined to obtain a single copy of a channel W4. Such recursion may be represented by W4: X4→Y4 having the following transitional probability.

Equation 4

$$W_4(y_1^4 | u_1^4) = W_2(y_1^2 | u_1 \oplus u_2, u_3 \oplus u_4)W_2(y_3^4 | u_2, u_4)$$

In FIG. 7(b), $G_N$ is a size-N generator matrix. The relationship between input $u^N_1$ to $G_N$ and output $x^N_1$ of $G_N$ of FIG. 7(b) may be represented as $x^N_1 = u^N_1 G_N$, where $x^N_1 = \{x_1, ..., x_N\}$, $u^N_1 = \{u_1, ..., u_N\}$. When N B-DMCs are combined, each B-DMC may be expressed in a recursive manner. That is, $G_N$ may be indicated by the following equation.

Equation 5

$$G_N = B_N F^{\otimes n}$$

Herein, $\otimes$ denotes the Kronecker product, N=$2^n$, n>=1, $F^{\otimes n} = F \otimes F^{\otimes(n-1)}$, and $F^{\otimes 0} = 1$. $B_N$ is a permutation matrix known as a bit-reversal operation and $B_N = R_N(I_2 \otimes B_{N/2})$ and may be recursively computed. $I_2$ is a 2-dimensional identity matrix and this recursion is initialized to $B_2 = I_2$. $R_N$ is a bit-reversal interleaver and is used to map an input $s^N_1 = \{s_1, ..., s_N\}$ to an output $x^N_1 = \{s_1, s_3, ..., s_{N-1}, s_2, ..., s_N\}$. For example, $G_2$ corresponds to a base matrix **F** shown in FIG. 6(b). $G_4$ may be expressed as the following matrix.

Equation 6

$$G_4 = \begin{bmatrix} 1 & 0 & 0 & 0 \\ 0 & 0 & 1 & 0 \\ 0 & 1 & 0 & 0 \\ 0 & 0 & 0 & 1 \end{bmatrix} \begin{bmatrix} 1 & 0 \\ 1 & 1 \end{bmatrix}^{\otimes 2} = \begin{bmatrix} 1 & 0 & 0 & 0 \\ 1 & 0 & 1 & 0 \\ 1 & 1 & 0 & 0 \\ 1 & 1 & 1 & 1 \end{bmatrix}$$

A bit-reversal interleaver may not be included on the transmitting side. Without considering the bit-reversal interleaver, $G_N$ may be expressed as $G_N = (G_2)^{\otimes n}$ (where N=$2^n$). $(G_2)^{\otimes n}$ denotes the n-th Kronecker power of the matrix $G_2$, where $G_2$ is the same as the basic matrix F shown in FIG. 6(b).

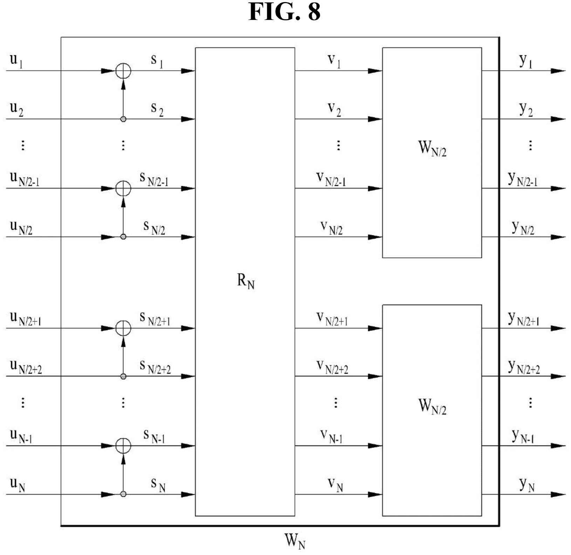

The relationship of Equation 5 is illustrated in FIG. 8.

FIG. 8 illustrates N-th level channel combining for a polar code.

A process of defining an equivalent channel for specific input after combining N B-DMCs Ws is called channel splitting. Channel splitting may be represented as a channel transition probability indicated by the following equation.

Equation 7

$$W_N^i(y_1^N, u_1^{i-1}|u_i) = \sum_{u_{i+1}^N} \frac{1}{2^{N-1}} W_N(y_1^N|u_1^N)$$

Channel polarization has the following characteristics:

> Conservation: C(W⁻) + C(W⁺) = 2C(W),
> Extremization: C(W⁻) <= C(W) <= C(W⁺).

When channel combining and channel splitting are performed, the following theorem may be obtained.

**[0104]** * Theorem: For any B-DMC W, channels {$W_N^{(i)}$} are polarized in the following sense. For any fixed $\delta \in \{0,1\}$, as N goes to infinity through powers of 2, the fraction of indexes $i \in \{1,...,N\}$ for channel capacity $I(W_N^{(i)} \in (1-\delta,1]$ goes to I(W) and the faction of i for channel capacity $I(W_N^{(i)}) \in [0,\delta)$ goes to 1-I(W). Hence, if $N \to \infty$, then channels are perfectly noisy or are polarized free of noise. These channels can be accurately recognized by the transmitting side. Therefore, bad channels are fixed and non-fixed bits may be transmitted on good channels.

That is, if the size N of polar codes is infinite, a channel has much noise or is free of noise, with respect to a specific input bit. This has the same meaning that the capacity of an equivalent channel for a specific input bit is divided into 0 or I(W).

Inputs of a polar encoder are divided into bit channels to which information data is mapped and bit channels to which the information data is not mapped. As described earlier, according to the theorem of the polar code, if a codeword of the polar code goes to infinity, the input bit channels may be classified into noiseless channels and noise channels. Therefore, if information is allocated to the noiseless bit channels, channel capacity may be obtained. However, in actuality, a codeword of an infinite length cannot be configured, reliabilities of the input bit channels are calculated and data bits are allocated to the input bit channels in order of reliabilities. In the present disclosure, bit channels to which data bits are allocated are referred to as good bit channels. The good bit channels may be input bit channels to which the data bits are mapped. Bit channels to which data is not mapped are referred to as frozen bit channels. A known value (e.g., 0) is input to the frozen bit channels and then encoding is performed. Any values which are known to the transmitting side and the receiving side may be mapped to the frozen bit channels. When puncturing or repetition is performed, information about the good bit channels may be used. For example, positions of codeword bits (i.e., output bits) corresponding to positions of input bits to which information bits are not allocated may be punctured.

A decoding scheme of the polar codes is a successive cancellation (SC) decoding scheme. The SC decoding scheme obtains a channel transition probability and then calculates a likelihood ratio (LLR) of input bits using the channel transition probability. In this case, the channel transition probability may be calculated in a recursive form if channel combining and channel splitting procedures use characteristics of the recursive form. Therefore, a final LLR value may also be calculated in the recursive form. First, a channel transition probability $W_N^{(i)}(y_1^N, u_1^{i-1}|u_1)$ of an input bit $u_i$ may be obtained as follows. $u_1^i$ may be split into odd indexes and even indexes as expressed as $u_{1,o}^i$, $u_{1,e}^i$, respectively. The channel transition probability may be indicated by the following equations.

Equation 8

$$W_{2N}^{(2i-1)}(y_1^{2N}, u_1^{2i-1}|u_{2i-1})$$

$$= \sum_{u_{2i}^{2N}} \frac{1}{2^{2N-1}} W_{2N}(y_1^{2N}|u_1^{2N})$$

$$= \sum_{u_{2i,o}^{2N}, u_{2i,e}^{2N}} \frac{1}{2^{2N-1}} W_N(y_1^N|u_{1,o}^{2N} \oplus u_{1,e}^{2N}) W_N(y_{N+1}^{2N}|u_{1,e}^{2N})$$

$$= \sum_{u_{2i}} \frac{1}{2} \sum_{u_{2i+1,e}^{2N}} \frac{1}{2^{N-1}} W_N(y_{N+1}^{2N}|u_{1,e}^{2N}) \cdot \sum_{u_{2i+1,o}^{2N}} \frac{1}{2^{N-1}} W_N(y_1^N|u_{1,o}^{2N} \oplus u_{i,e}^{2N})$$

$$= \sum_{u_{2i}} \frac{1}{2} W_N^{(i)}(y_1^N, u_{1,o}^{2i-2} \oplus u_{i,e}^{2i-2}|u_{2i-1} \oplus u_{2i}) \cdot W_N^{(i)}(y_{N+1}^{2N}, u_{1,e}^{2i-2}|u_{2i})$$

$$where\ W_N^{(i)}(y_1^N, u_1^{i-1}|u_i) = \sum_{u_{i+1}^N} \frac{1}{2^{N-1}} W_N(y_1^N|u_1^N).$$

Equation 9

$$W_{2N}^{(2i)}(y_1^{2N}, u_1^{2i-1}|u_{2i})$$

$$= \sum_{u_{2i+1}^{2N}} \frac{1}{2^{2N-1}} W_{2N}(y_1^{2N}|u_1^{2N})$$

$$= \sum_{u_{2i+1,o}^{2N}, u_{2i+1,e}^{2N}} \frac{1}{2^{2N-1}} W_N(y_1^N|u_{1,o}^{2N} \oplus u_{i,e}^{2N}) W_N(y_{N+1}^{2N}|u_{1,e}^{2N})$$

$$= \frac{1}{2} \sum_{u_{2i+1,e}^{2N}} \frac{1}{2^{N-1}} W_N(y_{N+1}^{2N}|u_{1,e}^{2N}) \cdot \sum_{u_{2i+1,o}^{2N}} \frac{1}{2^{N-1}} W_N(y_1^N|u_{1,o}^{2N} \oplus u_{i,e}^{2N})$$

$$= \frac{1}{2} W_N^{(i)}(y_1^N, u_{1,o}^{2i-2} \oplus u_{i,e}^{2i-2}|u_{2i-1} \oplus u_{2i}) \cdot W_N^{(i)}(y_{N+1}^{2N}, u_{1,e}^{2i-2}|u_{2i})$$

A polar decoder retrieves information and generates an estimate $u^{\wedge N}{}_1$ of $u^N{}_1$ using values (e.g., reception bits, frozen bits, etc.) known for the polar codes. The LLR is defined as follows.

Equation 10

$$L_N^{(i)}(y_1^N, u_1^{i-1}) = \frac{W_N^{(i)}(y_1^N, u_1^{i-1}|u_i = 0)}{W_N^{(i)}(y_1^N, u_1^{i-1}|u_i = 1)}$$

The LLR may be recursively calculated as follows.

Equation 11

$$L_N^{(2i-1)}(y_1^N, \hat{u}_1^{2i-2}) = \frac{L_{N/2}^{(i)}(y_1^{N/2}, \hat{u}_{1,o}^{2i-2} \oplus \hat{u}_{1,e}^{2i-2}) \cdot L_{N/2}^{(i)}(y_{N/2+1}^N, \hat{u}_{1,e}^{2i-2}) + 1}{L_{N/2}^{(i)}(y_1^{N/2}, \hat{u}_{1,o}^{2i-2} \oplus \hat{u}_{1,e}^{2i-2}) + L_{N/2}^{(i)}(y_{N/2+1}^N, \hat{u}_{1,e}^{2i-2})}$$

$$L_N^{(2i)}(y_1^N, \hat{u}_1^{2i-1}) = [L_{N/2}^{(i)}(y_1^{N/2}, \hat{u}_{1,o}^{2i-2} \oplus \hat{u}_{1,e}^{2i-2})]^{1-2\hat{u}_{2i-1}} \cdot L_{N/2}^{(i)}(y_{N/2+1}^N, \hat{u}_{1,e}^{2i-2})$$

Recursive calculation of LLRs is traced back to a code length of 1 with an LLR $L^{(1)}{}_1(y_i) = W(y_i|0)/W(y_i|1)$. $L^{(1)}{}_1(y_i)$ is soft information observed from a channel.

The complexity of a polar encoder and an SC decoder varies with the length N of polar codes and is known as having O(MogN). Assuming that K input bits are used for a length-N polar code, a coding rate becomes N/K. If a generator matrix of a polar encoder of a data payload size N is $G_N$, an encoded bit may be represented as $x^N{}_1 = u^N{}_1 G_N$. It is assumed that K bits out of $u^N{}_1$ correspond to payload bits, a row index of $G_N$ corresponding to the payload bits is i, and a row index of $G_N$ corresponding to (N-K) bits is F. A minimum distance of the polar codes may be given as $d_{min}(C) = min_{i \in I} 2^{wt(i)}$, where wt(i) is the number of 1s within binary extension of i and i=0,1,...,N-1.

SC list (SCL) decoding is an extension of a basic SC decoder. In this type of decoder, L decoding paths are simultaneously considered in each decoding stage. Herein, L is an integer. In other words, in the case of the polar codes, a list-L decoding algorithm is an algorithm for simultaneously tracking L paths in a decoding process.

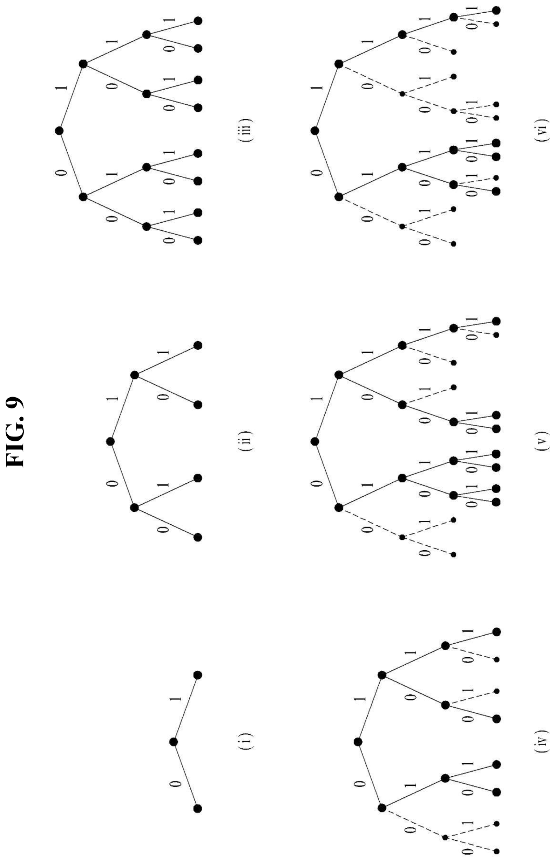

FIG. 9 illustrates an evolution of decoding paths in a list-L decoding process. For convenience of description, it is assumed that the number of bits that should be determined is n and all bits are not frozen. If a list size L is 4, each level includes at most 4 nodes with paths that continue downward. Discontinued paths are expressed by dotted lines in FIG. 9. A process in which decoding paths evolve in list-L decoding will now be described with reference to FIG. 9. i) If list-L decoding is started, the first unfrozen bit may be either 0 or 1. ii) list-L decoding continues. The second unfrozen bits may be either 0 or 1. Since the number of paths is not greater than L=4, pruning is not needed yet. iii) Consideration of all options for the first bit (i.e., a bit of the first level), the second bit (i.e., a bit of the second level), and the third bit (i.e., a bit of the third level) results in 8 decoding paths which are excessive because L=4. iv) the 8 decoding paths are pruned to L (=4) promising paths. v) 4 active paths continue by considering two options of the fourth unfrozen bit. In this case, the number of paths is doubled, i.e., 8 paths which are excessive because L=4. vi) The 8 paths are pruned back to L (=4) best paths. In the example of FIG. 7, 4 candidate codewords 0100, 0110, 0111, and 1111 are obtained and one of the codewords is determined to be a codeword most similar to an original codeword. In a similar manner to a normal decoding process, for example, in a pruning process or a process of determining a final codeword, a path in which the sum of LLR absolute values is largest may be selected as a survival path. If a CRC is present, the survival path may be selected through the CRC.

Meanwhile, CRC-aided SCL decoding is SCL decoding using CRC and improves the performance of polar codes. CRC is the most widely used technique in error detection and error correction in the field of information theory and coding. For example, if an input block of an error correction encoder has K bits and the length of information bits is k, and the length of CRC sequences is m bits, then K = k + m. CRC bits are a part of source bits for an error correction code. If the size of channel codes used for encoding is N, a code rate R is defined as R=K/N. CRC aided SCL decoding serves to detect an errorless path while a receiving device confirms a CRC code with respect to each path. An SCL decoder outputs candidate sequences to a CRC detector. The CRC detector feeds back a check result in order to aid in determining a codeword.

Although complicated as compared with an SC algorithm, SCL decoding or CRC aided SCL decoding has an advantage of excellent decoding performance. For more details of a list-L decoding algorithm of the polar codes, refer to 'I. Tal and A. Vardy, "List decoding of polar codes," in Proc. IEEE Int. Symp. Inf. Theory, pp. 1-5, Jul. 2011'.

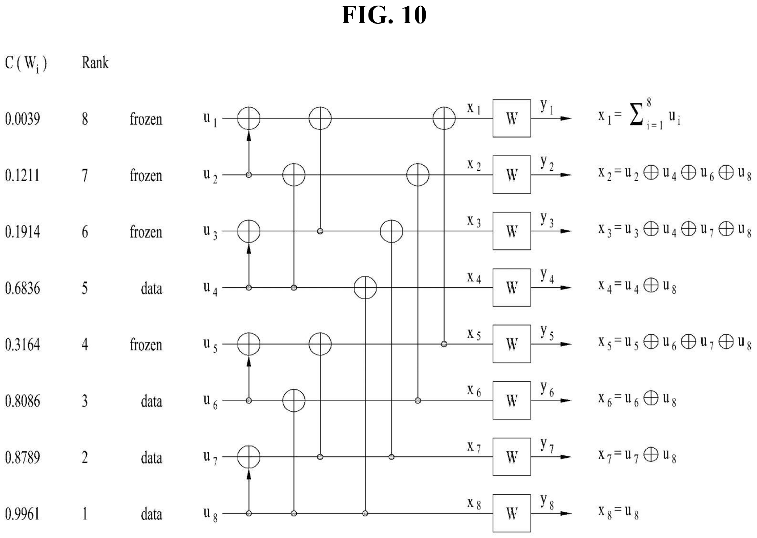

FIG. 10 illustrates the concept of selecting position(s) to which information bit(s) are to be allocated in polar codes.

In the example of FIG. 10, it is assumed that the size N of mother codes is 8, i.e., the size N of polar codes is 8, and a code rate is 1/2.

In FIG. 10, $C(W_i)$ denotes the capacity of a channel $W_i$ and corresponds to the reliability of channels that input bits of a polar code experience. When channel capacities corresponding to input bit positions of the polar code are as illustrated in FIG. 10, reliabilities of the input bit positions are ranked as illustrated in FIG. 10. To transmit data at a code rate of 1/2, a transmitting device allocates 4 bits constituting the data to 4 input bit positions having high channel capacities among 8 input bit positions (i.e., input bit positions denoted as $u_4$, $u_6$, $u_7$, and $u_8$ among input bit positions $u_1$ to $u_8$ of FIG. 10) and freezes the other input bit positions. A generator matrix $G_8$ corresponding to the polar code of FIG. 10 is as follows. The generator matrix $G_8$ may be acquired based on $(\mathbf{G}_2)^{\otimes n}$.

$$\text{Equation 12}$$

$$G_8 = \begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

The input bit positions denoted as $u_1$ to $u_8$ of FIG. 10 correspond one by one to rows from the highest row to the lowest row of $G_8$. Referring to FIG. 10, it may be appreciated that the input bit corresponding to $u_8$ affects all output coded bits. On the other hand, it may be appreciated that the input bit corresponding to $u_1$ affects only $y_1$ among the output coded bits. Referring to Equation 12, when binary-input source bits $u_1$ to $u_8$ are multiplied by $G_8$, a row in which the input bits appear at all output bits is the lowest row [1, 1, 1, 1, 1, 1, 1, 1] in which all elements are 1, among rows of $G_8$. Meanwhile, a row in which the binary-input source bits appears at only one output bit is a row in which one element is 1 among the rows of $G_8$, i.e., a row [1, 0, 0, 0, 0, 0, 0, 0] in which a row weight is 1. Similarly, it may be appreciated that a row in which a row weight is 2 reflects input bits corresponding to the row in two output bits. Referring to FIG. 10 and Equation 12, $u_1$ to $u_8$ correspond one by one to the rows of $G_8$ and bit indexes for distinguishing between input positions of $u_1$ to $u_8$, i.e., bit indexes for distinguishing between the input positions, may be assigned to the rows of $G_8$.

Hereinafter, for Polar codes, it may be assumed that bit indexes from 0 to N-1 are sequentially allocated to rows of $G_N$ starting from the highest row having the smallest row weight with respect to N input bits. For example, referring to FIG. 10, a bit index 0 is allocated to the input position of $u_1$, i.e., the first row of $G_8$ and a bit index 7 is allocated to the input position of $u_8$, i.e., the last row of $G_8$. However, since the bit indexes are used to indicate input positions of the polar code, a scheme different from the above allocation scheme may be used. For example, bit indexes from 0 to N-1 may be allocated staring from the lowest row having the largest row weight.

In the case of output bit indexes, as illustrated in FIG. 10 and Equation 12, it may be assumed that bit indexes from 0 to N-1 or bit indexes from 1 to N are assigned to columns from the first column having the largest column weight to the last column having the smallest column weight among columns of $G_N$.

In Polar codes, setting of information bits and frozen bits is one of the most important elements in the configuration and performance of the polar code. That is, determination of ranks of input bit positions may be an important element in the performance and configuration of the polar code. For Polar codes, bit indexes may distinguish input or output positions of the polar code. In the present disclosure, a sequence obtained by enumerating reliabilities of bit positions in ascending or descending order are referred to as a bit index sequence or polar sequence. That is, the bit index sequence represents reliabilities of input or output bit positions of the polar code in ascending or descending order. A transmitting device inputs information bits to input bits having high reliabilities based on the input bit index sequence and performs encoding using the polar code. A receiving device may discern input positions to which information bits are allocated or input positions to which frozen bits are allocated, using the same or corresponding input bit index sequence. That is, the receiving device may perform polar decoding using an input bit index sequence which is identical to or corresponds to an input bit index sequence used by the transmitting device and using a corresponding polar code. In the following description, it may be assumed that an input bit index sequence is predetermined so that information bit(s) may be allocated to input bit position(s) having high reliabilities. In the present disclosure, the input bit index sequence is also called a Polar sequence.

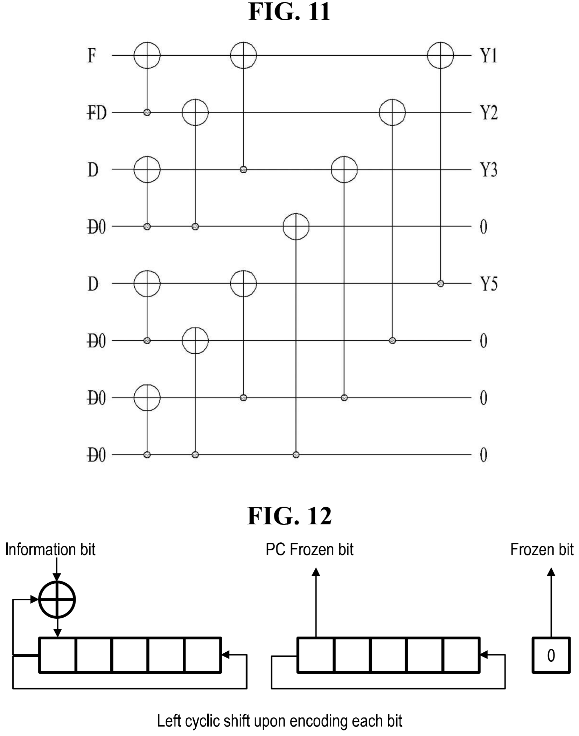

FIG. 11 illustrates puncturing and information bit allocation for polar codes. In FIG. 11, F denotes a frozen bit, D denotes an information bit, and 0 denotes a skipping bit.

Among coded bits, the case in which an information bit is changed to a frozen bit may occur according to an index or position of a punctured bit. For example, if output coded bits for a mother code of N=8 should be punctured in order of Y8, Y7, Y6, Y4, Y5, Y3, Y2, and Y1 and a target code rate is 1/2, then Y8, Y7, Y6, and Y4 are punctured, U8, U7, U6, and U4 connected only to Y8, Y7, Y6, and Y4 are frozen to 0, and these input bits are not transmitted, as illustrated in FIG. 9. An input bit changed to a frozen bit by puncturing of a coded bit is referred to as a skipping bit or a shortening bit and a corresponding input position is referred to as a skipping position or a shortening position. Shortening is a rate matching method of inserting a known bit into an input bit position connected to a position of an output bit desired to be transmitted while maintaining the size of input information (i.e., the size of information blocks). Shortening is possible starting from input corresponding to a column in which a column weight is 1 in a generator matrix $G_N$ and next shortening may be performed with respect to input corresponding to a column in which a column weight is 1 in a remaining matrix from which a column and row in which a column weight is 1 are removed. To prevent all information bits from being punctured, an information bit that should have been allocated to an information bit position may be reallocated in order of a high reliability within a set of frozen bit positions.

In the case of the polar code, decoding may be generally performed in the following order.

> 1. Bit(s) having low reliabilities are recovered first. Although reliability differs according to the structure of a decoder, since an input index in an encoder (hereinafter, an encoder input bit index or bit index) having a low value usually has a low reliability, decoding is generally performed staring from a low encoder input bit index.
> 2. When there is a known bit for a recovered bit, the known bit is used together with the recovered bit or the process of 1 is omitted and a known bit for a specific input bit position is immediately used, thereby recovering an information bit, which is an unknown bit. The information bit may be a source information bit (e.g., a bit of a transport block) or a CRC bit.

As explained earlier, the process of channel combining and channel splitting results in an equivalent channel being divided into a noisy channel and a noise-free channel. A data payload needs be transmitted over the noise-free channel. In other words, the data payload needs to be transmitted over the noise-free equivalent channel to achieve the desired performance. The noise-free equivalent channel may be determined by computing the value of the equivalent channel, $Z(W) = \sum \sqrt{W(y|0)W(y|1)}$ for each input bit. Z(W) is called the Battacharyya parameter, which may represent a value corresponding to the upper bound of the error probability when a MAP (maximum a posteriori probability) decision for transmission of binary input 0 or 1 is performed. Therefore, the transmitting side may obtain the values of Z(W), select equivalent channel(s) up to the size of the data payload in ascending order (e.g., decreasing order) of the values of Z(W), and use the equivalent channel(s) for transmission of the data payload. For a binary erasure channel (BEC), Z(W) may be obtained through Equation 13.

Equation 13

$$Z(W_N^{(i)}) = Z(W_{(b_1,b_2,...,b_{k-1})}) = \begin{cases} 2Z(W_{(b_1,b_2,...,b_{k-1})}) - Z(W_{(b_1,b_2,...,b_{k-1})})^2, & if \ b_k = 0 \\ Z(W_{(b_1,b_2,...,b_{k-1})})^2, & if \ b_k = 1 \end{cases}$$

For example, when the BEC has a binary probability of 0.5 and a code block size of 8, the values of Z(W) may be calculated according to Equation 11 as follows: Z(W) = {1.00, 0.68, 0.81, 0.12, 0.88, 0.19, 0.32, 0.00}. Thus, when the size of a data payload is 2, the data payload may be transmitted over equivalent channel 8 with Z(W) = 0.00 and equivalent channel 4 with Z(W) = 0.12.

As described above, since a polar encoder has different reliability depending on input positions, the transmitting side may allocate a data block (i.e., an information block before encoding) to bit channel(s) in order of reliability according to the size of the corresponding data block and perform encoding by setting all others to be frozen (e.g., with a value of '0'). For example, if the mother code size of the polar encoder (i.e., the maximum size of a code block that the polar encoder is capable of encoding) is N, and if the size of a data block input to the polar encoder is K, polar encoding is performed by arranging the bits of the data block in order of reliability in K bit channels and setting 0 to N-K bit channel(s).

The following shows the polar sequence used in NR (5G) systems (see the polar sequence defined in 3GPP TS 38.212 Rel-15).

<Polar sequence>

| W | I | W | I | W | I | W | I | W | I | W | I | W | I | W | I |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |
| 3 | 4 | 131 | 57 | 259 | 400 | 387 | 449 | 515 | 335 | 643 | 692 | 771 | 929 | 899 | 940 |
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 194 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |

(continued)

| W | I | W | I | W | I | W | I | W | I | W | I | W | I | W | I |
|---|---|---|---|---|---|---|---|---|---|---|---|---|---|---|---|
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |
| 42 | 26 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |
| 50 | 264 | 178 | 546 | 306 | 173 | 434 | 125 | 562 | 665 | 690 | 251 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |

(continued)

| W | I | W | I | W | I | W | I | W | I | W | I | W | I | W | I |
|---|---|---|---|---|---|---|---|---|---|---|---|---|---|---|---|
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |

(continued)

| W | I | W | I | W | I | W | I | W | I | W | I | W | I | W | I |
|---|---|---|---|---|---|---|---|---|---|---|---|---|---|---|---|
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |
| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

The above table shows a Polar sequence $\mathbf{Q}_0^{Nmax-1}$ and a reliability $W(Q_i^{Nmax})$ of the Polar sequence. In the above table, $W$ denotes $W(Q_i^{Nmax})$ and $I$ denotes $Q_i^{Nmax}$. Namely, the Polar sequence $\mathbf{Q}_0^{Nmax-1} = \{Q_0^{Nmax}, Q_1^{Nmax},..., Q_{Nmax-1}^{Nmax}\}$ is given by the above table, where $0<=Q_i^{Nmax}<=Nmax-1$ denotes a bit index (i.e., bit channel index) before Polar encoding for i=0,1,...,Nmax-1. For 3GPP TS 38.212 Re1-15, Nmax = 1024. The Polar sequence $\mathbf{Q}_0^{Nmax-1}$ is ascending order of reliability $W(Q_0^{Nmax})<W(Q_1^{Nmax})<...<W(Q_{Nmax-1}^{Nmax})$, where $W(Q_i^{Nmax})$ denotes the reliability of bit index $Q_i^{Nmax}$. For example, referring to the above table, a reliability $W(Q_i^{Nmax})=3$ of a bit index $Q_i^{Nmax}=4$ is lower than a reliability $W(Q_i^{Nmax})=7$ of bit index $Q_i^{Nmax}=3$. That is, the above table lists, in ascending order of reliability, bit indexes 0 to 1023 which respectively indicate 1024 input positions of a Polar code of Nmax=1024.

For any information block encoded to N bits, a same Polar sequence $\mathbf{Q}_0^{N-1} = \{Q_0^N, Q_1^N, Q_2^N,...,Q_{N-1}^N\}$ is used. The Polar sequence $\mathbf{Q}_0^{N-1}$ is a subset of Polar sequence $\mathbf{Q}_0^{Nmax-1}$ with all elements $Q_i^{Nmax}$ of values less than N, ordered in ascending order of reliability $W(Q_0^N)<W(Q_1^N)<W(Q_2^N)<...<W(Q_{N-1}^N)$. For example, when N=8, a Polar sequence $\mathbf{Q}_0^7$ includes elements of $Q_i^{Nmax}<8$ among elements of the Polar sequence $\mathbf{Q}_0^{Nmax-1}$ and the elements of $Q_i^{Nmax}<8$ are ordered in ascending order of reliability $W(0)<W(1)<W(2)<W(4)<W(3)<W(5)<W(6)$.

For example, Table 3 lists input bit positions for an information block of size K (=10) input to a Polar code in a Polar sequence of N=512.

Table 3

| | Polar sequence |
|---|---|
| 1 | *505* |
| 2 | 506 |
| 3 | 479 |
| 4 | 508 |

(continued)

|  | Polar sequence |
|---|---|
| 5 | 495 |
| 6 | 503 |
| 7 | 507 |
| 8 | 509 |
| 9 | 510 |
| 10 | 511 |

Table 3 shows 10 elements for K=10 among elements of the Polar sequence of N=512 in ascending order of reliability. Reffering to the above-described table of <Polar sequence>, values of I having 10 reliabilities $W(Q_i^{Nmax}$ among values of I $(=Q_i^{Nmax})$ less than N=512 are {479, 495, 503, 505, 506, 508, 509, 510, 511}. If {479, 495, 503, 505, 506, 507, 508, 509, 510, 511} are arranged in ascending order of reliability $W$, {505, 506, 479, 508, 495, 503, 507, 509, 510, 511}, which is a set of bit indexes for K=10 in the Polar sequence of N= 512 shown in Table 3, may be obtained.

If the bit sequence input to channel coding is denoted by $c_0, c_1, c_2 c_3, ..., c_{K-1}$, the bits after encoding are denoted by $d_0, d_1, d_2 d_3, ..., d_{N-1}$, where K is the number of bits to encode, where N=$2^n$ and the value of n is determined by the following table.

Table 4

$$\text{If } E \leq (9/8) \cdot 2^{(\lceil \log_2 E \rceil - 1)} \text{ and } K/E < 9/16$$

$$n_1 = \lceil \log_2 E \rceil - 1;$$

else

$$n_1 = \lceil \log_2 E \rceil;$$

end if

$$R_{min} = 1/8;$$

$$n_2 = \lceil \log_2 (K/R_{min}) \rceil;$$

$$n = \max\{\min\{n_1, n_2, n_{max}\}, n_{min}\}$$

$$\text{where } n_{min} = 5.$$

In Table 4, $n_{max}$ may be a value predetermined depending on the type of channel or control information and/or the number of information bits input into a channel coding block. For example, $n_{max}$ for a broadcast channel (BCH) may be predetermined as 9, $n_{max}$ for DCI may be predetermined as 9, and $n_{max}$ for UCI may be predetermined as 10.

In Table 4, E denotes a rate matching output sequence length. The rate matching output sequence length E may be predetermined depending on the type of channel, the type of control information, the amount of resources mapped to channel or control information, and/or the number of code blocks used for transmission of control information. For example, the rate matching output sequence length E for a BCH is 864, the rate matching output sequence length E for is 864, and the rate matching output sequence length E for UCI may be predetermined based on the number of OFDM symbols carrying the UCI, the number of RBs, a spreading factor, the number of code blocks for the UCI, and/or the type of UCI included in a UCI payload (e.g., HARQ-ACK, scheduling request (SR), channel state information (CSI), etc.).

For any information block encoded to N bits, a same Polar sequence $Q_0^{N-1} = \{Q_0^N, Q_1^N, Q_2^N, ..., Q_{N-1}^N\}$ is used. The Polar sequence $\mathbf{Q}_0^{N-1}$ is a subset of Polar sequence $\mathbf{Q}_0^{Nmax-1}$ with all elements $Q_i^{Nmax}$ of values less than N, ordered in ascending order of reliability $W(Q_0^N)<W(Q_1^N)<W(Q_2^N)<...<W(Q_{N-1}^N)$.

In the NR system, under specific conditions such as when 18 <= polar code information size <= 25, parity check bits are generated to improve performance (e.g., block error rate (BLER)) when using polar codes. Here, a polar code information size K refers to the number of information bits encoded through polar coding. For example, the sum of code block bits and code block CRC bit(s) may be equivalent to the polar code information size.

FIG. 12 illustrates a method of generating parity check bit(s) used in polar codes.

In some implementations, a parity check (PC) polar code may be used. The PC polar code refers to a polar code that places PC bit(s) generated using a portion of a data block (i.e., information block) in the input of a polar encoder. According to the currently published NR specifications, the PC polar code may be used when the data block size K is within a range of 18 <= K <= 25. In this case, the number of PC bits is 3, and the PC bits may be generated using a 5-bit shift register as illustrated in FIG. 12. In FIG.12, the 5-bit shift register, i.e., y[0], y[1], y[2], y[3], and y[4], are all initialized to 0. That is, PC bit(s) may be generated for a data block $[u_0, u_1, u_2, ..., u_{N-1}]$ as follows.

> The register is cyclically shifted to the left.
> If $u_i$ is an information bit, set y[0] = ($u_i$ XOR y[0]),
> If $u_i$ is a PC bit, set $u_i$ = y[0].

The generated PC bit(s) are assigned to input bit channels (i.e., the bit indices of the polar code) of the polar encoder as follows. When E - K + 3 > 192, $n^{wm}_{PC} = 1$, and when E - K + 3 <= 192, $n^{wm}_{PC} = 0$. In this case, if a set of bit indices for the PC bits is denoted as $\mathbf{Q}^N_{PC}$, and if a set of bit indices for other PC bits among $\mathbf{Q}^N_{PC}$ is denoted as $\mathbf{Q}^N_{PC\_wm}$, the size of the set $\mathbf{Q}^N_{PC}$ is $|\mathbf{Q}^N_{PC}| = n_{PC}$, and the size of the set $\mathbf{Q}^N_{PC\_wm}$ is $|\mathbf{Q}^N_{PC\_wm}| = n^{wm}pc$. According to the NR specifications (e.g., 3GPP TS 38.212 Rel-15), $\mathbf{Q}^N_{PC}$ and $\mathbf{Q}^N_{PC\_wm}$ may be calculated as follows. For a bit index j ranging from 0 to N - 1 (i.e., j = 0, 1, ..., N-1), the j-th row of $\mathbf{G}_N$ is denoted as $\mathbf{g}_j$, and the row weight of $\mathbf{g}_j$ is denoted as $w(\mathbf{g}_j)$, where $w(\mathbf{g}_j)$ is the count of ones within $\mathbf{g}_j$. In this case, ($n_{PC}$ - $n^{wm}_{PC}$) PC bits are placed on ($n_{PC}$ - $n^{wm}_{PC}$) least reliable bit indices in $\overline{\mathbf{Q}}^N_I$. In addition, the remaining $\mathbf{n}^{wm}_{PC}$ PC bits are placed on bit indices with the minimum row weight in $\overline{\mathbf{Q}}^N_I$, where $\widetilde{\mathbf{Q}}^N_I$ denotes ($\left|\mathbf{Q}^N_I\right| - n_{PC}$) most reliable bit indices. If there are more bit indices with the same minimum row weight in $\widetilde{\mathbf{Q}}^N_I$ than $n^{wm}_{PC}$, the remaining $n^{wm}_{PC}$ PC bits are placed on $n^{wm}_{PC}$ bit indices with the highest reliability and the minimum row weight in $\widetilde{\mathbf{Q}}^N_I$.

The input to polar encoding, $\mathbf{u} = [u_0\ u_1\ u_2\ ...\ u_{N-1}]$ may be generated according to Table 5 below.

Table 5

$$k = 0;$$

$$\text{if } n_{PC} > 0$$

$$y_0 = 0; \ y_1 = 0; \ y_2 = 0; \ y_3 = 0; \ y_4 = 0;$$

$$\text{for } n = 0 \text{ to } N - 1$$

$$y_t = y_0; \ y_0 = y_1; \ y_1 = y_2; \ y_2 = y_3; \ y_3 = y_4; \ y_4 = y_t;$$

$$\text{if } n \in \overline{\mathbf{Q}}_I^N$$

$$\text{if } n \in \mathbf{Q}_{PC}^N$$

$$u_n = y_0;$$

$$\text{else}$$

$$u_n = c_k^{'};$$

$$k = k + 1;$$

$$y_0 = y_0 \oplus u_n;$$

$$\text{end if}$$

$$\text{else}$$

$$u_n = 0;$$

$$\text{end if}$$

$$\text{end for}$$

$$\text{else}$$

$$\text{for } n = 0 \text{ to } N - 1$$

$$\text{if } n \in \overline{\mathbf{Q}}_I^N$$

$$u_n = c_k^{'};$$

$$k = k + 1;$$

$$\text{else}$$

$$u_n = 0;$$

$$\text{end if}$$

$$\text{end for}$$

$$\text{end if}$$

The output after encoding, $\mathbf{d} = [d_0 \ d_1 \ d_2 \ d_3 \ ... \ d_{N-1}]$ is obtained from $\mathbf{d} = \mathbf{u}\mathbf{G}_N$, and the encoding is performed by GF(2).

In some implementations, rate matching is performed after channel coding. In the NR specifications, rate matching for polar codes is defined for each code block, and the rate matching consists of sub-block interleaving, bit selection, and bit interleaving. In this specification, an input bit sequence before rate matching may be denoted as $d_0$, $d_1$, $d_2$, $d_3$, ..., $d_{N-1}$, and an output bit sequence after rate matching may be denoted as $f_0$, $f_1$, $f_2$, $f_3$, ..., $f_{E-1}$. Bits input to a sub-block interleaver are coded bits $d_0$, $d_1$, $d_2$, $d_3$, ..., $d_{N-1}$. The coded bits $d_0$, $d_1$, $d_2$, $d_3$, ..., $d_{N-1}$ may be divided into 32 sub-blocks. Bits output from the sub-block interleaver may be denoted as $y_0, y_1, y_2, y_3, ..., y_{N-1}$, which may be generated as follows: for n = 0 to N-1: i = floor(32n / N); J(n) = P(i) * (N / 32) + mod(n, N / 32); $y_n = d_{J(n)}$, where a sub-block interleaver pattern P(i) is determined according to Table 6 below.

Table 6

| i | P(i) | i | P(i) | i | P(i) | i | P(i) | i | P(i) | i | P(i) | i | P(i) | i | P(i) |
|---|------|---|------|----|------|----|------|----|------|----|------|----|------|----|------|
| 0 | 0 | 4 | 3 | 8 | 8 | 12 | 10 | 16 | 12 | 20 | 14 | 24 | 24 | 28 | 27 |
| 1 | 1 | 5 | 5 | 9 | 16 | 13 | 18 | 17 | 20 | 21 | 22 | 25 | 25 | 29 | 29 |
| 2 | 2 | 6 | 6 | 10 | 9 | 14 | 11 | 18 | 13 | 22 | 15 | 26 | 26 | 30 | 30 |
| 3 | 4 | 7 | 7 | 11 | 17 | 15 | 19 | 19 | 21 | 23 | 23 | 27 | 28 | 31 | 31 |

$G_N = (G_2)^{\otimes n}$ denotes the n-th Kronecker power of the matrix $G_2$, where N is $2^n$ and $G_2$ is the same as the basic matrix F shown in FIG. 6(b).

In some implementations, the bit sequence $y_0, y_1, y_2, y_3, ..., y_{N-1}$ after the sub-block interleaver is written into a cyclic buffer of length N. If the rate matching output sequence length is denoted as E, a bit selection output bit sequence $e_k$ (where k = 0, 1, 2, ..., E-1) may be generated as follows.

Table 7

if $E \geq N$ -- repetition

    for $k = 0$ to $E - 1$

$$e_k = y_{\text{mod}(k,N)};$$

    end for

else

    if $K / E \leq 7/16$ -- puncturing

      for $k = 0$ to $E - 1$

$$e_k = y_{k+N-E};$$

      end for

    else -- shortening

      for $k = 0$ to $E - 1$

$$e_k = y_k;$$

      end for

    end if

end if

Puncturing or shortening is a technique where some of the encoded bits are not transmitted when resources allocated for transmission are not large enough to accommodate all the encoded bits. Repetition is a technique where some of the encoded bits are duplicated and transmitted when resources allocated for transmission are large enough to accommodate all the encoded bits.

Depending on the type of transport channel or control information or depending on the channel coding scheme, a bit sequence $e_0, e_1, e_2, ..., e_{E-1}$ may be interleaved into the bit sequence $f_0, f_1, f_2, f_3, ..., f_{E-1}$. For example, in the case of polar coding for UCI, the bit sequence $e_0, e_1, e_2, ..., e_{E-1}$ may be interleaved into the bit sequence $f_0, f_1, f_2, f_3, ..., f_{E-1}$ as follows.

Table 8

Denote $T$ as the smallest integer such that $T(T+1)/2 \geq E$ ;

$k = 0$ ;

for $i = 0$ to $T - 1$

   for $j = 0$ to $T - 1 - i$

      if $k < E$

         $v_{i,j} = e_k$ ;

      else

         $v_{i,j} =< NULL >$ ;

      end if

      $k = k + 1$ ;

   end for

end for

$k = 0$ ;

for $j = 0$ to $T - 1$

   for $i = 0$ to $T - 1 - j$

      if $v_{i,j} \neq< NULL >$

         $f_k = v_{i,j}$ ;

         $k = k + 1$

      end if

   end for

   end for

else

   for $i = 0$ to $E - 1$

      $f_i = e_i$ ;

   end for

A set of bit indices in the polar sequence $Q_0^{N-1}$ is denoted as $\overline{\mathbf{Q}}_I^N$ , and a set of other bit indices in the polar

sequence $Q_0^{N-1}$ is denoted as $\overline{\mathbf{Q}}_F^N$ , where $\left|\overline{\mathbf{Q}}_I^N\right| = K + n_{PC}$ , $\left|\overline{\mathbf{Q}}_F^N\right| = N - \left|\overline{\mathbf{Q}}_I^N\right|$ , and $n_{PC}$ is the number of PC bits.

In the present disclosure, |S| denotes the number of elements in a set S. $\overline{\mathbf{Q}}_I^N$ and $\overline{\mathbf{Q}}_F^N$ are given as follows.

Table 9

$$\overline{\mathbf{Q}}_{F,tmp}^{N} = \varnothing$$

if $E < N$

 if $K / E \le 7/16$  -- puncturing

  for $n = 0$ to $N - E - 1$

$$\overline{\mathbf{Q}}_{F,tmp}^{N} = \overline{\mathbf{Q}}_{F,tmp}^{N} \cup \{J(n)\};$$

  end for

  if $E \ge 3N/4$

$$\overline{\mathbf{Q}}_{F,tmp}^{N} = \overline{\mathbf{Q}}_{F,tmp}^{N} \cup \{0,1,\ldots,\lceil 3N/4 - E/2 \rceil - 1\};$$

  else

$$\overline{\mathbf{Q}}_{F,tmp}^{N} = \overline{\mathbf{Q}}_{F,tmp}^{N} \cup \{0,1,\ldots,\lceil 9N/16 - E/4 \rceil - 1\};$$

  end if

 else  -- shortening

  for $n = E$ to $N - 1$

$$\overline{\mathbf{Q}}_{F,tmp}^{N} = \overline{\mathbf{Q}}_{F,tmp}^{N} \cup \{J(n)\};$$

  end for

 end if

end if

$$\overline{\mathbf{Q}}_{I,tmp}^{N} = \mathbf{Q}_{0}^{N-1} \setminus \overline{\mathbf{Q}}_{F,tmp}^{N};$$

$\overline{\mathbf{Q}}_{I}^{N}$ comprises $(K + n_{PC})$ most reliable bit indices in $\overline{\mathbf{Q}}_{I,tmp}^{N}$;

$$\overline{\mathbf{Q}}_{F}^{N} = \mathbf{Q}_{0}^{N-1} \setminus \overline{\mathbf{Q}}_{I}^{N};$$

In the present disclosure, A\B denotes the difference of set B from set A, i.e., A - B. In other words, A\B refers to a set of all elements of set A that do not belong to set B.

HARQ is a technology that combines forward error correction (FEC) and automatic repeat request (ARQ). For example, a transmitter transmits all or some of encoded coded bits by using FEC, and a receiver detects whether there is an error in the received data, and transmits a HARQ-ACK signal indicating an acknowledgement (ARQ) or negative ARQ (NACK) of the received data to the transmitter. If the transmitter determines that the data received at the receiver has no error or is below a certain threshold, the transmitter transmits new data, and in contrast, if the data received at the receiver contains an error, the transmitter retransmits the corresponding data block. The receiver combines the retransmitted data block with the previously transmitted data block and performs decoding again to detect an error. This operation may be performed until no error is detected or until a predetermined number of retransmissions are reached. The combining method for decoding the retransmitted data block may be divided into the following two types.

[0153]   * Chase combining: For combining at a receiver, the transmitter retransmits coded bits that are identical to the coded bits that are initially transmitted. Chase combining may reduce an error probability through power gain when decoding the retransmitted data block.

[0154]   * Incremental redundancy (IR): For combining at the receiver, the transmitter retransmits coded bits that are not identical to the coded bits initially transmitted. For example, the transmitter may transmit, to the receiver, redundancy that is not transmitted in the initial transmission in retransmission. In retransmission, redundancy that is not transmitted in the previous transmission is transmitted, and thus redundancy of the previous transmission and redundancy of the current transmission are combined to increase redundancy, which has an effect of lowering a code rate. That is, incremental redundancy may reduce an error probability through a coding gain during decoding of retransmitted data blocks. In general, chase combining corresponds to a case in which there is no incremental redundancy from among incremental redundancies, and thus chase combining may also be interpreted as a special form of incremental redundancy.

There are various types of HARQ schemes. For example, the HARQ schemes may be broadly categorized into synchronous HARQ schemes and asynchronous HARQ schemes based on the timing of retransmission. In addition, the HARQ schemes may be categorized into channel-adaptive schemes and channel-non-adaptive schemes depending on whether the channel state is reflected in the amount of resources to be used for retransmission.

In the case of the synchronous HARQ scheme, if the initial transmission fails, subsequent retransmission occurs at a timing determined by the system. For example, assuming that retransmission occurs every fourth time unit after the initial transmission fails, there is no need for the transmitter to inform the receiver of the timing of retransmission or for the receiver to inform the transmitter of the timing of retransmission because the timing is already determined between the transmitter and receiver. However, in the synchronous HARQ scheme, if the data transmitting side receives a NACK message, the data transmitting side retransmits a frame, for example, every fourth time unit, until receiving an ACK message. On the other hand, in the case of the asynchronous HARQ scheme, the timing of retransmission may be newly scheduled or provided through additional signaling (from the transmitter to the receiver or from the receiver to the transmitter). In the asynchronous HARQ scheme, the timing at which a previously failed frame is retransmitted varies depending on various factors such as channel states.

In the case of the channel-non-adaptive HARQ scheme, the frame modulation, the number of used RBs, adaptive modulation and coding (AMC), etc. for retransmission are determined to be the same as those determined for the initial transmission. In contrast, in the case of the channel-adaptive HARQ scheme, these parameters vary depending on the channel state. For example, in the channel-non-adaptive HARQ scheme, the transmitting side uses 6 RBs to transmit data during the initial transmission and also use 6 RBs for retransmission. On the other hand, in the channel-adaptive HARQ scheme, even if the transmitting side uses 6 RBs during the initial transmission, the transmitting side may use more or fewer RBs for retransmission based on the channel state.

According to the above classification, four different types of HARQ schemes may be used, but asynchronous and channel-adaptive HARQ schemes and synchronous and channel-non-adaptive HARQ schemes are commonly used. The asynchronous and channel-adaptive HARQ scheme may maximize retransmission efficiency by adaptively varying the retransmission timing and the amount of resources used based on the channel state. However, the asynchronous and channel-adaptive HARQ scheme may increase overhead, and thus, the asynchronous and channel-adaptive HARQ scheme is generally not considered for UL. On the other hand, the synchronous and channel-non-adaptive HARQ scheme has the advantage of minimal overhead because the timing and resource allocation for retransmission are predefined in the system. However, the synchronous and channel-non-adaptive HARQ scheme may when used in conditions with rapidly changing channel states. When the channel states change rapidly, the retransmission efficiency of the synchronous and channel-non-adaptive HARQ scheme may significantly degrade.

### <Increment Redundancy (IR) HARQ>

In the current 3GPP-based wireless systems, the polar code has only been used for channel coding for a transport channel or control information with a small number of bits, such as broadcast channels (BCH), DCI, and UCI, and thus there has been little need to apply HARQ to an information block to which polar coding is applied. However, as wireless communication technology develops and the required services become more diverse, it may be considered to apply polar code-based channel coding to a data channel (e.g., uplink shared channel (UL-SCH), downlink shared channel (DL-SCH), and sidelink shared channel (SL-SCH)). In the future, when polar code-based channel coding is applied to data, a method for supporting HARQ for an information block to which polar code-based channel coding is applied is required. Hereinafter, implementations of the present disclosure for supporting HARQ for a polar code are described.

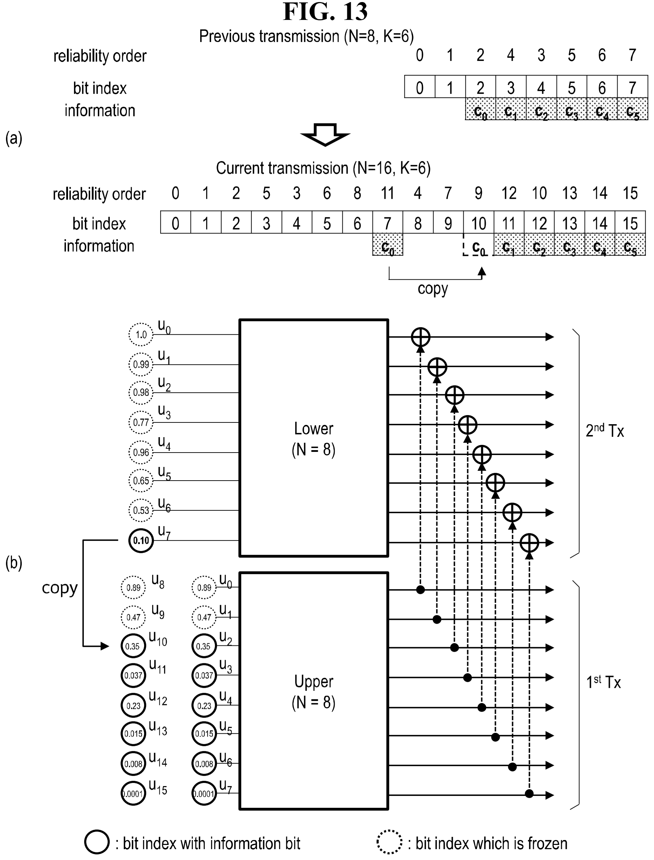

FIG. 13 illustrates examples of allocating information bits to a polar encoder according to some implementations of the present disclosure. In particular, FIG. 13 illustrates allocation of information bits for incremental redundancy (IR) to a polar encoding block, where the example of FIG. 13 assumes that a size of the data block (i.e., the size of the information block in polar encoding) K = 6, a mother code size N = 8 for initial transmission, and a mother code size N = 16 for retransmission. In the example of FIG. 13, reliability according to the Battacharyya parameter is assumed. In FIG. 13(a), it is assumed that a bit index with a larger reliability order value is a more reliable bit index. For example, a bit index with a reliability order value of 1 is assumed to be more reliable than a bit index with a reliability order value of 0. In FIG. 13(b), values in the input nodes are calculated Battacharyya parameters, and a smaller value indicates higher reliability.

To support incremental redundancy-based HARQ (hereinafter, IR HARQ) for a polar code, a transmitter may increase a mother code size when performing retransmission. For example, the transmitter may apply a mother code size N for initial transmission and a mother code size 2N for retransmission.

Referring to FIG. 13, in the case of the initial transmission, K = 6, and thus the transmitter performs polar encoding by placing bits $c_0, c_1, c_2, c_3, c_4$, and $c_5$ of the data block in the most reliable bit indices 2, 3, 4, 5, 6, and 7 from among bit channel indices 0 to 7 (i.e., bit indices before polar encoding) of a mother code size N = 8. If the receiver determines that there is an error after decoding initial transmission and requests retransmission, or if the transmitter intends to perform retransmission in a case in which there is an error in initial transmission, the transmitter performs polar encoding by placing bits $c_0, c_1, c_2, c_3, c_4$, and $c_5$ of the data block in six most reliable bit indices 7, 11, 12, 13, 14, and 15 from among bit indices 0 to 15 of the mother code size N = 16. However, to support the IR HARQ, the transmitter and the receiver need to satisfy the property that the coded bits generated in the initial transmission are provided in the coded bits generated in the retransmission. For example, referring to FIG. 13(a) and FIG. 13(b), in the current transmission, information bits $c_0, c_1, c_2, c_3, c_4$, and $c_5$ need to be placed in bit indices in which information bits $c_0, c_1, c_2, c_3, c_4$, and $c_5$ are placed in the previous transmission. When the mother code size increases from N to 2N, the polar encoded codeword may be represented as follows.

Equation 14

$$\begin{bmatrix} U_2 & U_1 \end{bmatrix} \begin{bmatrix} F & 0 \\ F & F \end{bmatrix} = \begin{bmatrix} (U_1 + U_2)F & U_1 F \end{bmatrix}$$

Here, F is Kernel for polar encoding of a mother code size N, and $[U_2\ U_1]$ is a data block. In this case, $U_1 F$ needs to be a codeword of initial transmission such that IR HARQ may be supported. Therefore, referring to FIG. 13, an operation in which data corresponding to bit index 7 is also allocated to a bit index 10 is required. That is, the same data bit needs to be placed in bit indices 7 and 10 and then encoded. Such a copy operation occurs if a mother code size increases for retransmission and a data block size is placed in bit indices of an upper polar encoder. That is, according to the example of FIG. 13, when N=16, an information bit is placed in bit index 7, which is the most reliable bit index from among the bit indices corresponding to a lower polar encoder when the data block size is greater than or equal to 5, and therefore the copy operation occurs. Hereinafter, polar subcodes of small bit indices are called lower polar subcodes, and the polar subcodes of large bit indices are called upper polar subcodes.

According to the current LTE or NR standards, DCI for a channel that carries DL data (e.g., PDSCH) or a channel that carries UL data (e.g., PUSCH) may be transmitted over a DL control channel (e.g., PDCCH), and sidelink control information (SCI) for a channel that carries sidelink data (e.g., physical sidelink shared channel (PSSCH)) may be transmitted over a sidelink control channel (e.g., physical sidelink control channel (PSCCH)). After detecting DCI for DL or UL data transmitted over a PDCCH, the UE may obtain the DL data or UL data by decoding a corresponding PDSCH or PUSCH. After detecting sidelink control information transmitted over a PSSCH, the UE may obtain sidelink data by decoding a corresponding PSSCH.

As described above, in the 5G NR standard, polar codes are used for control information (e.g., BCH, DCI, UCI, SCI, etc.). Since the size of control information (also referred to as control data) is predefined in the standard, and the time and/or frequency resources allocated to a PBCH/PDCCH, PUCCH/PUSCH, or PSCCH/PSSCH that carry the control information are defined, indicated, or configured, the length of coded bits obtained by encoding the control information is determined. Using the above information (i.e., the size of the control information, the size of the time/frequency resources, etc.), the mother code size for a polar encoder may be determined. For example, if it is assumed that the size of control data corresponding to DCI is K=40 and the size of coded bits transmitted based on time/frequency resources allocated to a PDCCH is E=120, referring to Table 7, since the code rate K/E = 1/3 < 7/16, the transmitter punctures 8 bits among the 128 bits of a codeword generated using a mother code size N=128, and perform transmission on the PDCCH. Accordingly, based on the size of the time/frequency resources, the size of the control data, or the code rate (the transmission code rate or the target code rate of a corresponding channel), the transmitter and the receiver may determine the mother code size to be applied to or already applied to the corresponding control data.

If polar codes are also applied to unicast data, higher-order modulation such as 16 quadrature amplitude modulation (QAM)/64QAM/256QAM, in addition to quadrature phase shift keying (QPSK), may be applied to coded bits obtained through the polar codes. In this case, in some implementations of the present specification, a data block size encoded with a polar code may be indicated to the transmitter or the receiver via a transport block size (TBS), which is the data block size of a PDSCH, PUSCH, or PSSCH according to 5G NR. For example, the TBS may be calculated from the value of a field related to the modulation and coding scheme (MCS) among fields in a DCI format or an SCI format and the value(s) of the field(s) related to time/frequency resource allocation. Accordingly, the mother code size of the polar encoder may be obtained from the information block size K determined from the TBS or from the code block size determined based on the TBS, and from the amount of transmitted bits E determined according to the time/frequency resources. However, errors may occur in the PDCCH/PSCCH during transmission. If an error occurs in the PDCCH/PSCCH that carries control information scheduling the PDSCH/PSSCH, the UE may not receive the PDSCH/PSSCH that is to be decoded based on the control information. If an error occurs in the PDCCH that carries control information scheduling the PUSCH, the UE may not properly transmit the PUSCH based on the corresponding control information. Therefore, a signaling method is needed to allow the UE to operate stably even if an error occurs in the PDCCH/PSSCH.

Hereinafter, some implementations of the present disclosure for signaling related data to which polar encoding is applied will be described. For convenience of description, some implementations of the present disclosure are mainly described by way of example in which polar encoding is applied to DL-SCH data carried by a PDSCH and control information related to the PDSCH is transmitted over a PDCCH. However, some implementations of the present disclosure may also be applied to a PUSCH and a PDCCH that carries a DCI format for the PUSCH, and/or a PSSCH and a PSSCH that carries an SCI format for the PSSCH.

For example, an error may occur in a PDCCH that carries control information corresponding to an initial transmission of a polar-encoded transport block. In this case, because the error occurs in the PDCCH, the UE may not receive the PDSCH that is to be decoded based on the corresponding control information. Accordingly, the UE may not transmit any signal at the time of transmitting a HARQ-ACK for the PDCCH. However, since the BS transmits the PDCCH, the BS attempts to detect the PUCCH or PUSCH carrying the HARQ-ACK of the UE. The detection of the HARQ-ACK depends on the BS implementation, but the BS may detect a HARQ-ACK where the UE performs discontinuous transmission (DTX) as a NACK. This may be inferred from the requirements on HARQ-ACK errors. From the perspective of a receiver that receives a HARQ-ACK, HARQ-ACK errors may be classified into two types: ACK-to-NACK errors and NACK-to-ACK errors. The ACK-to-NACK error is an error in which the receiver detects, as a NACK, a signal that is transmitted as an ACK by the transmitter for transmission of the HARQ-ACK, and the NACK-to-ACK error is an error in which the receiver detects, as an ACK, a signal that is transmitted as a NACK by the transmitter for transmission of the HARQ-ACK. In this case, from the perspective of the higher layer (e.g., MAC layer, RLC layer, PDCP layer), it becomes more important to reduce the probability of occurrence of the NACK-to-ACK error. When the ACK-to-NACK error occurs, the UE already successfully decodes a transport block, but due to the error, the BS may request retransmission for the transport block, which may degrade system throughput. However, when the NACK-to-ACK error occurs, the UE does not successfully decode a transport block, but due to the error, the BS determines that the transport block is successfully decoded at the UE and transmits a new transport block to the UE. That is, when the NACK-to-ACK error occurs, transport block loss may occur. The recovery of the corresponding transport block may be attempted through higher-layer retransmission, and as a result, system throughput is further degraded compared to the ACK-to-NACK error. For these reasons, it is common to set the requirement for NACK-to-ACK errors stronger than the requirement (requirement) for ACK-to-NACK errors. Accordingly, a HARQ-ACK where the UE performs DTX (i.e., HARQ-ACK that is not transmitted) is detected as a NACK at the BS, and the BS may perform retransmission for the corresponding transport block. In general, during retransmission, the TBS remains the same, but the time/frequency resources may change. In addition, the BS may adjust the time/frequency resources for the retransmission in consideration of the coded bits that the UE transmits in the initial transmission. For example, when IR HARQ is supported, since the receiver performs decoding by combining the coded bits of the initial transmission with the coded bits of the retransmission, the time/frequency resources may be configured such that the size of the coded bits transmitted in the retransmission is smaller than the size of the coded bits transmitted in the initial transmission. Nevertheless, the receiver that receives the transport block may obtain greater coding gain and improve error performance through combining. If the time/frequency resources are changed for the retransmission, there is a difference between the size (i.e., length) of the coded bits in the initial transmission and the size of the coded bits in the retransmission. If IR HARQ is supported, the mother code size for the retransmission may be configured by adding the size of the coded bits in the initial transmission and the size of the coded bits in the retransmission. In this case, since the mother code size used by the transmitter when generating the codeword and the mother code size used by the receiver may differ, errors may occur, and the retransmission may continue to be required. For example, if the UE misses a DCI format that schedules the initial transmission and the BS performs the retransmission by increasing the mother code size from N to 2N, since the UE missed the DCI format for the initial transmission, the UE may not know whether the mother code size for the retransmission increases compared to the initial transmission and/or whether a copy operation according to some implementations of the present disclosure is performed. Although a new data indicator (NDI) in the DCI format is capable of indicating whether the transmission scheduled by the DCI format is new transmission or retransmission, even if the transmission is retransmission, the mother code size may not be increased. In addition, even when the mother code size increases, if K is small, the copy operation may not be necessary. Accordingly, in some implementations of the present disclosure, to avoid a situation in which a difference arises between the mother code size used by the transmitter that transmits the transport block (i.e., the mother code size on the polar encoder side) and the mother code size used by the receiver that receives the transport block (i.e., the mother code size on the polar decoder side), the mother code size may be provided to the UE via DCI or SCI.

If the transmitter or the polar encoder places data and parity check (PC) bit(s) at bit index(es) through the copy operation during retransmission, IR HARQ robust to PDCCH/PSCCH errors needs to be designed. Since the copy operation is performed when the transmitter increases the mother code size and places data bits at the bit indexes corresponding to an upper polar subcode, cases in which the transmitter increases the mother code size increases during retransmission are considered in some implementations of the present disclosure

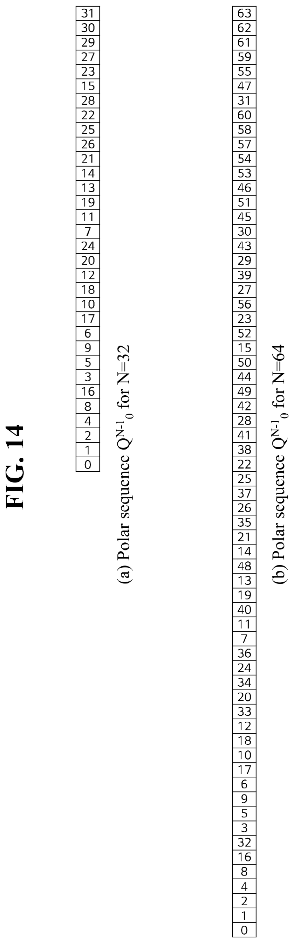

FIG. 14 illustrates bit indexes sorted in ascending order of reliability. In particular, FIG. 14 is based on polar sequences according to 3GPP TS 38.212 Rel-15 Table 5.3.1.2-1, where FIG. 14(a) illustrates a polar sequence with N=32, and FIG. 14(b) illustrates a polar sequence with N=64.

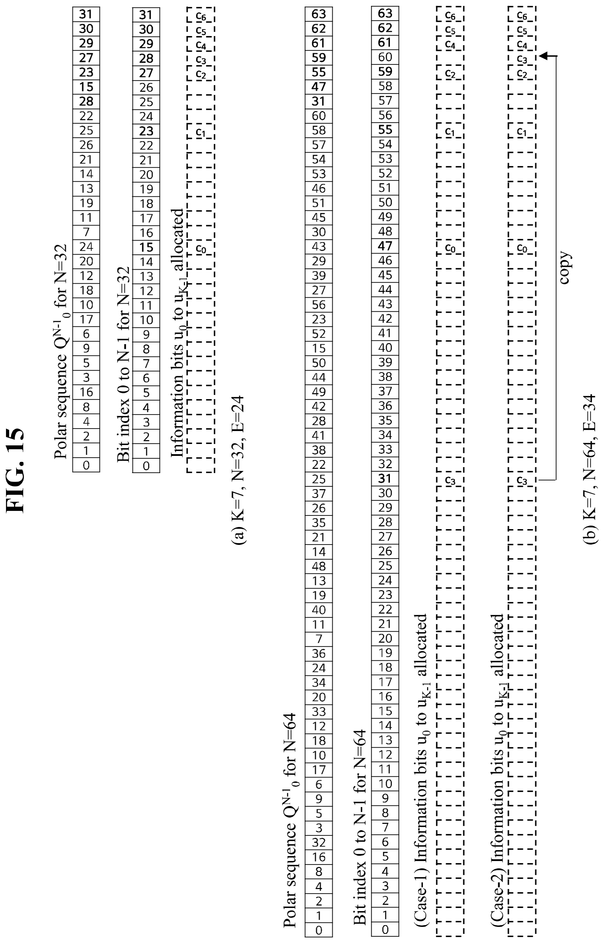

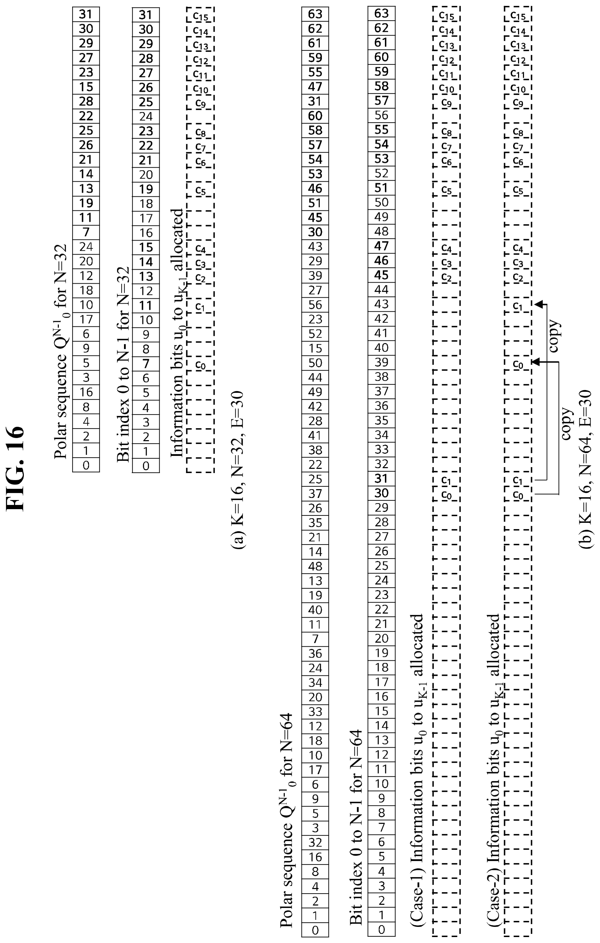

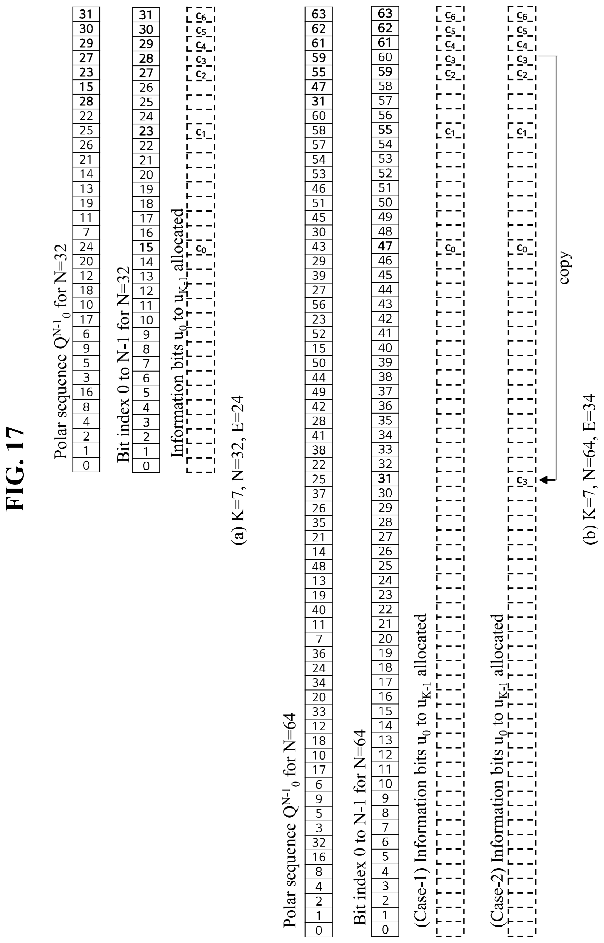

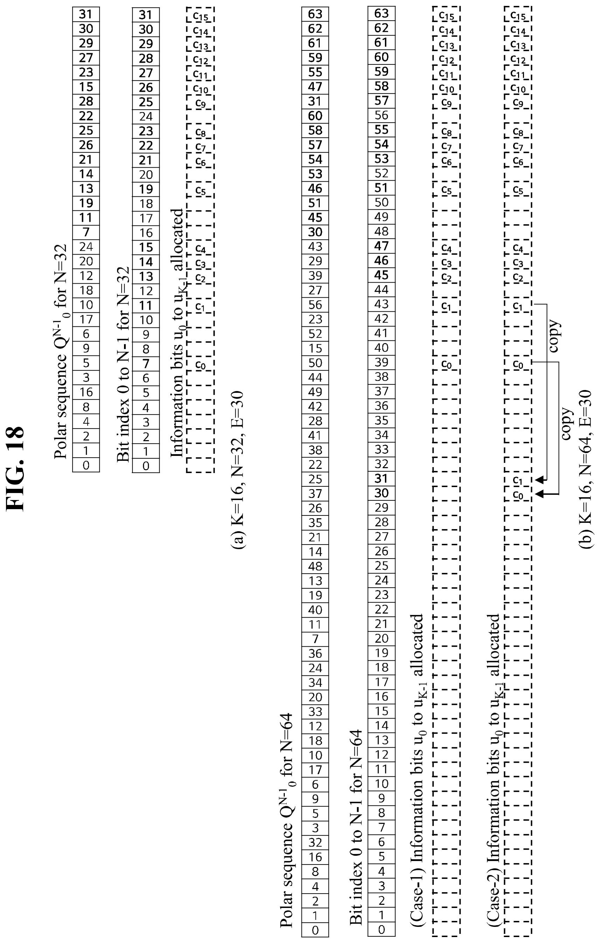

FIG. 15 to FIG. 18 illustrate examples of placing data bits at bit indexes of a polar code according to some implementations of the present disclosure. In FIG. 15 to FIG. 18, the polar sequences according to FIG. 14 are assumed. In the examples of FIG. 15 and FIG. 17, K = 7, N = 32 and E = 24 for the initial transmission, and N = 64 and E = 34 for the retransmission are assumed, while in the examples of FIG. 16 and FIG. 18, K = 16, N = 32 and E = 30 for the initial transmission, and N = 64 and E = 30 for the retransmission are assumed.

Referring to FIG. 15(a), the BS places data bits of initial transmission, i.e., information bits $c_0$ to $c_6$, in the seven most reliable bit indexes among bit indexes 0 to 31 of a polar encoder with N=32. The BS may perform the initial transmission to the UE based on the coded bits obtained through polar encoding of information bits $c_0$ to $c_6$. If the BS determines that the initial transmission is not properly decoded at the UE, or the BS determines that retransmission is required for the initial transmission, the BS may place information bits $c_0$ to $c_6$ at the bit indexes of a polar encoder with N=64, and perform the retransmission to the UE based on the coded bits obtained through polar encoding of information bits $c_0$ to $c_6$, as in Case-2 of FIG. 15(b). However, if the UE does not receive a PDSCH carrying the initial transmission due to a PDCCH error for the initial transmission, the UE assumes that the information bits are placed in the polar encoder as illustrated in Case-1 of FIG. 15(b) when decoding the coded bits received via a PDSCH carrying the retransmission. However, since the BS already performs the initial transmission, the BS increases the mother code size at the retransmission and places the information bits in the polar encoder as in Case-2. Thus, if the UE assumes the assignment of the information bits shown in Case-1of FIG. 15(b), the placement of the information bits at the bit indexes used by the BS and the UE becomes inconsistent. To avoid such an error, in some implementations of the present disclosure, information on whether the data bits (i.e., information bits) are placed at the bit indexes by the copy operation is provided to the receiving side of control information, via the control information (e.g., PDCCH, PSCCH) that schedules data transmission. For example, if the BS performs an operation of placing data bits at bit indexes through the copy operation, the UE may assume that the data bits placed at the bit indexes of a lower polar subcode are copied to be identically placed at the bit indexes of an upper polar subcode and then perform polar decoding. In this case, the copy operation may be performed for the most reliable bit index among the bit indexes of the lower polar subcode that are set as frozen bits, excluding a set of bit indexes corresponding to the data block size, i.e., information block size. For example, referring to FIG. 15(b), when performing the copy operation, the transmitter places information bits at bit indexes 63, 62, 61, 59, 55, 47, and 31, and performs the copy operation for bit index 60, which has the highest reliability in the lower polar subcode among the bit indexes other than 63, 62, 61, 59, 55, 47, and 31. In addition, the receiver may assume this operation and perform polar decoding.

Referring to FIG. 16(a), the BS places data bits of initial transmission, i.e., information bits $c_0$ to $c_{15}$, in the sixteen most reliable bit indexes among bit indexes 0 to 31 of a polar encoder with N=32. The BS may perform the initial transmission to the UE based on the coded bits obtained through polar encoding of information bits $c_0$ to $c_{15}$. If the BS determines that the initial transmission is not properly decoded at the UE, or the BS determines that retransmission is required for the initial transmission, the BS may place information bits $c_0$ to $c_{15}$ at the bit indexes of a polar encoder with N=64, and perform the retransmission to the UE based on the coded bits obtained through polar encoding of information bits $c_0$ to $c_{15}$, as in Case-2 of FIG. 16(b). However, if the UE does not receive a PDSCH carrying the initial transmission due to a PDCCH error for the initial transmission, the UE assumes that the information bits are placed in the polar encoder as illustrated in Case-1 of FIG. 16(b) when decoding the coded bits received via a PDSCH carrying the retransmission. However, since the BS already performs the initial transmission, the BS increases the mother code size at the retransmission and places the information bits in the polar encoder as in Case-2. If the assignment of the information bits shown in Case-1 of FIG. 16(b) is assumed, the placement of the information bits at the bit indexes used by the BS and the UE becomes inconsistent. To avoid such an error, in some implementations of the present disclosure, information on whether the data bits (i.e., information bits) are placed at the bit indexes by the copy operation is provided to the receiving side of control information, via the control information (e.g., PDCCH, PSCCH) that schedules data transmission. For example, if the BS performs an operation of placing data bits at bit indexes through the copy operation, the UE may assume that the data bits placed at the bit indexes of a lower polar subcode are copied to be identically placed at the bit indexes of an upper polar subcode and then perform polar decoding. In this case, the copy operation may be performed for the most reliable bit index among the bit indexes of the lower polar subcode that are set as frozen bits, excluding a set of bit indexes corresponding to the data block size, i.e., information block size. For example, referring to FIG. 16(b), when performing the copy operation, the transmitter places information bits at bit indexes 63, 62, 61, 59, 55, 47, 31, 60, 58, 57, 54, 53, 46, 51, 45, and 30. Since two information bits are placed at bit indexes 31 and 30 of the upper polar subcode, the transmitter may perform the copy operation for two bit indexes 43 and 39 with the highest reliability among the bit indexes frozen in the lower polar subcode, place the information bits at the bit indexes as in Case-2 of FIG. 16(b), and perform polar encoding. In addition, the receiver may assume that the information bits are placed at the bit indexes of the polar encoder as in Case-2 of FIG. 16(b) and perform polar decoding.

In the examples of FIG. 15 and FIG. 16, some implementations of the present disclosure have been described as performing the copy operation in which the transmitter copies information bit(s) placed at bit index(es) of an upper polar subcode to the most reliable frozen bit index(es) in a lower polar subcode. However, in some implementations of the present disclosure, when it is determined, indicated, or configured to increase the mother code size from N to 2N for retransmission and to perform the copy operation, the transmitter maps an information block of length K to a polar encoding block of size 2N such that a mapping pattern of the information block of length K to a polar encoding block of size N is preserved in the upper polar subcode of the polar encoding block of size 2N. The transmitter may perform the copy operation in such a way that, among the bit index(es) within the upper polar subcode of the polar encoding block of size 2N to which the bit(s) of the information block of length K are mapped, the information bit(s) of the bit index(es) that are not among the K most reliable bit indexes of the polar encoding block of size 2N are mapped to bit index(es) belonging to the lower polar subcode among the K most reliable bit indexes. In addition, the receiver may perform polar decoding based on this assumption. For example, referring to FIG. 17(b), when mapping an information block of length K = 7 to a polar encoding block of size N = 64, the transmitter that performs the copy operation for polar encoding for retransmission may map information bits $c_0$ to $c_6$ to the upper polar subcode such that the bit indexes of the upper polar subcode of the polar encoding block (i.e., bit indexes 32 to 63) include the information block mapping pattern to a polar encoding block of size N = 32 (see Case-1 of FIG. 17(b)). Since bit index 60, to which information bit $c_3$ is mapped, does not belong to the seven most reliable bit indexes 63, 62, 61, 59, 55, 47, and 31 among the bit indexes of the N = 64 polar code, information bit $c_3$ mapped to bit index 60 may be mapped to bit index 31, which belongs to the lower polar subcode and is one of the seven most reliable bit indexes (see Case-2 of FIG. 17(b)). As another example, referring to FIG. 18(b), when mapping an information block of length K = 16 to a polar encoding block of size N = 64, the transmitter that performs the copy operation for polar encoding for retransmission may map information bits $c_0$ to $c_{15}$ to the upper polar subcode such that the bit indexes of the upper polar subcode of the polar encoding block (i.e., bit indexes 32 to 63) include the information block mapping pattern to a polar encoding block of size N = 32 (see Case-1 of FIG. 18(b)). Since bit indexes 43 and 39, to which information bits $c_1$ and $c_0$ are mapped, do not belong to the sixteen most reliable bit indexes 63, 62, 61, 59, 55, 47, 31, 60, 58, 57, 54, 53, 46, 51, 45, and 30 among the bit indexes of the N = 64 polar code, information bits $c_1$ and $c_0$ mapped to bit indexes 43 and 39 may be mapped to bit indexes 31 and 30, which belong to the lower polar subcode and are among the sixteen most reliable bit indexes (see Case-2 of FIG. 18(b)).

In some implementations of the present disclosure, regardless of the order of mapping information bit(s) to bit index(es) and/or the copy target, an input bit sequence to a polar code of size 2N for retransmission, $\mathbf{u} = [u_0, u_1, u_2, ..., u_{2N-1}]$, may be generated such that (i) an upper sub-bit sequence $\mathbf{u}\_upper = [u_N, u_{N+1}, u_{N+2}, ..., u_{2N-1}]$ of the input bit sequence $\mathbf{u} = [u_0, u_1, u_2, ..., u_{2N-1}]$ is the same as an input bit sequence $u = [u_0, u_1, u_2, ..., u_{N-1}]$ to a polar code of size N for initial transmission, and (ii) in a lower sub-bit sequence $\mathbf{u}\_lower = [u_0, u_1, u_2, ..., u_{N-1}]$, for n = 0 to N-1, $u_n$ satisfying $n \in \overline{\mathbf{Q}}_I^N$ is generated to carry information bits. The transmitter may perform encoding based on $\mathbf{d} = \mathbf{u}\mathbf{G}_n$ to obtain a coded bit sequence $\mathbf{d} = [d_0, d_1, d_2, ..., d_{2N-1}]$. The coded bit sequence is transmitted to other communication device(s) over a physical channel after rate matching, modulation, and the like. Upon receiving the coded bit sequence over the physical channel, the receiver may perform polar decoding by assuming that the information block is mapped to the polar encoding block according to some implementations of the present disclosure.

**<Determination of mother code size>**

In some implementations, the mother code size of initial transmission may be determined in the same manner as in the 5G NR standard described above. Hereinafter, some implementations of the present disclosure regarding a method of determining the mother code size when performing retransmission will be described. Hereinafter, the information size (i.e., the size of the information block to the polar encoding block) is denoted by K, the rate-matching output size of the i-th transmission is denoted by $E_i$, the mother code size of the initial transmission is denoted by N, and the maximum mother code size is denoted by Nmax.

> If the copy operation described in FIG. 13 and FIG. 15 to FIG. 18 does not occur, the transmitter does not increase the mother code size and performs encoding using the mother code size of the initial transmission. For example, if no copy operation is performed when the transmitter increases the mother code size from N to $2^n$*N, the transmitter may perform polar encoding by keeping the mother code size N without increasing the mother code size to $2^n$*N. In addition, the receiver may perform decoding by assuming the above operation.

>> In some implementations, since the reliability order of the bit indexes is fixed according to N, if K is greater than or equal to a certain value, it is possible to know whether the copy operation is to be performed when the mother code size increases. Thus, depending on N and K, whether to perform the copy operation or to increase the mother code size may be predefined or preconfigured (in the form of a table).

>> In some implementations, even if the copy operation occurs, if a parameter capable of being inferred from the initial transmission is less than or equal to or greater than or equal to a certain value, the transmitter does not increase the mother code size, and performs encoding using the mother code size of the initial transmission. The receiver performs decoding by assuming this operation. In some implementations, for example, the code rate $K/E_1$ may be used as the parameter capable of being inferred from the initial transmission.

> If the copy operation described in FIG. 13 and FIG. 15 to FIG. 18 occurs, the transmitter may perform encoding by increasing the mother code size. The receiver may perform decoding by assuming this operation.

>> When the copy operation occurs, if a parameter capable of being inferred from the initial transmission is less than or equal to or greater than or equal to a certain value, the transmitter increases the mother code size and performs encoding for the retransmission using the increased mother code size. The receiver performs decoding by assuming this operation. In some implementations, for example, the code rate $K/E_1$ may be used as the parameter capable of being inferred from the initial transmission.

>> Method 1: The mother code size increases up to min(2N, Nmax).

>>> The transmitter performs encoding by increasing the mother code size for the retransmission. If additional retransmission is required, the transmitter performs encoding using the mother code size corresponding to min(2N, Nmax). The receiver performs decoding of received coded bits on the assumption of this encoding operation.

>> Method 2: The mother code size increases up to min(4N, Nmax).

>>> Method 2-1: The transmitter performs encoding by increasing the mother code size to min(2N, Nmax) for the retransmission. If additional retransmission is required, the transmitter performs encoding using the mother code size corresponding to min(4N, Nmax). Also, if further retransmission is required, the transmitter performs encoding using the mother code size corresponding to min(4N, Nmax) without further increasing the mother code size. The receiver performs decoding of received coded bits on the assumption of this encoding operation.

>>> Method 2-2: The transmitter performs encoding by increasing the mother code size to min(4N, Nmax) for the retransmission. If additional retransmission is required, the transmitter performs encoding using the mother code size corresponding to min(4N, Nmax) without further increasing the mother code size. The receiver performs decoding of received coded bits on the assumption of this encoding operation.

>>> Method 2-3: The transmitter performs encoding by increasing the mother code size up to min(4N, Nmax) for the retransmission, but the transmitter performs encoding by selecting min(2N, Nmax) or min(4N, Nmax) according to a specific condition. In some implementations, the code rate $K/E_1$ of the initial transmission may be used as the specific condition. For example, if the code rate of the initial transmission is less than or equal to a specific value, the transmitter may perform encoding using the mother code size corresponding to min(2N, Nmax) for the retransmission. If the code rate of the initial transmission is greater than or equal to the specific value, the transmitter may perform encoding by increasing the mother code size up to min(4N, Nmax) for the retransmission. In this case, Method 2-1 or Method 2-2 may be used to increase the mother code size up to min(4N, Nmax). In some implementations, the effective code rate $\left(\text{e.g., } \frac{K}{\sum_{j=1}^{i} E_j}\right)$ up to the current transmission (e.g., i-th transmission) may be used as the specific condition. For example, if the effective code rate up to the current transmission is less than or equal to a specific value, the transmitter performs encoding using the mother code size of the previous transmission, without increasing the mother code size. If the effective code is greater than or equal to the specific value, the transmitter may perform encoding by increasing the mother code size. The receiver performs decoding of received coded bits on the assumption of the encoding operation according to Method 2-3.

**<Indication of mother code size>**

As described above, if an error occurs in the reception of a DL control channel, ambiguity regarding the mother code size may arise between the BS and the UE, or if an error occurs in the reception of a sidelink control channel, ambiguity regarding the mother code size may arise between the transmitting UE and the receiving UE. Accordingly, errors in DL or UL data transmission/reception or sidelink data transmission/reception may be caused, and as a result, system performance may be degraded. Therefore, to operate robustly against such error cases, it may be necessary for the mother code size to be indicated or provided to the UE. To indicate the mother code size, the following method(s) may be used in some implementations of the present disclosure. Information on the mother code size may be provided to the UE according to the following method(s). For example, the mother code size for a transport block carried by a PDSCH may be provided to the UE via a DCI format that schedules the PDSCH, the mother code size for a transport block carried by a PUSCH may be provided via a DCI format that schedules the PUSCH, or the mother code size for a transport block carried by a PSSCH may be provided via an SCI format that schedules the PSSCH.

> Method 1: The mother code size may be directly indicated to the UE. If a set of possible mother code sizes is denoted by $N_{mother}$, in some implementations, $ceil(log_2(n(N_{mother})))$ bit(s) may be used to indicate the mother code size to the UE, where $ceil(\cdot)$ denotes the ceiling operation and $n(\cdot)$ denotes the number of elements in a set. For example, if $N_{mother}$ = {32, 64, 128, 256, 512, 1024, 2048, 4096, 8192}, then $ceil(log_2(9))$ = 4. Thus, the mother code size may be indicated to the UE using 4 bits.

> Method 2: Whether the mother code size of the retransmission increases relative to the mother code size of the initial transmission may be indicated to the UE. In some implementations of the present disclosure, the mother code size of the initial transmission may be determined using the method specified in the 5G NR standard described above.

>> Method 2-1: When the mother code size increases up to $min(2N, Nmax)$, the mother code size may be provided to the UE using 1-bit information (e.g., copy flag). For example, the BS or the transmitting UE may set the copy flag and provide the copy flag to the UE as follows.

>>> For the initial transmission, the transmission flag is set to 0 and transmitted.
>>> If the mother code size does not increase for the retransmission, the copy flag is set to 0. If the mother code size increases to 2N, the copy flag is set to 1 and indicated.
>>> When the mother code size at the initial transmission is Nmax, since the mother code size does not increase at the retransmission, the copy flag is set to 0 and indicated.

>> Method 2-2: When the mother code size increases up to $min(4N, Nmax)$, the mother code size may be notified to the UE using 1-bit information (e.g., copy flag). For example, the BS or the transmitting UE may set the copy flag and provide the copy flag to the UE as follows.

>>> During the initial transmission, the copy flag is set to 0 and transmitted.
>>> If the mother code size does not increase for the retransmission, the copy flag is set to 0. If the mother code size increases to 4N, the copy flag is set to 1 and indicated.
>>> When the mother code size at the initial transmission is Nmax, since the mother code size does not increase at the retransmission, the copy flag is set to 0 and indicated.
>>> For the retransmission, if $2N \leq Nmax < 4N$, the copy flag is set to 1, and encoding is performed by increasing the mother code size to 2N.

>> Method 2-3: When the mother code size increases to $min(2N, Nmax)$ or $min(4N, Nmax)$, the mother code size may be provided to the UE using 2-bit information (e.g., copy flag 0, copy flag 1). For example, the BS or the transmitting UE may set copy flag 0 and copy flag 1 and indicate the copy flags to the UE as follows.

>>> For the initial transmission, copy flag 0 and copy flag 1 are set to 0 and indicated.

>>>> Alternatively, in some implementations, for the initial transmission, copy flag 1 may be used for another indication.

>>> For the retransmission, copy flag 0 is set to 1 to indicate an increase in the mother code size. If the mother code size increases to 2N, copy flag 1 is set to 0. If the mother code size increases to 4N, copy flag 1 is set to 1 and indicated.

>>> When the mother code size at the initial transmission is Nmax, since the mother code size does not increase at the retransmission, copy flag 0 and copy flag 1 are set to 0 and indicated during the retransmission.

>> Method 2-4: When the mother code size increases to min(2N, Nmax) or min(4N, Nmax), the mother code size may be provided to the UE using 1-bit information (e.g., copy flag) and a specific parameter (e.g., the code rate of the initial transmission). For example, the BS or the transmitting UE may set the copy flag and provide the copy flag to the UE as follows.

>>> During the initial transmission, the copy flag is set to 0 and transmitted.

>>> If the mother code size does not increase at the retransmission, the copy flag is set to 0 and indicated. If the mother code size increases, the copy flag is set to 1. If the value of a specific parameter (e.g., the code rate up to immediately before the corresponding transmission) is less than or equal to a specific value, the mother code size increases to min(2N, Nmax). If the value of the specific parameter is greater than or equal to the specific value, the mother code size increases to min(4N, Nmax), and encoding is performed.

>>> When the mother code size at the initial transmission is Nmax, since the mother code size does not increase at the retransmission, the copy flag is set to 0 and indicated.

>>> For the retransmission, if 2N ≤ Nmax < 4N, the copy flag is set to 1, and encoding is performed by increasing the mother code size to 2N, regardless of the value of the specific parameter.

>> Method 2-5: When the mother code size increases to min(2N, Nmax) or min(4N, Nmax), the mother code size may be provided to the UE using 1-bit information (e.g., copy flag) and a specific parameter (e.g., the effective code rate (e.g., $\frac{K}{\sum_{j=1}^{i} E_j}$) up to the current transmission (e.g., i-th transmission)). For example, the BS or the transmitting UE may set the copy flag and provide the copy flag to the UE as follows.

>>> During the initial transmission, the copy flag is set to 0 and transmitted.

>>> For the retransmission, if the mother code size used in the previous transmission does not increase, the copy flag is set to 0 and indicated. If the mother code size increases, the copy flag is set to 1. If the value of the effective code rate (e.g., $\frac{K}{\sum_{j=1}^{i} E_j}$) up to the current transmission (e.g., i-th transmission) is greater than or equal to a specific value, encoding is performed by increasing the mother code size to twice the mother code size of the previous transmission.

>>> When the mother code size at the initial transmission or retransmission is Nmax, since the mother code size does not increase at the retransmission, the copy flag is set to 0 and indicated.

>>> For the retransmission, if 2N ≤ Nmax < 4N, the copy flag is set to 1, and encoding is performed by increasing the mother code size to 2N, regardless of the value of the specific parameter.

>> Method 2-6: When the mother code size increases to min(2N, Nmax) or min(4N, Nmax), the mother code size may be provided to the UE using 1-bit information (e.g., copy flag) and additional 2-bit information (e.g., multiplication factor). For example, the BS or the transmitting UE may set the copy flag and the multiplication factor and provide the copy flag and the multiplication factor to the UE as follows.

>>> During the initial transmission, the copy flag is set to 0 and transmitted.

>>> For the retransmission, if the mother code size of the initial transmission does not increase (e.g., $\sum_{j=1}^{i} E_j < N$)), the copy flag is set to 0 and indicated. If the mother code size increases, the copy flag is set to 1. An appropriate 2-bit multiplication factor (e.g., 1, 2, 4, 8) is set and indicated according to the rate-matching output size $E_j$ of the j-th transmission, the information size K, and the increased mother code size min(2N, Nmax) or min(4N, Nmax).

>>>> During the retransmission (i.e., j>1), if the mother code size increases for ($E_j$, K), the mother code size may be determined as specified in the NR standard. Hereinafter, this is referred to as the intermediate mother code size.

>>>>> For the mother code size N of the initial transmission, the total rate-matching output size up to the (j-1)-th transmission, $\sum_{i=1}^{j-1} E_i$ has a range of $E_{1,min} \leq \sum_{i=1}^{j-1} E_i \leq E_{1,max}$. Here, $E_{1,min}$ = N/2 + x, where 0 < x < N/2, and $E_{1,max}$ = N + y, where 0 < y < N/2.

>>>>> Since the code rate of ($E_j$, K) needs to be less than 1, $E_j$ > K.

>>>>> Since the mother code size increases at the j-th transmission, $\sum_{i=1}^{j} E_i > N$.

>>>>>> From $E_j + \sum_{i=1}^{j-1} E_i > N$, the relationship $E_j$ > N - $E_{1,min}$ = N - N/2 - x = 2/N - x may be obtained.

>>>>>> Since the mother code size increases to min(2N, Nmax) or min(4N, Nmax) at the j-th transmission, $E_j + \sum_{i=1}^{j-1} E_i < min(2N, Nmax) + z$ or $E_j + \sum_{i=1}^{j-1} E_i < min(4N, Nmax) + z$. If the increased mother code size is denoted as N', the relationship N' + z - $E_{1,max}$ < $E_j$ < N' + z - $E_{1,min}$ is satisfied, which may be expressed as N' + z - N - y < $E_j$ < N' + z - N/2 - x.

>>>>>>> When N' = min(2N, Nmax) = 2N, N + z - y < $E_j$ < 3N/2 + z - x. Accordingly, combining with the relationship $E_j$ > N/2 - x, the relationship min(N + z - y, N/2 - x) < $E_j$ < 3N/2 + z + x is satisfied. In this case, the possible mother code sizes may be N/2, N, and 2N.

>>>>>>> When N' = min(4N, Nmax) = 4N, 3N + z - y < $E_j$ < 7N/2 + z - x. Accordingly, combining with the relationship Ej > N/2 - x, the relationship min(3N + z - y, N/2 - x) < $E_j$ < 7N/2 + z - x is satisfied. In this case, the possible mother code sizes may be N/2, N, 2N, and 4N.

>>>>> After obtaining the possible mother code sizes from the j-th rate-matching output size, a multiplication factor is selected to indicate the increased mother code size. For example, if the mother code size of the initial transmission is N, encoding is performed at the j-th transmission using the increased mother code size 2N. If the mother code size N is obtained from the rate-matching output size at the j-th transmission, the multiplication factor 2 may be selected to indicate the mother code size 2N.

The following table shows examples of the mother code sizes for retransmission depending on the mother code size of initial transmission, the rate-matching output size, and the information size. In particular, the table presents examples of retransmission mother code sizes determined according to Method 2-6. In the table, N1 is the mother code size for the initial transmission based on (E1, K), K is the information size, E1 is the rate-matching output size of the initial transmission, E2 is the rate-matching output size of the retransmission, N2 is the mother code size for the retransmission based on (E2, K), and N' is the actual mother code size used for encoding in the retransmission.

Table 10

| N1 | K | E1 | codeword (1st tx, (E1,K)) | E2 | codeword (all, (N', K)) | codeword (2nd tx, (E2, K)) | N2 | Copy flag | Multiplication factor | N' |
|---|---|---|---|---|---|---|---|---|---|---|
| 32 | 5 | 20 | (20, 5) | 10 | (32, 5) | (10, 5) | 16 | 0 | 2 | 32 |
| 32 | 5 | 20 | (20, 5) | 20 | (64, 5) | (20, 5) | 32 | 1 | 2 | 64 |
| 32 | 6 | 24 | (24, 6) | 16 | (64, 6) | (16, 6) | 16 | 1 | 4 | 64 |
| 32 | 6 | 30 | (30, 6) | 50 | (128, 6) | (50, 6) | 64 | 1 | 2 | 128 |
| 32 | 8 | 30 | (30, 8) | 32 | (64, 8) | (32, 8) | 32 | 1 | 2 | 64 |
| 32 | 10 | 30 | (30, 10) | 34 | (64, 10) | (34, 10) | 32 | 1 | 2 | 64 |
| 32 | 10 | 18 | (18, 10) | 16 | (128, 10) | (16, 10) | 16 | 1 | 8 | 128 |
| 32 | 10 | 30 | (30, 10) | 50 | (128, 10) | (50, 10) | 64 | 1 | 2 | 128 |
| 32 | 12 | 30 | (30, 12) | 36 | (64, 10) | (36, 10) | 64 | 1 | 1 | 64 |
| 32 | 16 | 30 | (30, 16) | 30 | (64, 16) | (30, 16) | 32 | 1 | 2 | 64 |
| 32 | 20 | 30 | (30, 20) | 50 | (128, 20) | (50, 20) | 64 | 1 | 2 | 128 |

(continued)

| N1 | K | E1 | codeword (1st tx, (E1,K)) | E2 | codeword (all, (N', K)) | codeword (2nd tx, (E2, K)) | N2 | Copy flag | Multiplication factor | N' |
|----|----|----|------|----|------|------|----|------|------|----|
| 32 | 24 | 30 | (30, 24) | 32 | (64, 24) | (32, 20) | 32 | 1 | 2 | 64 |
| 32 | 24 | 30 | (30, 24) | 36 | (64, 24) | (34, 20) | 64 | 1 | 1 | 64 |

Referring to Table 10 and Method 2-6, when transmitting a control channel, a communication device encodes data at the second transmission with codeword(all, (N', K)) and transmits codeword(2nd tx, (E2, K)) to another communication device. For example, in Table 10, referring to the row where N1 = 32, K = 5, E1 = 20, codeword(1st tx, (E1, K)) = (20, 5), E2 = 20, codeword(all, (N', K)) = (64, 5), codeword(2nd tx, (E2, K)) = (20, 5), N2 = 32, Copy flag = 1, Multiplication factor = 2, and N' = 64, the transmitter encodes an information block of length K = 5 using the polar code of size N = 64, which is twice N2 determined by (E2, K) at the second transmission, and transmits only 20 bits among the bits of an encoded bit sequence of length 64. In some implementations of the present disclosure, K may be obtained based on a TBS provided to the UE via control information, and E may be obtained based on a time/frequency resource allocation and an MCS provided to the UE via control information. The TBS may be calculated based on the MCS and the resource allocation.

When the BS or the transmitting UE schedules initial transmission for a certain HARQ process, the BS or the transmitting UE includes a value obtained by toggling a previous NDI value for the HARQ process in an NDI field within a control information format carried by a PDCCH/PSCCH, and transmits the control information format. If a UE misses the PDCCH/PSCCH of the initial transmission, the BS or the transmitting UE may transmit a retransmission PDCCH/PSCCH to the UE that includes an NDI value identical to the NDI value included in the PDCCH/PSCCH of the initial transmission, i.e., a non-toggled NDI value. Upon receiving the retransmission PDCCH/PSCCH, since the NDI for the HARQ process is toggled relative to the previous value, the UE may misinterpret the retransmission PDCCH/PSCCH as the PDCCH/PSCCH of the initial transmission. Therefore, it is necessary to indicate to the UE whether the current PDCCH/PSCCH is for retransmission of a transport block. According to some implementations of the present disclosure, even if the initial PDCCH/PSCCH is lost, the copy flag included in the current PDCCH/PSCCH may serve to indicate that, before the transmission of the transport block scheduled by the current PDCCH/PSCCH, there has been previous transmission of the same transport block.

In the case of conventional polar codes, the mother code size is determined according to the information block size K and the rate-matching output size E. In addition, since retransmission is not performed for BCH, DCI, UCI, and SCI to which the polar codes are applied, there is no need to provide the mother code size to the UE. For channel codes other than polar codes, channel coding is performed according to the minimum code rate, and a portion of a coded bit sequence is appropriately selected and transmitted to the receiver. However, when polar codes are applied to a transport block carried by a PUSCH, PDSCH, or PSSCH, it is necessary to allow a mother code size different from the mother code size determined by K and E. According to some implementations of the present disclosure, polar encoding/decoding based on the mother code size different from the mother code size determined by K and E becomes possible. Meanwhile, for polar codes, an increase in the mother code size does not necessarily mean an increase in redundancy, and an increase in the mother code size means an increase in decoding complexity. According to some implementations of the present disclosure, by starting from an appropriate mother code size and increasing the mother code size, coding gain may be increased while minimizing decoding complexity.

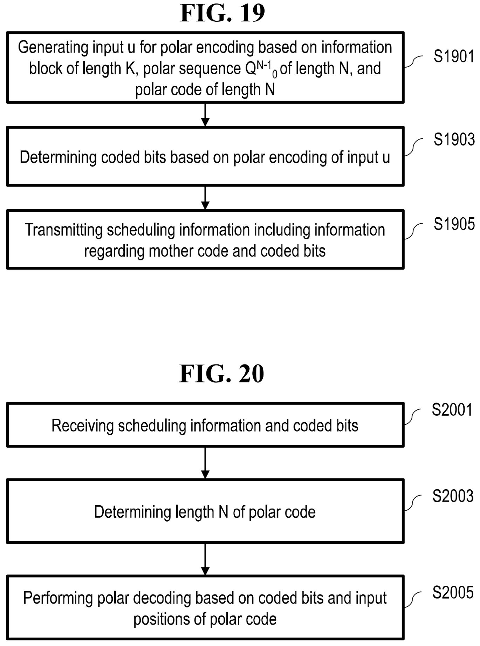

FIG. 19 illustrates a channel encoding process according to some implementations of the present disclosure.

A communication device or encoder may perform operations related to channel encoding according to some implementations of the present disclosure. The communication device may include: at least one transceiver; at least one processor; and at least one computer memory operably connected to the at least one processor and storing instructions that, when executed, cause the at least one processor to perform operations according to some implementations of the present disclosure. A processing device for the communication device or encoder may include: at least one processor; and at least one computer memory operably connected to the at least one processor and storing instructions that, when executed, cause the at least one processor to perform the operations according to some implementations of the present disclosure. A computer-readable (non-volatile) storage medium may store at least one computer program including instructions that, when executed by at least one processor, cause the at least one processor to perform the operations according to some implementations of the present disclosure. A computer program or computer program product may include instructions that are recorded in at least one computer-readable (non-volatile) storage medium and cause, when executed, (at least one processor) to perform the operations according to some implementations of the present disclosure. Referring to FIG. 19, in the communication device, encoder, processing device, computer-readable (non-transitory) storage medium, and/or computer program product, the operations may include: determining a length N of a polar code for encoding an information block; generating an input bit sequence u of length N based on a polar sequence of length N, $\mathbf{Q}^{N-1}_0$

= $\{Q_0, Q_1, ..., Q_{N-1}\}$, and a length K of the information block (S1901); generating coded bits based on polar encoding of the input bit sequence u of length N (S 1903); and transmitting scheduling information for transmission of the information block and the coded bits based on the scheduling information (S 1905). The polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for i = 0, 1, ..., N - 1, and $W(Q^N_i)$ denotes a reliability of a bit index $Q^N_i$. The scheduling information may include resource allocation information, information on an information length, and information on a mother code size, and N may be related to the information regarding the mother code size.

In some implementations, generating the input bit sequence u of length N may include, based on the transmission of the information block being initial transmission, placing bits $c_0$ to $c_{K-1}$ of the information block in K most reliable bit indexes among N bit indexes of the polar code to generating the input bit sequence u = $[u_0, u_1, u_2, ..., u_{N-1}]$ of length N.

In some implementations, generating the input bit sequence u of length N may include, based on the transmission of the information block being retransmission, placing bits $c_0$ to $c_{K-1}$ of the information block in K most reliable bit indexes among N bit indexes of the polar code of length N and placing at least one of the bits $c_0$ to $c_{K-1}$ of the information block at a bit index other than the K most reliable bit indexes to generate the input bit sequence u = $[u_0, u_1, u_2, ..., u_{N-1}]$ of length N.

In some implementations, generating the input bit sequence u of length N may include, based on the transmission of the information block being retransmission and on N = $2^n$*N1, generating the input bit sequence u = $[u_0, u_1, u_2, ..., u_{N-1}]$ of length N such that an upper portion $[u_{N-N1}, u_{N-N1+1}, u_{N-N1+2}, ..., u_{N-1}]$ of the input bit sequence of length N is identical to an input bit sequence $[u_0, u_1, u_2, ..., u_{N1-1}]$ to a polar code of length N1, and such that, a bit index belonging to the K most reliable bit indexes in a lower portion $[u_0, u_1, u_2, ..., u_{N-N1-1}]$ of the input bit sequence of length N includes an information bit placed at a bit index among bit indexes of the upper portion that does not belong to the K most reliable bit indexes. Here, N1 is the length of the polar code for the initial transmission of the information block, and n ≥ 0.

In some implementations, the information regarding the mother code size may include information regarding a multiplication factor. N may be related to a length $N_{int}$ which is based on the resource allocation information and the information regarding the information length, and to the information regarding the multiplication factor regarding how many times N is of $N_{int}$.

In some implementations, the scheduling information may further include copy-related information regarding whether N is greater than a length of a polar code for initial transmission of the information block.

In some implementations, the copy-related information may have a first value when the transmission of the information block is the initial transmission, and the copy-related information may have a second value when the transmission of the information block is retransmission.

FIG. 20 illustrates a channel decoding process according to some implementations of the present disclosure.

A communication device or decoder may perform operations related to channel decoding according to some implementations of the present disclosure. The communication device may include: at least one transceiver; at least one processor; and at least one computer memory operably connected to the at least one processor and storing instructions that, when executed, cause the at least one processor to perform operations according to some implementations of the present disclosure. A processing device for the communication device or decoder may include: at least one processor; and at least one computer memory operably connected to the at least one processor and storing instructions that, when executed, cause the at least one processor to perform the operations according to some implementations of the present disclosure. A computer-readable (non-volatile) storage medium may store at least one computer program including instructions that, when executed by at least one processor, cause the at least one processor to perform the operations according to some implementations of the present disclosure. A computer program or computer program product may include instructions that are recorded in at least one computer-readable (non-volatile) storage medium and cause, when executed, (at least one processor) to perform the operations according to some implementations of the present disclosure. Referring to FIG. 20, in the communication device, decoder, processing device, computer-readable (non-transitory) storage medium, and/or computer program product, the operations may include: receiving scheduling information regarding transmission of the information block (S2001); receiving a coded information block based on the scheduling information (S2001); determining a length N of a polar code based on the scheduling information (S2003); performing polar decoding for the coded information block based on a polar sequence of length N, $Q^{N-1}_0 = \{Q_0, Q_1, ..., Q_{N-1}\}$, a length K of the information block, and a mapping relationship of information bits of the information block to bit indexes of the polar code of length N (S2005); and determining the information block based on the polar decoding. The polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for i = 0, 1, ..., N - 1, and $W(Q^N_i)$ denotes a reliability of a bit index $Q^N_i$. The scheduling information may include resource allocation information, information regarding an information length, and information regarding a mother code size, and N may be related to the information regarding the mother code size.

In some implementations, the mapping relationship of the information bits of the information block to the bit indexes of the polar code of length N may include the following: based on the transmission of the information block being initial transmission, an input bit sequence u = $[u_0, u_1, u_2, ..., u_{N-1}]$ of length N to the polar code of length N includes bits $c_0$ to $c_{K-1}$ of the information block in K most reliable bit indexes among N bit indexes of the polar code.

In some implementations, the mapping relationship of the information bits of the information block to the bit indexes of the polar code of length N may include the following: based on the transmission of the information block being retransmission, an input bit sequence $u = [u_0, u_1, u_2, ..., u_{N-1}]$ to the polar code of length N includes bits $c_0$ to $c_{K-1}$ of the information block at positions of K most reliable bit indexes among N bit indexes of the polar code of length N and includes at least one of the bits $c_0$ to $c_{K-1}$ of the information block at a position of a bit index other than the K most reliable bit indexes.

In some implementations, the mapping relationship of the information bits of the information block to the bit indexes of the polar code of length N may include the following: based on the transmission of the information block being retransmission and on $N = 2^n*N1$, the upper portion $[u_{N-N1}, u_{N-N1+1}, u_{N-N1+2}, ..., u_{N-1}]$ of the input bit sequence $u = [u_0, u_1, u_2, ..., u_{N-1}]$ of length N includes the bits $c_0$ to $c_{K-1}$ of the information block at positions identical to positions of an input bit sequence $[u_0, u_1, u_2, ..., u_{N1-1}]$ to a polar code of length N1, and a bit index belonging to the K most reliable bit indexes in a lower portion $[u_0, u_1, u_2, ..., u_{N-N1-1}]$ of the input bit sequence of length N includes an information bit identical to an information bit placed at a bit index among bit indexes of the upper portion that does not belong to the K most reliable bit indexes. N1 is a length of a polar code for initial transmission of the information block, and $n \geq 0$.

In some implementations, the information regarding the mother code size may include information regarding a multiplication factor, and N may be related to a length $N_{int}$ which is based on the resource allocation information and the information regarding the information length, and to the information regarding the multiplication factor regarding how many times N is of $N_{int}$.

In some implementations, the scheduling information may further include copy-related information regarding whether N is greater than a length of a polar code for initial transmission of the information block.

In some implementations, the copy-related information may have a first value when the transmission of the information block is the initial transmission, and the copy-related information may have a second value when the transmission of the information block is retransmission.

The examples of the present disclosure as described above have been presented to enable any person of ordinary skill in the art to implement and practice the present disclosure. Although the present disclosure has been described with reference to the examples, those skilled in the art may make various modifications and variations in the example of the present disclosure. Thus, the present disclosure is not intended to be limited to the examples set for the herein, but is to be accorded the broadest scope consistent with the principles and features disclosed herein.

The implementations of the present disclosure may be used in a BS, a UE, or other equipment in a wireless communication system.

**Claims**

1. A method of transmitting an information block by a communication device in a wireless communication system, the method comprising:

    determining a length N of a polar code for encoding the information block;
    transmitting scheduling information for transmission of the information block;
    generating an input bit sequence u of length N based on a polar sequence of length N, $Q^{N-1}_0 = \{Q_0, Q_1, ..., Q_{N-1}\}$, and a length K of the information block;
    generating coded bits based on polar encoding of the input bit sequence u of length N; and
    transmitting the coded bits based on the scheduling information,
    wherein the polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for $i = 0, 1, ..., N - 1$, and $W(Q^N_i)$ denotes a reliability of a bit index $Q^N_i$,
    wherein the scheduling information comprises resource allocation information, information regarding an information length, and information regarding a mother code size, and
    wherein N is related to the information regarding the mother code size.

2. The method of claim 1, wherein generating the input bit sequence u of length N comprises, based on the transmission of the information block being initial transmission, placing bits $c_0$ to $c_{K-1}$ of the information block in K most reliable bit indexes among N bit indexes of the polar code to generating the input bit sequence $u = [u_0, u_1, u_2, ..., u_{N-1}]$ of length N.

3. The method of claim 1, wherein generating the input bit sequence u of length N comprises, based on the transmission of the information block being retransmission, placing bits $c_0$ to $c_{K-1}$ of the information block in K most reliable bit indexes among N bit indexes of the polar code of length N and placing at least one of the bits $c_0$ to $c_{K-1}$ of the information block at a bit index other than the K most reliable bit indexes to generate the input bit sequence $u = [u_0, u_1, u_2, ..., u_{N-1}]$ of length N.

4. The method of claim 3, wherein generating the input bit sequence u of length N comprises, based on the transmission of the information block being retransmission and on $N = 2^n*N1$, generating the input bit sequence $u = [u_0, u_1, u_2, ..., u_{N-1}]$ of length N such that an upper portion $[u_{N-N1}, u_{N-N1+1}, u_{N-N1+2}, ..., u_{N-1}]$ of the input bit sequence of length N is identical to an input bit sequence $[u_0, u_1, u_2, ..., u_{N1-1}]$ to a polar code of length N1, and such that, a bit index belonging to the K most reliable bit indexes in a lower portion $[u_0, u_1, u_2, ..., u_{N-N1-1}]$ of the input bit sequence of length N includes an information bit placed at a bit index among bit indexes of the upper portion that does not belong to the K most reliable bit indexes, where N1 is a length of a polar code for initial transmission of the information block, and n > 0.

5. The method of claim 1, wherein the information regarding the mother code size comprises information regarding a multiplication factor, and
wherein N is related to a length $N_{int}$ which is based on the resource allocation information and the information regarding the information length, and to the information regarding the multiplication factor regarding how many times N is of $N_{int}$.

6. The method of claim 1, wherein the scheduling information further comprises copy-related information regarding whether N is greater than a length of a polar code for initial transmission of the information block.

7. The method of claim 6, wherein the copy-related information has a first value when the transmission of the information block is the initial transmission, and
wherein the copy-related information has a second value when the transmission of the information block is retransmission.

8. A communication device configured to transmit an information block in a wireless communication system, the communication device comprising:

    at least one transceiver;
    at least one processor; and
    at least one computer memory operably connectable to the at least one processor and storing instructions that, when executed, cause the at least one processor to perform operations, the operations comprising:

        determining a length N of a polar code for encoding the information block;
        transmitting scheduling information for transmission of the information block;
        generating an input bit sequence u to a polar code of length N, based on a polar sequence of length N, $Q^{N-1}_0 = \{Q_0, Q_1, ..., Q_{N-1}\}$, and a length K of the information block;
        generating coded bits based on polar encoding of the input bit sequence u to the polar code of length N; and
        transmitting the coded bits based on the scheduling information,
        wherein the polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N i \leq N - 1$ denotes a bit index for i = 0, 1, ..., N - 1, and $W(Q^N_i)$ denotes a reliability of a bit index $Q^N_i$,
        wherein the scheduling information comprises resource allocation information, information regarding an information length, and information regarding a mother code size, and
        wherein N is related to the information regarding the mother code size.

9. A processing device in a wireless communication system, the processing device comprising:

    at least one processor; and
    at least one computer memory operably connectable to the at least one processor and storing instructions that, when executed, cause the at least one processor to perform operations, the operations comprising:

        determining a length N of a polar code for encoding an information block;
        transmitting scheduling information for transmission of the information block;
        generating an input bit sequence u to a polar code of length N, based on a polar sequence of length N, $Q^{N-1}_0 = \{Q_0, Q_1, ..., Q_{N-1}\}$, and a length K of the information block;
        generating coded bits based on polar encoding of the input bit sequence u to the polar code of length N; and
        transmitting the coded bits based on the scheduling information,
        wherein the polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N i \leq N - 1$ denotes a bit index for i = 0, 1, ..., N - 1, and $W(Q^N_i)$ denotes a reliability of a bit index $Q^N_i$,

wherein the scheduling information comprises resource allocation information, information regarding an information length, and information regarding a mother code size, and

wherein N is related to the information regarding the mother code size.

10. A computer-readable storage medium configured to store at least one program code comprising instructions that, when executed, cause at least one processor to perform operations comprising:

determining a length N of a polar code for encoding an information block;

transmitting scheduling information for transmission of the information block;

generating an input bit sequence u to a polar code of length N, based on a polar sequence of length N, $Q^{N-1}_0 = \{Q_0, Q_1, ..., Q_{N-1}\}$, and a length K of the information block;

generating coded bits based on polar encoding of the input bit sequence u to the polar code of length N; and

transmitting the coded bits based on the scheduling information,

wherein the polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for i = 0, 1, ..., N - 1, and $W(Q^N_i)$ denotes a reliability of a bit index $Q^N_i$,

wherein the scheduling information comprises resource allocation information, information regarding an information length, and information regarding a mother code size, and

wherein N is related to the information regarding the mother code size.

11. A method of receiving an information block by a communication device in a wireless communication system, the method comprising:

receiving scheduling information regarding transmission of the information block;

receiving a coded information block based on the scheduling information;

determining a length N of a polar code based on the scheduling information;

performing polar decoding for the coded information block based on a polar sequence of length N, $Q^{N-1}_0 = \{Q_0, Q_1, ..., Q_{N-1}\}$, a length K of the information block, and a mapping relationship of information bits of the information block to bit indexes of the polar code of length N; and

determining the information block based on the polar decoding,

wherein the polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for i = 0, 1, ..., N - 1, and $W(Q^N_i)$ denotes a reliability of a bit index $Q^N_i$,

wherein the scheduling information comprises resource allocation information, information regarding an information length, and information regarding a mother code size, and

wherein N is related to the information regarding the mother code size.

12. The method of claim 11, wherein the mapping relationship of the information bits of the information block to the bit indexes of the polar code of length N includes the following:

based on the transmission of the information block being initial transmission, an input bit sequence $u = [u_0, u_1, u_2, ..., u_{N-1}]$ of length N to the polar code of length N includes bits $c_0$ to $c_{K-1}$ of the information block in K most reliable bit indexes among N bit indexes of the polar code.

13. The method of claim 11, wherein the mapping relationship of the information bits of the information block to the bit indexes of the polar code of length N includes the following:

based on the transmission of the information block being retransmission, an input bit sequence $u = [u_0, u_1, u_2, ..., u_{N-1}]$ to the polar code of length N includes bits $c_0$ to $c_{K-1}$ of the information block at positions of K most reliable bit indexes among N bit indexes of the polar code of length N and includes at least one of the bits $c_0$ to $c_{K-1}$ of the information block at a position of a bit index other than the K most reliable bit indexes.

14. The method of claim 13, wherein the mapping relationship of the information bits of the information block to the bit indexes of the polar code of length N includes the following:

based on the transmission of the information block being retransmission and on $N = 2^n*N1$, an upper portion $[u_{N-N1}, u_{N-N1+1}, u_{N-N1+2}, ..., u_{N-1}]$ of the input bit sequence $u = [u_0, u_1, u_2, ..., u_{N-1}]$ of length N includes the bits $c_0$ to $c_{K-1}$ of the information block at positions identical to positions of an input bit sequence $[u_0, u_1, u_2, ..., u_{N1-1}]$ to a polar code of length N1, and a bit index belonging to the K most reliable bit indexes in a lower portion $[u_0, u_1, u_2, ..., u_{N-N1-1}]$ of the input bit sequence of length N includes an information bit identical to an information bit placed at a bit index among bit indexes of the upper portion that does not belong to the K most reliable bit indexes, where N1 is a length of a polar code for initial transmission of the information block, and n > 0.

15. The method of claim 11, wherein the information regarding the mother code size comprises information regarding a multiplication factor, and
wherein N is related to a length $N_{int}$ which is based on the resource allocation information and the information regarding the information length, and to the information regarding the multiplication factor regarding how many times N is of $N_{int}$.

16. The method of claim 11, wherein the scheduling information further comprises copy-related information regarding whether N is greater than a length of a polar code for initial transmission of the information block.

17. The method of claim 16, wherein the copy-related information has a first value when the transmission of the information block is the initial transmission, and
wherein the copy-related information has a second value when the transmission of the information block is retransmission.

18. A communication device configured to receive an information block in a wireless communication system, the communication device comprising:

at least one transceiver;
at least one processor; and
at least one computer memory operably connectable to the at least one processor and storing instructions that, when executed, cause the at least one processor to perform operations, the operations comprising:

receiving scheduling information regarding transmission of the information block;
receiving a coded information block based on the scheduling information;
determining a length N of a polar code based on the scheduling information;
performing polar decoding for the coded information block based on a polar sequence of length N, $Q^{N-1}_0 = \{Q_0, Q_1, ..., Q_{N-1}\}$, a length K of the information block, and a mapping relationship of information bits of the information block to bit indexes of the polar code of length N; and
determining the information block based on the polar decoding,
wherein the polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for i = 0, 1, ..., N - 1, and $W(Q^N_i)$ denotes a reliability of a bit index $Q^N_i$,
wherein the scheduling information comprises resource allocation information, information regarding an information length, and information regarding a mother code size, and
wherein N is related to the information regarding the mother code size.

19. A processing device in a wireless communication system, the processing device comprising:

at least one processor; and
at least one computer memory operably connectable to the at least one processor and storing instructions that, when executed, cause the at least one processor to perform operations, the operations comprising:

receiving scheduling information regarding transmission of an information block;
receiving a coded information block based on the scheduling information;
determining a length N of a polar code based on the scheduling information;
performing polar decoding for the coded information block based on a polar sequence of length N, $Q^{N-1}_0 = \{Q_0, Q_1, ..., Q_{N-1}\}$, a length K of the information block, and a mapping relationship of information bits of the information block to bit indexes of the polar code of length N; and
determining the information block based on the polar decoding,
wherein the polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for i = 0, 1, ..., N - 1, and $W(Q^N_i)$ denotes a reliability of a bit index $Q^N_i$,
wherein the scheduling information comprises resource allocation information, information regarding an information length, and information regarding a mother code size, and
wherein N is related to the information regarding the mother code size.

**20.** A computer-readable storage medium configured to store at least one program code comprising instructions that, when executed, cause at least one processor to perform operations comprising:

receiving scheduling information regarding transmission of the information block;

receiving a coded information block based on the scheduling information;

determining a length N of a polar code based on the scheduling information;

performing polar decoding for the coded information block based on a polar sequence of length N, $Q^{N-1}_0 = \{Q_0, Q_1, ..., Q_{N-1}\}$, a length K of the information block, and a mapping relationship of information bits of the information block to bit indexes of the polar code of length N; and

determining the information block based on the polar decoding,

wherein the polar sequence of length N, $\mathbf{Q}^{N-1}_0 = \{Q_0, Q_1, ..., Q_{N-1}\}$, is defined in ascending order of reliabilities $W(Q^N_0) < W(Q^N_1) < ... < W(Q^N_{N-1})$, where $0 \leq Q^N_i \leq N - 1$ denotes a bit index for $i = 0, 1, ..., N - 1$, and $W(Q^N_i)$ denotes a reliability of a bit index $Q^N_i$,

wherein the scheduling information comprises resource allocation information, information regarding an information length, and information regarding a mother code size, and

wherein N is related to the information regarding the mother code size.

## FIG. 1

# FIG. 2

100

108 ⚡ 208

200

First Device

102 — Processor(s)   Transceiver(s)

Memory(s)

104          106

Second Device

Transceiver(s)   Processor(s) — 202

Memory(s)

206          204

# FIG. 3

100, 200

Device

110 — Communication unit
(e.g., 5G communication unit)

112 — Communication circuit
(e.g., processor(s), memory(s))

114 — Transceiver(s)
(e.g., RF unit(s), antenna(s))

Control unit
(e.g., processor(s)) — 120

Memory unit
(e.g., RAM, storage) — 130

Additional components
(e.g., power unit/battery, I/O unit,
driving unit, computing unit) — 140

# FIG. 4

| | | |
|---|---|---|
| ··· | One Frame (10 ms) | ··· |

| | | | |
|---|---|---|---|
| ··· | Half-Frame (5ms) | Half-Frame (5ms) | ··· |

| | | | | | | | |
|---|---|---|---|---|---|---|---|
| ··· | Subframe 0 (1ms) | ··· | Subfrae 4 (1ms) | Subframe 5 (1ms) | ··· | Subframe 9 (1ms) | ··· |

subframe ($T_{sf}$ = 1ms)

**15kHz** — Slot (14 symbols)

1ms

**30kHz** — Slot 0 (14 symbols) | Slot 1

500us

**60kHz** — Slot 0 (14 symbols) | Slot 1 | Slot 2 | Slot 3

250us

**120kHz** — Slot 0 (14 symbols) | Slot 1 | Slot 2 | Slot 3 | Slot 4 | Slot 5 | Slot 6 | Slot 7

125us

# FIG. 5

Transport Block (TB)

TB CRC Attachment

Code Block (CB) Segmentation

CB CRC Attachment

Channel Coding

Rate Matching

CBs Concatenation

# FIG. 6

$$F = \begin{bmatrix} 1 & 0 \\ 1 & 1 \end{bmatrix}$$

(a)

(b)

# FIG. 7

Original channels
(uniform)

New channels
(polarized)

Vector
channel

$W$

$\vdots$

$W$

$W$

$W_{vec}$

$W_1$

$\vdots$

$W_{N-1}$

$W_N$

Combine →

Split →

(a)

$U_1$ → $G_N$ → $X_1$ → $W$ → $Y_1$

$U_2$ → $X_2$ → $W$ → $Y_2$

$\vdots$ $\vdots$ $\vdots$ $\vdots$

$U_N$ → $X_N$ → $W$ → $Y_N$

$W_{vec}$

(b)

# FIG. 8

**FIG. 9**

**FIG. 10**

$$x_1 = \sum_{i=1}^{8} u_i$$

$$x_2 = u_2 \oplus u_4 \oplus u_6 \oplus u_8$$

$$x_3 = u_3 \oplus u_4 \oplus u_7 \oplus u_8$$

$$x_4 = u_4 \oplus u_8$$

$$x_5 = u_5 \oplus u_6 \oplus u_7 \oplus u_8$$

$$x_6 = u_6 \oplus u_8$$

$$x_7 = u_7 \oplus u_8$$

$$x_8 = u_8$$

## FIG. 11

## FIG. 12

Information bit

PC Frozen bit

Frozen bit

Left cyclic shift upon encoding each bit

# FIG. 13

(a)

Previous transmission (N=8, K=6)

Current transmission (N=16, K=6)

(b)

copy

Lower (N = 8)

Upper (N = 8)

2nd Tx

1st Tx

$\bigcirc$ : bit index with information bit          $\bigcirc$ : bit index which is frozen

# FIG. 14

(a) Polar sequence $Q^{N-1}_0$ for N=32

| |
|---|
| 31 |
| 30 |
| 29 |
| 27 |
| 23 |
| 15 |
| 28 |
| 22 |
| 25 |
| 26 |
| 21 |
| 14 |
| 13 |
| 19 |
| 11 |
| 7 |
| 24 |
| 20 |
| 12 |
| 18 |
| 10 |
| 17 |
| 6 |
| 9 |
| 5 |
| 3 |
| 16 |
| 8 |
| 4 |
| 2 |
| 1 |
| 0 |

(b) Polar sequence $Q^{N-1}_0$ for N=64

| |
|---|
| 63 |
| 62 |
| 61 |
| 59 |
| 55 |
| 47 |
| 31 |
| 60 |
| 58 |
| 57 |
| 54 |
| 53 |
| 46 |
| 51 |
| 45 |
| 30 |
| 43 |
| 29 |
| 39 |
| 27 |
| 56 |
| 23 |
| 52 |
| 15 |
| 50 |
| 44 |
| 49 |
| 42 |
| 28 |
| 41 |
| 38 |
| 22 |
| 25 |
| 37 |
| 26 |
| 35 |
| 21 |
| 14 |
| 48 |
| 13 |
| 19 |
| 40 |
| 11 |
| 7 |
| 36 |
| 24 |
| 34 |
| 20 |
| 33 |
| 12 |
| 18 |
| 10 |
| 17 |
| 6 |
| 9 |
| 5 |
| 3 |
| 32 |
| 16 |
| 8 |
| 4 |
| 2 |
| 1 |
| 0 |

# FIG. 15

Polar sequence $Q^{N-1}_0$ for N=32

Bit index 0 to N-1 for N=32

Information bits $u_0$ to $u_{K-1}$ allocated

(a) K=7, N=32, E=24

Polar sequence $Q^{N-1}_0$ for N=64

Bit index 0 to N-1 for N=64

(Case-1) Information bits $u_0$ to $u_{K-1}$ allocated

(Case-2) Information bits $u_0$ to $u_{K-1}$ allocated

copy

(b) K=7, N=64, E=34

EP 4 708 740 A1

## FIG. 16

Polar sequence $Q^{N-1}_0$ for N=32

| 0 | 1 | 2 | 4 | 8 | 16 | 3 | 5 | 9 | 6 | 17 | 10 | 18 | 12 | 20 | 24 | 7 | 11 | 19 | 13 | 14 | 21 | 26 | 25 | 22 | 28 | 15 | 23 | 27 | 29 | 30 | 31 |

Bit index 0 to N-1 for N=32

| 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 |

Information bits $u_0$ to $u_{K-1}$ allocated

(a) K=16, N=32, E=30

Polar sequence $Q^{N-1}_0$ for N=64

| 0 | 1 | 2 | 4 | 8 | 16 | 32 | 3 | 5 | 9 | 6 | 17 | 10 | 18 | 12 | 33 | 20 | 34 | 24 | 36 | 7 | 11 | 40 | 19 | 13 | 48 | 14 | 21 | 35 | 26 | 37 | 25 | 22 | 38 | 41 | 28 | 42 | 49 | 44 | 50 | 15 | 52 | 23 | 56 | 27 | 39 | 29 | 43 | 30 | 45 | 51 | 46 | 53 | 54 | 57 | 58 | 60 | 31 | 47 | 55 | 59 | 61 | 63 | 62 |

Bit index 0 to N-1 for N=64

| 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 | 33 | 34 | 35 | 36 | 37 | 38 | 39 | 40 | 41 | 42 | 43 | 44 | 45 | 46 | 47 | 48 | 49 | 50 | 51 | 52 | 53 | 54 | 55 | 56 | 57 | 58 | 59 | 60 | 61 | 62 | 63 |

(Case-1) Information bits $u_0$ to $u_{K-1}$ allocated

(Case-2) Information bits $u_0$ to $u_{K-1}$ allocated

copy

copy

(b) K=16, N=64, E=30

EP 4 708 740 A1

FIG. 17

EP 4 708 740 A1

Polar sequence $Q^{N-1}_0$ for N=32

| 0 | 1 | 2 | 4 | 8 | 16 | 3 | 5 | 9 | 6 | 17 | 10 | 18 | 12 | 20 | 24 | 7 | 11 | 19 | 13 | 14 | 21 | 26 | 25 | 22 | **28** | **15** | **23** | **27** | **29** | **30** | **31** |
|---|---|---|---|---|----|---|---|---|---|----|----|----|----|----|----|---|----|----|----|----|----|----|----|----|----|----|----|----|----|----|----|

Bit index 0 to N-1 for N=32

| 0 | 1 | 2 | 3 | 4 | 5 | 6 | 7 | 8 | 9 | 10 | 11 | 12 | 13 | 14 | **15** | 16 | 17 | 18 | 19 | 20 | 21 | 22 | **23** | 24 | 25 | 26 | **27** | **28** | **29** | **30** | **31** |
|---|---|---|---|---|---|---|---|---|---|----|----|----|----|----|----|----|----|----|----|----|----|----|----|----|----|----|----|----|----|----|----|

Information bits $u_0$ to $u_{K-1}$ allocated

(a) K=7, N=32, E=24

Polar sequence $Q^{N-1}_0$ for N=64

| 0 | 1 | 2 | 4 | 8 | 16 | 32 | 3 | 5 | 9 | 6 | 17 | 10 | 18 | 12 | 33 | 20 | 34 | 24 | 36 | 7 | 11 | 40 | 19 | 13 | 48 | 14 | 21 | 35 | 26 | 37 | 25 | 22 | 38 | 41 | 28 | 42 | 49 | 44 | 50 | 15 | 52 | 23 | 56 | 27 | 39 | 29 | 43 | 30 | 45 | 51 | 46 | 53 | 54 | 57 | 58 | 60 | **31** | **47** | **55** | **59** | **61** | **62** | **63** |
|---|---|---|---|---|----|----|---|---|---|---|----|----|----|----|----|----|----|----|----|---|----|----|----|----|----|----|----|----|----|----|----|----|----|----|----|----|----|----|----|----|----|----|----|----|----|----|----|----|----|----|----|----|----|----|----|----|----|----|----|----|----|----|----|

Bit index 0 to N-1 for N=64

| 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | **31** | 32 | 33 | 34 | 35 | 36 | 37 | 38 | 39 | 40 | 41 | 42 | 43 | 44 | 45 | 46 | **47** | 48 | 49 | 50 | 51 | 52 | 53 | 54 | **55** | 56 | 57 | 58 | **59** | 60 | **61** | **62** | **63** |
|---|---|---|---|---|---|---|---|---|---|----|----|----|----|----|----|----|----|----|----|----|----|----|----|----|----|----|----|----|----|----|----|----|----|----|----|----|----|----|----|----|----|----|----|----|----|----|----|----|----|----|----|----|----|----|----|----|----|----|----|----|----|----|----|

(Case-1) Information bits $u_0$ to $u_{K-1}$ allocated

(Case-2) Information bits $u_0$ to $u_{K-1}$ allocated

copy

(b) K=7, N=64, E=34

# FIG. 18

(a) K=16, N=32, E=30

(b) K=16, N=64, E=30

## FIG. 19

Generating input u for polar encoding based on information block of length K, polar sequence $Q^{N-1}_0$ of length N, and polar code of length N — S1901

Determining coded bits based on polar encoding of input u — S1903

Transmitting scheduling information including information regarding mother code and coded bits — S1905

## FIG. 20

Receiving scheduling information and coded bits — S2001

Determining length N of polar code — S2003

Performing polar decoding based on coded bits and input positions of polar code — S2005

# INTERNATIONAL SEARCH REPORT

| International application No. |
| --- |
| **PCT/KR2023/006154** |

| A. | CLASSIFICATION OF SUBJECT MATTER |
| --- | --- |

**H04L 1/00**(2006.01)i

According to International Patent Classification (IPC) or to both national classification and IPC

| B. | FIELDS SEARCHED |
| --- | --- |

Minimum documentation searched (classification system followed by classification symbols)

H04L 1/00(2006.01); H03M 13/00(2006.01); H03M 13/11(2006.01); H03M 13/13(2006.01); H04B 7/0456(2017.01); H04B 7/06(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 폴라 코드(polar code), 신뢰도(reliability), 오름차순(ascending order), 시퀀스(sequence), 인코딩(encoding), 재전송(retransmission), 복사(copy)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | US 2021-0184696 A1 (HUAWEI TECHNOLOGIES CO., LTD.) 17 June 2021 (2021-06-17)<br>See paragraphs [0044], [0051], [0056], [0064]-[0067], [0074], [0115]-[0116] and [0119]-[0121]; and claims 1-2 and 5. | 1-20 |
| Y | KR 10-2023-0010805 A (SAMSUNG ELECTRONICS CO., LTD.) 19 January 2023 (2023-01-19)<br>See paragraphs [0026]-[0037]. | 1-20 |
| Y | WO 2022-042214 A1 (HUAWEI TECHNOLOGIES CO., LTD.) 03 March 2022 (2022-03-03)<br>See claims 1-3 and 6. | 3-7,13-17 |
| A | KR 10-2243485 B1 (HUAWEI TECHNOLOGIES CO., LTD.) 21 April 2021 (2021-04-21)<br>See claims 1-12. | 1-20 |
| A | CN 110868226 A (WUHAN UNIVERSITY OF TECHNOLOGY) 06 March 2020 (2020-03-06)<br>See claims 1-10. | 1-20 |

☐ Further documents are listed in the continuation of Box C.  ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **26 January 2024** | **26 January 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2023/006154**

| Patent document cited in search report | | | Publication date (day/month/year) | Patent family member(s) | | | Publication date (day/month/year) |
|---|---|---|---|---|---|---|---|
| US | 2021-0184696 | A1 | 17 June 2021 | CN | 109286404 | A | 29 January 2019 |
| | | | | CN | 109286404 | B | 09 February 2021 |
| | | | | CN | 112953558 | A | 11 June 2021 |
| | | | | EP | 3605848 | A1 | 05 February 2020 |
| | | | | EP | 3605848 | B1 | 03 February 2021 |
| | | | | US | 10965322 | B2 | 30 March 2021 |
| | | | | US | 11316538 | B2 | 26 April 2022 |
| | | | | US | 2020-0091936 | A1 | 19 March 2020 |
| | | | | WO | 2019-015592 | A1 | 24 January 2019 |
| KR | 10-2023-0010805 | A | 19 January 2023 | CN | 109495230 | A | 19 March 2019 |
| | | | | CN | 109495230 | B | 07 September 2021 |
| | | | | CN | 113572588 | A | 29 October 2021 |
| | | | | EP | 3863200 | A1 | 11 August 2021 |
| | | | | EP | 3863200 | B1 | 01 November 2023 |
| | | | | KR | 10-2019-0029239 | A | 20 March 2019 |
| | | | | KR | 10-2488581 | B1 | 13 January 2023 |
| | | | | US | 11129145 | B2 | 21 September 2021 |
| | | | | US | 2019-0082435 | A1 | 14 March 2019 |
| | | | | US | 2022-0007359 | A1 | 06 January 2022 |
| | | | | WO | 2019-054686 | A1 | 21 March 2019 |
| WO | 2022-042214 | A1 | 03 March 2022 | CN | 114124292 | A | 01 March 2022 |
| | | | | EP | 4199394 | A1 | 21 June 2023 |
| | | | | US | 2023-0224082 | A1 | 13 July 2023 |
| KR | 10-2243485 | B1 | 21 April 2021 | CN | 107342843 | B | 20 October 2023 |
| | | | | CN | 109889304 | B | 16 June 2020 |
| | | | | EP | 3550750 | A1 | 09 October 2019 |
| | | | | EP | 3550750 | B1 | 08 September 2021 |
| | | | | EP | 3996284 | A1 | 11 May 2022 |
| | | | | JP | 2020-505820 | A | 20 February 2020 |
| | | | | JP | 2021-064956 | A | 22 April 2021 |
| | | | | JP | 6817452 | B2 | 20 January 2021 |
| | | | | JP | 7026763 | B2 | 28 February 2022 |
| | | | | US | 10700809 | B2 | 30 June 2020 |
| | | | | US | 10938506 | B2 | 02 March 2021 |
| | | | | US | 11539457 | B2 | 27 December 2022 |
| | | | | US | 2021-0234631 | A1 | 29 July 2021 |
| | | | | US | 2023-0198660 | A1 | 22 June 2023 |
| | | | | WO | 2018-127041 | A1 | 12 July 2018 |
| CN | 110868226 | A | 06 March 2020 | CN | 110868226 | B | 03 September 2021 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **E. ARIKAN**. Channel Polarization: A Method for Constructing Capacity-Achieving Codes for Symmetric Binary-Input Memoryless Channels. *IEEE Transactions on Information Theory*, July 2009, vol. 55 (7), 3051-3073

- **I. TAL** ; **A. VARDY**. List decoding of polar codes. *Proc. IEEE Int. Symp. Inf. Theory*, July 2011, 1-5